# EUROPEAN PATENT SPECIFICATION

(11) **EP 2 990 873 B1**
(45) Date of publication and mention of the grant of the patent: **28.03.2018**
(21) Application number: 15181093.4
(22) Date of filing: 22.02.2012
(51) Int. Cl.: G03F 7/32, G03F 7/00, G03F 7/004, G03F 7/029, G03F 7/033, G03F 7/035

(54) **PROCESS FOR MAKING LITHOGRAPHIC PRINTING PLATE**
VERFAHREN ZUR HERSTELLUNG EINER LITHOGRAFIEDRUCKPLATTE
PROCESSUS DE FABRICATION D'UNE PLAQUE D'IMPRESSION LITHOGRAPHIQUE

(30) Priority: 24.02.2011 JP 2011038916
(43) Date of publication of application: 02.03.2016
(62) Divisional of application: 12749638.8
(73) Proprietor: Fujifilm Corporation, Minato-ku Tokyo 106-8620 (JP)
(72) Inventor: Sonokawa, Koji, Haibara-gun, Shizuoka 421-0396 (JP)
(74) Representative: Hoffmann Eitle

(56) References cited:
- GB-A- 1 189 944
- JP-A- 2010 197 989
- US-A- 3 615 480
- US-A1- 2008 070 152
- US-A1- 2010 310 989
- US-B1- 7 175 949

## Description

The present invention relates to a process for making a lithographic printing plate.

In general, a lithographic printing plate is formed from a lipophilic image area for accepting ink and a hydrophilic non-image area for accepting dampening water in a printing process. Lithographic printing is a printing process in which the property of water and oil-based ink repelling each other is utilized so as to cause a difference in ink attachment on the surface of a lithographic printing plate with a lipophilic image area of the lithographic printing plate as an ink-accepting area and a hydrophilic non-image area as a dampening water-accepting area (non-ink-accepting area), and after inking only the image area ink is transferred to a printing substrate such as paper.

In order to make this lithographic printing plate, a lithographic printing plate precursor (PS plate) formed by providing a lipophilic photosensitive resin layer (photosensitive layer) on a hydrophilic support is widely used in the art. A lithographic printing plate is usually obtained by a process in which, after the lithographic printing plate precursor is exposed through an original image such as a lith film, a photosensitive layer that becomes an image area is made to remain, and unneccesary photosensitive layer that becomes a non-image area is removed by dissolving using an alkaline developer having a pH of no less than 12 to thus form a non-image area in which the surface of the hydrophilic support is exposed.

In the conventionally known process for making of a lithographic printing plate, after the exposure, a step of removing unnecessary photosensitive layer by dissolving, for example, with a developer is required, simplification of such wet treatment carried out additionally are cited as one of issues. In particular, since in recent years the disposal of liquid waste discharged accompanying highly pH alkaline treatment has become a great concern throughout the industrial world from the viewpoint of consideration for the global environment, developing by a nearly neutral aqueous solution has been more and more desired as one of the simplificaion.

On the other hand, digitization techniques involving electronically processing, storing, and outputting image information by computer have been widespread in recent years, and various new image output methods responding to such digitization techniques have been put into practical use. Accompanying this, a computer-to-plate (CTP) technique has been attracting attention in which digitized image information is carried on a highly convergent radiant ray such as laser light and a lithographic printing plate precursor is scan-exposed by this light to directly produce a lithographic printing plate without intervention of a lith film. Therefore, obtaining a lithographic printing precursor suitable for these techniques has become one of the important technological challenges.

As a laser light source that can be used in the CTP technique, a solid-state laser such as a YAG laser or a semiconductor laser that emits infrared rays having a wavelength of 760 to 1,200 nm is very useful since one with high output and small size is available at low cost. A UV laser can also be used.

From the background described above, there is currently an even stronger desire than ever for compatibility with both digitization and simplification of plate making operations.

In response to this, for example, Patent Document 1 describes a process for making a plate by developing, using a gumming liquid, a lithographic printing plate precursor having provided above a hydrophilic support a photosensitive layer in which hydrophobic thermoplastic polymer particles are dispersed in a hydrophilic binder.

Patent Document 2 describes a method for processing a lithographic printing plate precursor by imagewise exposing with an infrared laser a lithographic printing plate precursor comprising (i) a hydrophilic support and (ii) a photosensitive layer comprising a radically polymerizable ethylenically unsaturated monomer, a radical polymerization initiator, and an infrared absorbing dye, and then removing an uncured portion of the photosensitive layer using a gumming liquid.

Furthermore, Patent Document 3 describes a method for developing a lithographic printing plate precursor, the method comprising curing a radically polymerizable photosensitive layer by exposure to an infrared laser and removing an unexposed portion using a solvent-containing developer having a pH of less than 12 and comprising benzyl alcohol and an amphoteric surfactant having a specific structure.

Furthermore, Patent Document 4 describes a method for developing a lithographic printing plate precursor, the method comprising curing a radically polymerizable photosensitive layer by exposure to an infrared laser and removing an unexposed portion using a solvent-containing developer comprising no greater than 60 wt% of water, a water-soluble or water-dispersible solvent, and a surfactant having a specific structure.
(Patent Document 1) EP 1,342,568 B
(Patent Document 2) WO 2005/111727
(Patent Document 3) WO 2008/027227
(Patent Document 4) US 2010/0216067

In the process for making a plate described in Patent Document 1, the lithographic printing plate precursor is imagewise exposed using an infrared laser to thus fuse the hydrophobic thermoplastic polymer particles and form an image, and development is then carried out by removing an unexposed portion using a gumming liquid.

However, such a method in which a lithographic printing plate precursor employing image formation by thermal fusion of particles is developed using a gumming liquid has very good developability but low sensitivity and poor printing durability, and there is the serious problem that particles removed from an unexposed portion easily coagulate and settle in a developer and a slimy deposit called development sludge is formed.

Furthermore, the developers of the inventions described in Patent Documents 3 and 4 contain an organic solvent and are therefore poor in terms of work safety, but they enable development at low pH and are excellent in terms of environmental impact, and since image formation involves radical polymerization, sensitivity and printing durability are high, but a component of the photosensitive layer after removal by development still coagulates and settles in the developer, and bad development sludge is formed, thus causing the problems that the frequency with which a filter in a developer circulation system is replaced is very high and the time that is required for washing a development bath when replacing a developer is long.

US-A-2010/310989, US-A-2008/070152, US-B-7175949, JP-A-2010-197989, GB-A-1 189 944 and US-A-3615480 all disclose processes for making lithographic printing plates. These processes comprise a step of preparing a negative-working lithographic printing plate precursor comprising a photopolymerizable photosensitive layer above a support. The precursor is imagewise exposed and then developed using a developer.

Therefore, it is an object of the present invention to provide a process for making a lithographic printing plate that enables a lithographic printing plate having excellent printing durability to be obtained and enables the odor of a developer and development sludge due to a component removed by development to be suppressed, the lithographic printing plate having excellent sensitivity and developability.

The following are aspects of the present invention:
<1> A process for making a lithographic printing plate, comprising:
   a step of preparing a negative-working lithographic printing plate precursor comprising a photopolymerizable photosensitive layer above a support;
   a step of imagewise exposing the negative-working lithographic printing plate precursor; and
   a step of developing the exposed negative-working lithographic printing plate precursor by means of a developer comprising at least (Component A) a compound represented by Formula (I) below, (Component B) a compound represented by Formula (II) below, and (Component C) water,
   wherein the photopolymerizable photosensitive layer comprises an acrylic polymer comprising a vinylcarbazole compound-derived monomer unit or a urethane-acrylic hybrid polymer, 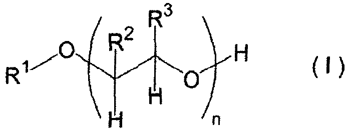 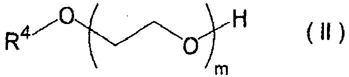
   wherein in the Formulae,
   R¹ denotes a straight-chain or branched alkyl group having 4 to 8 carbons, preferably a *n*-butyl group, a
   *n*-hexyl group, or a 2-ethylhexyl group;
   R² and R³ independently denote a hydrogen atom or a methyl group and when either one of R² and R³ is a methyl group the other is a hydrogen atom, and R² and R³ are preferably both hydrogen atoms;
   n denotes 1 or 2, preferably 1;
   R⁴ denotes a substituted or unsubstituted phenyl group, 1-naphthyl group, or 2-naphthyl group, preferably a substituted or unsubstituted 1-naphthyl group or 2-naphthyl group, and
   m denotes an integer of 4 to 20, preferably 9 to 16.

Preferred embodiments are as follows:
<2> The process for making a lithographic printing plate according to <1> above, wherein Component A is a compound having an octanol/water partition coefficient of 0.8 to 2.0 and is preferably selected from the group consisting of ethylene glycol mono-*n*-butyl ether, ethylene glycol mono-*n*-hexyl ether, and propylene glycol mono-*n*-butyl ether.
<3> The process for making a lithographic printing plate according to <1> or <2> above, wherein Component A has a content in the developer that is greater than the solubility of Component A in water but no greater than 40 wt%, preferably 2 to 30 wt%, more preferably 5 to 20 wt%, relative to the total weight of the developer.
<4> The process for making a lithographic printing plate according to any one of <1> to <3> above, wherein Component B has a content in the developer that is 1 to 15 wt%, preferably 4 to 10 wt%, relative to the total weight of the developer.
<5> The process for making a lithographic printing plate according to any one of <1> to <4> above, wherein Component C has a content in the developer of at least 50 wt%, relative to the total weight of the developer.
<6> The process for making a lithographic printing plate according to any one of <1> to <5> above, wherein the developer further comprises an anionic surfactant or an amphoteric surfactant.
<7> The process for making a lithographic printing plate according to any one of <1> to <6> above, wherein the developer has a pH of 6 to 8.
<8> The process for making a lithographic printing plate according to any one of <1> to <7> above, wherein the photopolymerizable photosensitive layer comprises an acrylic polymer comprising a vinylcarbazole compound-derived monomer unit.
<9> The process for making a lithographic printing plate according to <8> above, wherein the acrylic polymer comprises an acrylonitrile-derived monomer unit.
<10> The process for making a lithographic printing plate according to any one of <1> to <9> above, wherein the photopolymerizable photosensitive layer comprises a urethane-acrylic hybrid polymer.
<11> The process for making a lithographic printing plate according to <10> above, wherein the urethane-acrylic hybrid polymer comprises a monomer unit derived from a compound selected from the group consisting of diphenylmethane diisocyanate, *m*-tolylene diisocyanate, isophorone diisocyanate, and dicyclohexylmethane diisocyanate.
<12> A process for making a lithographic printing plate according to any one of <1> to <11> above, wherein the photopolymerizable photosensitive layer is sensitive to infrared light, does not contain a borate salt, and comprises a coloring dye.
<13> A process for making a lithographic printing plate according to <12> above, wherein the photopolymerizable photosensitive layer comprises a cyanine dye and an iodonium salt.

In accordance with the present invention, there can be provided a process for making a lithographic printing plate that enables a lithographic printing plate having excellent printing durability to be obtained and enables the odor of a developer and development sludge due to a component removed by development to be suppressed, the lithographic printing plate having excellent sensitivity and developability.

### Brief Description of Drawings

FIG. 1 A diagram showing the constitution of one example of automatic processing equipment for a lithographic printing plate precursor that can suitably be used in the process for making a lithographic printing plate of the present invention.
FIG. 2 A diagram showing the constitution of one example of automatic processing equipment having only the development section that can suitably be used in the process for making a lithographic printing plate of the present invention.

### Explanation of Reference Numerals and Symbols

1 Automatic processing equipment
10 Processing section
12 Printing plate precursor
14 Development section
16 Water washing section
18 De-oleophilization treatment section
20 Drying section
24 Development tank
61 Rotating brush roller
62 Backing roller
63 Transport roller
64 Transport guide plate
65 Spray pipe
66 Pipeline
67 Filter
68 Plate supply table
69 Plate discharge table
70 Developer tank
71 Circulation pump
72 Plate
141,142 Brush roller (rubbing member)
200 Pretreatment section

The process for making a lithographic printing plate of the present invention comprises a step of producing a negative-working lithographic printing plate precursor comprising a photopolymerizable photosensitive layer above a support (hereinafter, also called a 'precursor production step'), a step of imagewise exposing the negative-working lithographic printing plate precursor (hereinafter, also called an 'exposure step'), and a step of developing the exposed negative-working lithographic printing plate precursor by means of a developer comprising at least (Component A) a compound represented by Formula (I) below, (Component B) a compound represented by Formula (II) below, and (Component C) water (hereinafter, also called a 'development step'). 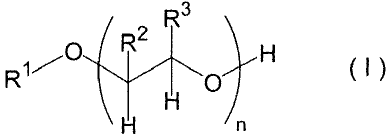 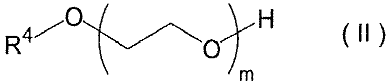 (In the Formulae, R¹ denotes a straight-chain or branched alkyl group having 4 to 8 carbons, R² and R³ independently denote a hydrogen atom or a methyl group and when either one of R² and R³ is a methyl group the other is a hydrogen atom, n denotes 1 or 2, R⁴ denotes a substituted or unsubstituted phenyl group, 1-naphthyl group, or 2-naphthyl group, and m denotes an integer of 4 to 20.)

The present invention is explained in detail below. The development step, which is the most characteristic step in the present invention, is explained first, and the other steps etc. are then explained.

In the present invention, the notation 'lower limit to upper limit', which expresses a numerical range, means 'at least the lower limit but no greater than the upper limit', and the notation 'upper limit to lower limit' means 'no greater than the upper limit but at least the lower limit'. That is, they are numerical ranges that include the upper limit and the lower limit. In the present invention, 'mass %' is used for the same meaning as 'weight %', and 'parts by mass' is used for the same meaning as 'parts by weight'. Furthermore, '(Component A) a compound represented by Formula (I)' etc. are simply called 'Component A' etc.

### (Development step)

The process for making a lithographic printing plate of the present invention comprises a step of developing the exposed negative-working lithographic printing plate precursor by means of a developer comprising at least the compound represented by Formula (I) (Component A), the compound represented by Formula (II) (Component B), and water (Component C) (development step).

### <Developer>

The developer that is used in the process for making a lithographic printing plate of the present invention is an aqueous solution or aqueous dispersion comprising at least Components A to C above.

The developer is preferably a single phase (non-separated) aqueous solution or aqueous dispersion in which Component A, which is an organic solvent having a specific structure, is solubilized in Component C, which is water, by means of Component B, which is a nonionic surfactant having a specific structure.

The compound represented by Formula (I) (Component A) in the developer is a developing agent that is in charge of the operation of removing an unexposed portion of a lithographic printing plate precursor and that can impart dispersibility to the developed and removed photosensitive layer in the developer (development sludge suppression). When Component A is used on its own as a developer, the solvent odor is very strong and the environment around development equipment becomes poor, and in order to cut the amount thereof used and reduce the exposure of solvent on the liquid surface, the developer used in the present invention employs water (Component C) in combination. In this process, if a compound having very high compatibility with water is used, the organic solvent can be present in water in a stable manner, and when the developer is contacted with the surface of a lithographic printing plate precursor, it becomes harder for the organic solvent to penetrate into a photosensitive layer of the lithographic printing plate precursor, and the developability becomes insufficient. Because of this, as the compound represented by Formula (I) (Component A), one having low compatibility with water is used; it is preferable to add an amount thereof that is equal to or greater than its solubility in water, and this is solubilized in water by means of the compound represented by Formula (II) (Component B), thus greatly suppressing solvent odor and enabling development by breaking an oil-in-water micelle when contacting the surface of a lithographic printing plate precursor so as to make Component A as a developing agent penetrate into a photosensitive layer. Furthermore, it is surmised that the compound represented by Formula (II) (Component B) also has a function of suppressing development sludge.

Components A to C are explained below.

### (Component A) Compound represented by Formula (I)

Component A is a compound represented by Formula (I) below. Furthermore, the compound represented by Formula (I) preferably functions in a developer as an organic solvent that makes development sludge due to a component removed by development dissolve and/or disperse in the developer. 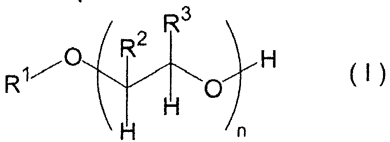 (In the Formula above, R¹ denotes a straight-chain or branched alkyl group having 4 to 8 carbons, R² and R³ independently denote a hydrogen atom or a methyl group and when either one of R² and R³ is a methyl group the other is a hydrogen atom, and n denotes 1 or 2.)

In Formula (1) above, n is preferably 1. It is also preferable for both R² and R³ to be hydrogen atoms. R¹ is preferably a *n*-butyl group, a *n-*hexyl group, or a 2-ethylhexyl group, and more preferably an *n*-hexyl group. When in this mode, development sludge due to a component removed by development can be further suppressed, and developability is better.

Specifically, Component A is preferably a compound selected from the group consisting of ethylene glycol mono-*n*-butyl ether, ethylene glycol mono-*n*-hexyl ether, ethylene glycol mono-*t*-butyl ether, diethylene glycol mono-2-ethylhexyl ether, and propylene glycol mono-*n*-butyl ether, more preferably a compound selected from the group consisting of ethylene glycol mono-*n*-butyl ether, ethylene glycol mono-*n*-hexyl ether, and propylene glycol mono-*n*-butyl ether, and yet more preferably ethylene glycol mono-*n*-hexyl ether.

Furthermore, as one characteristic physical property, Component A preferably has an octanol/water partition coefficient of 0.8 to 2.0. The octanol/water partition coefficient referred to here means the ratio of the concentration of a chemical substance in two solvent phases, that is, 1-octanol and water, when the chemical substance is added to the two phases and attains an equilibrium state, and is a physiochemical indicator denoting the hydrophobicity of the chemical substance (lipid solubility). The larger the value, the higher the hydrophobicity. The octanol/water partition coefficient is sometimes denoted by the abbreviation Pow, or is also generally denoted by a logarithmic value (LogP).

Since the compound having the above octanol/water partition coefficient has a relatively low solubility in water, the developer used in the present invention preferably comprises an amount of Component A that is at least its solubility in water. In this case, the portion of Component A that exceeds the solubility separates from the aqueous solution to thus form two phases, and this is preferably solubilized by means of Component B, which is described later, to thus form a single-phase aqueous solution or aqueous dispersion. When the developer has a mode in which it contains an amount of Component A that is at least its solubility in water, the odor of the developer and development sludge due to a component removed by development can be suppressed, thereby achieving better developability.

The amount of Component A in the developer is preferably no greater than 40 wt%. When it is no greater than 40 wt%, a developer in an oil-in-water (o/w) state in which Component A is solubilized in water by means of Component B is easily obtained, the odor due to organic solvent is suppressed, and work safety is excellent. The content of Component A in the developer is more preferably 2 to 30 wt%, and most preferably 5 to 20 wt%.

With regard to Component A, one type may be used on its own or two or more types may be used in combination.

### (Component B) Compound represented by Formula (II)

Component B is a compound represented by Formula (II) below. Furthermore, the compound represented by Formula (II) preferably functions in the developer as a nonionic surfactant that contributes to dispersion into the developer of Component A or development sludge due to a component removed by development. 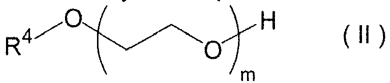 (In the Formula, R⁴ denotes a substituted or unsubstituted phenyl group, 1-naphthyl group, or 2-naphthyl group and m denotes an integer of 4 to 20.)

R⁴ of Formula (II) above is preferably a substituted or unsubstituted 1-naphthyl group or 2-naphthyl group, more preferably a 1-naphthyl group or a 2-naphthyl group, and yet more preferably a 1-naphthyl group. Furthermore, m is preferably 9 to 16, and more preferably 11 to 16.

Preferred examples of the substituent on the phenyl group, 1-naphthyl group, or 2-naphthyl group denoted by R⁴ above include an alkyl group, an aryl group, and an aralkyl group.

Specific examples of Component B include, but are not limited to, the structures below.

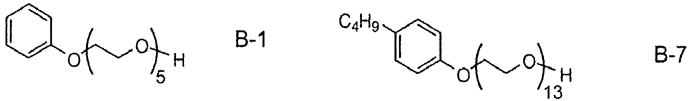

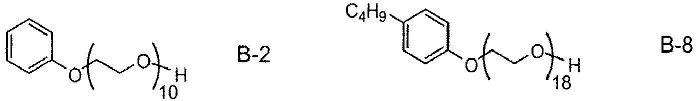

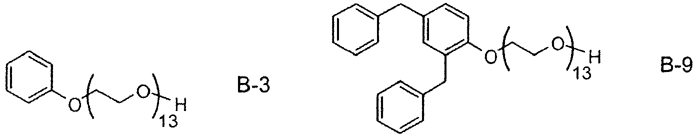

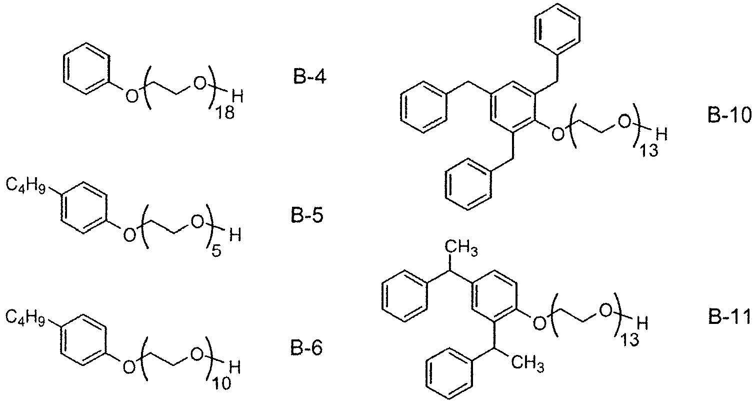

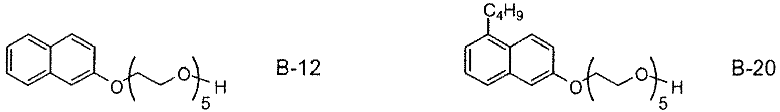

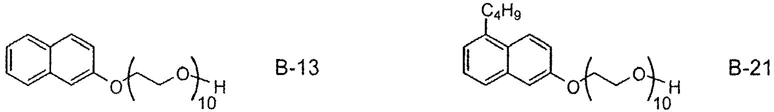

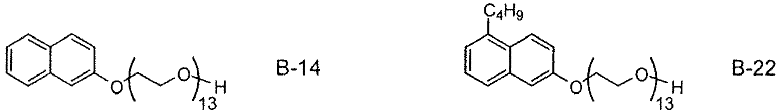

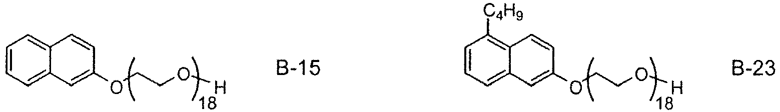

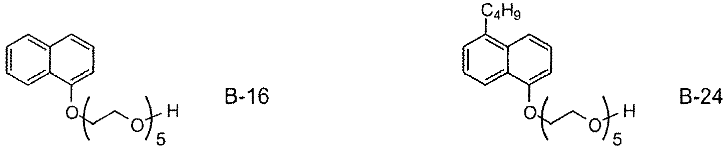

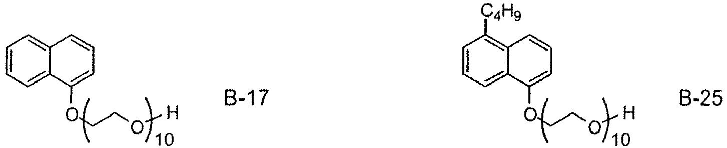

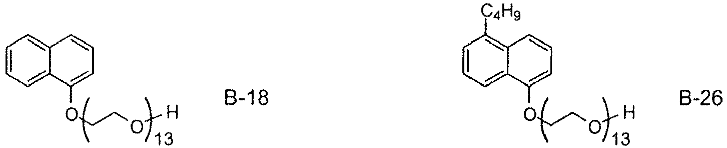

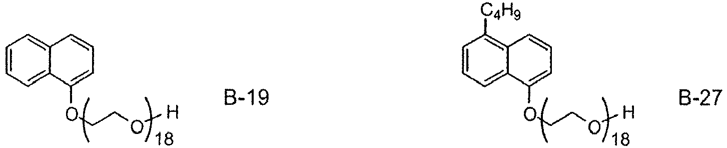

Among them, Component B is preferably B-12 to B-15, and particularly preferably B-14.

Furthermore, Component B is commercially available as commercial products such as the 'Emulgen A' series and the 'Emulgen B' series manufactured by Kao Corporation, the 'Naroacty CL' series manufactured by Sanyo Chemical Industries, Ltd., or the 'Newcol 700' series, the 'Newcol 2600' series, and the 'Newcol B' series manufactured by Nippon Nyukazai Co., Ltd.

Component B is preferably contained in at least an amount that can solubilize Component A in the developer. By solubilizing Component A in water, the odor of organic solvent can be suppressed and the occurrence of streaks in the development of a lithographic printing plate can be suppressed. The content of Component B in the developer is preferably no greater than 20 wt%. When it is no greater than 20 wt%, the stability of the solubilized organic solvent in the developer is appropriate, breakage of a micelle easily occurs on the surface of a lithographic printing plate precursor, and developability is excellent.

The content of Component B in the developer is more preferably 1 to 15 wt%, and most preferably 4 to 10 wt%.

With regard to Component B, two or more types may be used in combination.

### (Component C) Water

Component C is water.

The water referred to here denotes pure water, distilled water, ion-exchanged water, tap water, etc., and water of any hardness can be used.

The content of Component C in the developer is preferably at least 50 wt% in order to maintain the structure of an oil-in-water micelle as described above.

Other components in the developer are described below.

The developer may comprise a surfactant (anionic, nonionic, cationic, etc.) other than the compound represented by Formula (II) (Component B).

Examples of the anionic surfactant used in the present invention include a fatty acid salt, an abietic acid salt, a hydroxyalkanesulfonic acid salt, an alkanesulfonic acid salt, a dialkylsulfosuccinic acid salt, a straight-chain alkylbenzenesulfonic acid salt, a branched alkylbenzenesulfonic acid salt, an alkylnaphthalenesulfonic acid salt, an alkylphenoxypolyoxyethylene propylsulfonic acid salt, a polyoxyethylene alkylsulfophenyl ether salt, sodium *N*-methyl-*N*-oleyltaurine, a disodium *N*-alkylsulfosuccinic acid monoamide, a petroleum sulfonic acid salt, sulfated castor oil, sulfated tallow oil, a sulfate ester of a fatty acid alkyl ester, an alkylsulfate ester salt, a polyoxyethylene alkyl ether sulfate ester, a fatty acid monoglyceride sulfate ester, a polyoxyethylene alkyl phenyl ether sulfate ester, a polyoxyethylene styrylphenyl ether sulfate ester, an alkyl phosphate ester, a polyoxyethylene alkyl ether phosphate ester, a polyoxyethylene alkyl phenyl ether phosphate ester, a partially saponified styrene-maleic anhydride copolymer, a partially saponified olefin-maleic anhydride copolymer, a naphthalenesulfonic acid salt formalin condensate, an arenesulfonic acid salt, and a polyoxyethylene substituted arene sulfonic acid salt. Among them, a dialkylsulfosuccinic acid salt, an alkylsulfate ester salt, and/or an alkylnaphthalenesulfonic acid salt are particularly preferably used.

The cationic surfactant that can be used in the present invention is not particularly limited, and a conventionally known cationic surfactant may be used. Examples thereof include an alkylamine salt, a quaternary ammonium salt, a polyoxyethylene alkylamine salt, and a polyethylene polyamine derivative.

Examples of the other nonionic surfactant that can be used in the present invention include a polyethylene glycol type higher alcohol ethylene oxide adduct, an alkylphenol ethylene oxide adduct, a fatty acid ethylene oxide adduct, a polyhydric alcohol fatty acid ester ethylene oxide adduct, a higher alkylamine ethylene oxide adduct, a fatty acid amide ethylene oxide adduct, an ethylene oxide adduct of an oil or fat, a polypropylene glycol ethylene oxide adduct, a dimethylsiloxane-ethylene oxide block copolymer, a dimethylsiloxane-(propylene oxide-ethylene oxide) block copolymer, a polyhydric alcohol type glycerol fatty acid ester, a pentaerythritol fatty acid ester, sorbitol and sorbitan fatty acid esters, a sucrose fatty acid ester, a polyhydric alcohol alkyl ether, and an alkanolamine fatty acid amide. Furthermore, an acetylene glycol- or acetylene alcohol-based oxyethylene adduct or a fluorine-based, silicone-based, etc. surfactant may also be used in the same manner.

As is well known in the surfactant field, an amphoteric surfactant is a compound having an anionic portion and a cationic portion in a single molecule, and includes amphoteric surfactants of the amino acid type, betaine type, amine oxide type, etc.

With regard to these other surfactants, one type may be used on its own or two or more types may be used in combination.

The content of the other surfactant in the developer is preferably 0.01 to 10 wt%, and more preferably 0.01 to 5 wt%.

For the purpose of adjusting the pH and assisting dissolution of a non-image area of a photosensitive layer, an alkali agent may be added as an auxiliary agent. Examples of the alkali agent include a carbonate, a bicarbonate, and an organic alkali agent. The carbonate salt and the hydrogen carbonate salt are not particularly limited, but an alkali metal salt is preferable. As the alkali metal, lithium, sodium, and potassium can be cited, and sodium is particularly preferable. Examples of the organic alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. These alkali agents may be used singly or in a combination of two or more types.

The pH of the developer is not particularly limited but is preferably in the range of 6 to 8 from the viewpoint of environmental impact and, furthermore, from the viewpoint of work safety.

For the purpose of protecting of the surface of a non-image area after developing and removing of the photosensitive layer, the developer that can be used in the present invention may contain a water-soluble polymer.

The water-soluble polymer that can be contained in the developer includes, for example, soybean polysaccharide, starch, gum Arabic, dextrin, a cellulose derivative (for example, carboxymethylcellulose, carboxyethylcellulose or methylcellulose) or a modified product thereof, pullulan, polyvinyl alcohol or a derivative thereof, polyvinylpyrrolidone, polyacrylamide, an acrylamide copolymer, a vinyl methyl ether/maleic anhydride copolymer, a vinyl acetate/maleic anhydride copolymer, and a styrene/maleic anhydride copolymer.

Furthermore, the acid value of the water-soluble polymer is preferably 0 to 3.0 meq/g.

As the soybean polysaccharide, those conventionally known may be used. For example, as a commercial product, Soyafibe (Fuji Oil Co., Ltd.) is available, and various product grades can be used. The soybean polysaccharide preferably used has a viscosity in the range of 10 to 100 mPa/sec in a 10 wt% aqueous solution thereof.

Examples of the starch include sweet potato starch, potato starch, tapioca starch, wheat starch, and corn starch and, furthermore, modified starch and starch derivatives of the above.

Modified starches may be carried out by a method in which they are decomposed with an acid or an enzyme to the extent that the number of glucose residues per molecule is from 5 to 30 and then oxypropylene is added thereto in an alkali.

As starch derivatives, roasted starch such as British gum, enzymatically-modified dextrins such as enzyme dextrin and Schardinger dextrin, oxidized starch such as solubilized starch, pregelatinized starch such as modified pregelatinized starch and unmodified pregelatinized starch, esterified starch such as starch phosphate, fatty starch, starch sulfate, starch nitrate, starch xanthate, and starch carbamate, etherified starch such as a carboxyalkyl starch, a hydroxyalkyl starch, a sulfoalkyl starch, cyanoethyl starch, allyl starch, benzyl starch, carbamylethyl starch, and a dialkylamino starch, crosslinked starch such as methylol-crosslinked starch, hydroxyalkyl-crosslinked starch, phosphoric acid-crosslinked starch, and dicarboxylic acid-crosslinked starch, and starch graft polymers such as a starch polyacrylamide copolymer, a starch polyacrylic acid copolymer, a starch polyvinyl acetate copolymer, a starch polyacrylonitrile copolymer, a cationic starch polyacrylic acid ester copolymer, a cationic starch vinyl polymer copolymer, a starch polystyrene maleic acid copolymer, a starch polyethylene oxide copolymer, and a starch polypropylene copolymer are preferable.

Among the water-soluble polymers, soybean polysaccharide, starch, gum Arabic, dextrin, carboxymethylcellulose, or polyvinyl alcohol are preferable, and gum Arabic or starch are more preferable. The water-soluble polymer may be used in combination of two or more types.

The content of the water-soluble polymer in the developer is preferably 0.1 to 20 wt%, and more preferably 0.5 to 10 wt%.

The developer may contain, in addition to the above-mentioned components, a wetting agent, a preservative, a chelating compound, an antifoaming agent, an organic acid, an organic solvent, an inorganic acid, an inorganic salt, etc.

As the wetting agent, ethylene glycol, propylene glycol, triethylene glycol, butylene glycol, hexylene glycol, diethylene glycol, dipropylene glycol, glycerol, trimethylolpropane, diglycerol, etc. are suitably used. These wetting agents may be used singly or in a combination of two or more types. The wetting agent is preferably used in an amount of 0.1 to 5 wt % relative to the total weight of the developer.

As the preservative, for example, phenol or a derivative thereof, formalin, an imidazole derivative, sodium dehydroacetate, a 4-isothiazolin-3-one derivative, benzisothiazolin-3-one, 2-methyl-4-isothiazolin-3-one, a benzotriazole derivative, an amidine guanidine derivative, a quaternary ammonium salt, a pyridine derivative, a quinoline derivative, a guanidine derivative, diazine, a triazole derivative, oxazole, an oxazine derivative, or a nitrobromoalcohol such as 2-bromo-2-nitropropane-1,3-diol, 1,1-dibromo-1-nitro-2-ethanol, or 1,1-dibromo-1-nitro-2-propanol is preferably used. It is preferable to use in combination at least two types of preservatives so as to exhibit efficacy toward various types of molds and bacteria.

The amount of preservative added is an amount that exhibits stable efficacy toward bacteria, molds, yeasts, etc., and depends on the type of bacterium, mold, or yeast, but is preferably in the range of 0.01 to 4 wt % relative to the total weight of the developer.

As the chelating compound, for example, ethylenediaminetetraacetic acid, the potassium salt thereof, or the sodium salt thereof; diethylenetriaminepentaacetic acid, the potassium salt thereof, or the sodium salt thereof; triethylenetetraminehexaacetic acid, the potassium salt thereof, or the sodium salt thereof; hydroxyethylethylenediaminetriacetic acid, the potassium salt thereof, or the sodium salt thereof; nitrilotriacetic acid or the sodium salt thereof; an organic phosphonic acid, for example, 1-hydroxyethane-1,1-diphosphonic acid, the potassium salt thereof, or the sodium salt thereof; or aminotri(methylenephosphonic acid), the potassium salt thereof, or the sodium salt thereof; or a phosphonoalkanetricarboxylic acid can be cited. An organic amine salt is also effective instead of the sodium salt or potassium salt of the chelating compounds.

As these chelating agents, those that are present stably in the developer and do not inhibit printing properties are selected. The amount thereof added is preferably 0.001 to 1.0 wt % relative to the total weight of the developer.

As the antifoaming agent, a normal silicone-based self emulsifying type, emulsifying type, nonionic, etc. compound having an HLB (Hydrophile-Lipophile Balance) of no greater than 5 may be used. Silicone antifoaming agents are preferable. Among them, any of an emulsifying dispersion type and a solubilizing type may be used.

The content of the antifoaming agent is preferably in the range of 0.001 to 1.0 wt % relative to the total weight of the developer.

As the organic acid, for example, citric acid, acetic acid, oxalic acid, malonic acid, salicylic acid, caprylic acid, tartaric acid, malic acid, lactic acid, levulinic acid, *p*-toluenesulfonic acid, xylenesulfonic acid, phytic acid, and an organic phosphonic acid can be cited. The organic acid may also be used in the form of an alkali metal salt or an ammonium salt. The content of the organic acid is preferably 0.01 to 0.5 wt % relative to the total weight of the developer.

As the inorganic acid and an inorganic salt, for example, phosphoric acid, metaphosphoric acid, monoammonium phosphate, diammonium phosphate, monosodium phosphate, disodium phosphate, monopotassium phosphate, dipotassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate, and nickel sulfate can be cited.

The content of the inorganic acid and the inorganic salt is preferably 0.01 to 0.5 wt % relative to the total weight of the developer.

Processing in the development step is not particularly limited, and development may be carried out by a known method, but it is preferably carried out using an automatic processor equipped with a rubbing member. Furthermore, the processing is more suitably carried out using an automatic processor equipped with supply means for the developer, etc. Examples of the automatic processor include an automatic processor described in JP-A-2006-235227 (JP-A denotes a Japanese unexamined patent application publication), etc. in which a lithographic printing plate precursor after imagewise recording is subjected to a rubbing treatment while being transported. Among them, an automatic processor using a rotating brush roller as the rubbing member is particularly preferable.

The preferable rotating brush roller that can be used in the present invention may be appropriately selected by taking account, for example, of the scratch resistance of the image area and the robustness of the support of the lithographic printing plate precursor. As the rotating brush roller, a known rotating brush roller produced by implanting a brush material in a plastic or metal roller may be used. For example, a rotating brush roller described in JP-A-58-159533 and JP-A-3-100554, or a brush roller described in JU-B-62-167253 (JU-B denotes a Japanese examined utility model application publication), in which a metal or plastic groove-shaped member having a brush material implanted in rows therein is closely radially wrapped around a plastic or metal roller acting as a core, may be used.

As the brush material, a plastic fiber (for example, a polyester-based synthetic fiber such as polyethylene terephthalate or polybutylene terephthalate; a polyamide-based synthetic fiber such as nylon 6.6 or nylon 6.10; a polyacrylic synthetic fiber such as polyacrylonitrile or a polyalkyl (meth)acrylate; or a polyolefin-based synthetic fiber such as polypropylene or polystyrene) may be used, for example, a brush material having a fiber bristle diameter of 20 to 400 µm and a bristle length of 5 to 30 mm may preferably be used.

Furthermore, the outer diameter of the rotating brush roller is preferably 30 to 200 mm, and the peripheral speed at the tip of the brush rubbing the plate surface is preferably 0.1 to 5 m/sec.

The direction of rotation of the rotating brush roller may be the same direction or the opposite direction with respect to the transport direction of the lithographic printing plate precursor, but when two or more rotating brush rollers are used in an automatic processor, it is preferable that at least one rotating brush roller rotates in the same direction and at least one rotating brush roller rotates in the opposite direction. By such an arrangement, the photosensitive layer in the non-image area can be more reliably removed. Furthermore, rocking the rotating brush roller in the rotational axis direction of the brush roller is also effective.

The developer that is used in the present invention may employ fresh liquid each time, but it is preferable to repeatedly use the developer after processing by circulating it through a filter.

As the filter for use in the invention, any filter may be used as long as it can filter the removed component of the image-recording layer mixed in a water washing unit. As a material of the filter, for example, a polyester resin, a polypropylene resin, a polyethylene resin a cellulose resin or cotton is preferably used. With respect to the configuration thereof, a structure in which a filter is held in the form of a cartridge in a housing as a replaceable filter is preferable. As the cartridge, a pleated type prepared by processing a filter paper made of a cellulose fiber with an epoxy resin in order to reinforce and prevent detachment of the fiber and casting in the form of pleats in order to increase a filtration area, a depth type prepared by winding up a yarn comprising many fibers (fiber bundle) from a central tube so as to form a gradual density gradient, or an adsorbing type prepared by housing an adsorbent in a case made of plastic, for example, polyethylene or prepared by supporting an adsorbent, for example, active carbon on media mainly composed of a resin, cellulose, a glass fiber and a water-absorbing polymer is preferably used. As the adsorbent, silica gel, active carbon, active aluminum, molecular sieve, clay and a material selected from superabsorbent fiber, calcium carbonate, calcium sulfate, potassium permanganate, sodium carbonate, potassium carbonate, sodium phosphate and active metal and ion exchanger used in various filters are used.

As a commercially available filter, a cartridge filter "TCW Type", "TCP Type" or "TCS Type" produced by Advantec Toyo Kaisha, Ltd. is preferably used.

A mesh diameter of the filter is preferably 5 to 500 µm, more preferably from 10 to 200 µm, yet more preferably 20 to 100 µm.

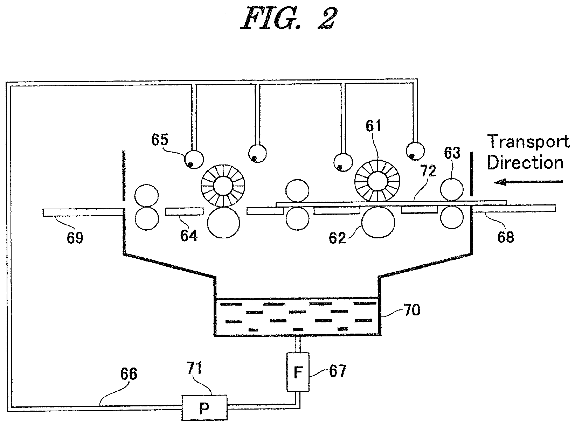

In the process for making a lithographic printing plate of the present invention, it is preferable to carry out the development step continuously twice or more. Examples of a specific method for carrying out processing continuously twice or more include a method in which processing is carried out repeatedly twice or more using an automatic processor (see FIG. 2) comprising only a development section equipped with a rubbing member as described above (in this case, processing may be carried out by joining two or more automatic processors) and a method in which an automatic processor having a plurality of development sections equipped with a rubbing member as described above is used.

Furthermore, as a preferred embodiment of the process for making a lithographic printing plate of the present invention, a washing step may be carried out subsequent to the development step. Printing stains due to a component removed by development becoming reattached to the plate surface are suppressed by carrying out the continuous development or washing step.

As the water used in the washing step, any water, for example, ordinary tap water, well water, deionized water or distilled water may be used, and tap water or well water is preferably used from a viewpoint of economy. As the water used in the washing step, it is preferred to use fresh water at any time or to reuse the water used in the washing step after circulation through a filter.

After the development step, a step of de-oleophilizing a non-image area using a gumming liquid may be carried out subsequent to the washing step. By supplying a gumming liquid to the plate surface subsequent to the washing step, a non-image area can be fully de-oleophilized.

In the de-oleophilization step, a normal gumming liquid or, among the developers, a developer comprising a water-soluble polymer (also called a 'water-soluble resin') is used. In the case of the latter, it is preferable to use a liquid having basically the same composition as that of the developer used in the development step in terms of the structure of equipment. This means that the developer used to charge a tank of a development unit is the same as the liquid used to charge a tank of a de-oleophilization unit, and does not mean taking into consideration a change in the composition due to a developer component being carried away during subsequent processing, contamination with a component of a lithographic printing plate precursor, evaporation of water, dissolution of carbon dioxide, etc. This enables a starting liquid or a replenisher for liquids used in the respective steps to be shared. Moreover, it is also possible to employ a cascade method in which, as a replenisher for the development section, a required amount is supplied by making a circulating liquid of the de-oleophilization section overflow.

A gumming liquid used in the de-oleophilization step after the washing step is explained.

As a de-oleophilizing agent used in the gumming liquid, gum arabic is preferably used and an aqueous solution containing about 15 to about 20% by weight of gum arabic is used as the gumming liquid. Various water-soluble resins are used as the de-oleophilizing agent other than the gum arabic. For example, dextrin, sterabic, stractan, alginic acid salt, polyacrylic acid salt, hydroxyethyl cellulose, polyvinyl pyrrolidone, polyacrylamide, methyl cellulose, hydroxypropyl cellulose, hydroxymethyl cellulose, carboxyalkyl cellulose salt and water-soluble polysaccharide extracted from soybean curd refuse are preferable, and pullulan, a derivative thereof and polyvinyl alcohol are also preferable.

Further, as a modified starch derivative, roast starch such as British gum, an enzymatically modified starch such as enzyme dextrin or Shardinger dextrin, oxidized starch such as solubilized starch, alphalized starch such as modified alphalized starch or unmodified alphalized starch, esterified starch such as starch phosphate, starch of fatty acid, starch sulfate, starch nitrate, starch xanthate or starch carbamate, etherified starch such as carboxyalkyl starch, hydroxyalkyl starch, sulfoalkyl starch, cyanoethyl starch, allyl starch, benzyl starch, carbamylethyl starch or dialkylamino starch, cross-linked starch such as methylol cross-linked starch, hydroxyalkyl cross-linked starch, phosphoric acid cross-linked starch or dicarboxylic acid cross-linked starch, or starch graft polymer such as starch-polyacrylamide copolymer, starch-polyacrylic acid copolymer, starch-polyvinyl acetate copolymer, starch-polyacrylonitrile copolymer, cationic starch-polyacrylate copolymer, cationic starch-polyvinyl copolymer, starch-polystyrene-maleic acid copolymer, starch-polyethylene oxide copolymer or starch-polypropylene copolymer is preferably used as the de-oleophilizing agent.

As a natural polymer compound, starch such as sweet potato starch, potato starch, tapioca starch, wheat starch or corn starch, a polymer obtained from seaweed such as carrageenan, laminaran, seaweed mannan, funori, Irish moss, agar or sodium alginate, plant mucilage such as tororoaoi, mannan, quince seed, pectin, tragacanth gum, karaya gum, xanthine gum, guar bean gum, locust bean gum, carob gum or benzoin gum, bacteria mucilage such as homopolysaccharide, e.g., dextran, glucan or levan, or heteropolysaccharide, e.g., succinoglucan or xanthan gum, or protein such as glue, gelatin, casein or collagen is preferably used.

Two or more of the water-soluble resins may be used in combination. The water-soluble resin may be preferably contained in a range of 1 to 50% by weight, more preferably in a range of 3 to 30% by weight, in the gumming liquid.

The gumming liquid used in the present invention may contain, for example, a pH adjusting agent, a surfactant, a perservative, an antimold, an oleophilic substance, a wetting agent, a chelating agent or a defoaming agent, in addition to the de-oleophilizing agent described above.

The gumming liquid is preferably used in a pH range of 3 to 12 and thus, a pH adjusting agent is preferably added to the gumming liquid. In order to adjust the pH of gumming liquid to 3 to 12, a mineral acid, an organic acid, an inorganic salt or the like is preferably added thereto. The amount thereof is preferably 0.01 to 2 % by weight. Examples of the mineral acid include nitric acid, sulfuric acid, phosphoric acid and metaphosphoric acid. Examples of the organic acid include acetic acid, oxalic acid, malonic acid, p-toluenesulfonic acid, levulinic acid, phytic acid, an organic phosphonic acid, polystyrene sulfonic acid and an amino acid, for example, glycine, α-alanine, and β-alanine. Examples of the inorganic salt include magnesium nitrate, sodium dihydrogen phosphate, disodium hydrogen phosphate, nickel sulfate, sodium hexametaphosphate or sodium tripolyphosphate. The mineral acid, organic acid, inorganic salt or the like may be used singly or in combination of two or more thereof.

Examples of the surfactant used in the gumming liquid include an anionic surfactant, a cationic surfactant, an amphoteric surfactant and a nonionic surfactant. Examples of the anionic surfactant include a fatty acid salt, an abietic acid salt, a hydroxyalkanesulfonic acid salt, an alkanesulfonic acid salt, an α-olefinsulfonic acid salt, a dialkylsulfosuccinic acid salt, an alkyldiphenyl ether disulfonaic acid salt, a straight-chain alkylbenzenesulfonic acid salt, a branched alkylbenzenesulfonic acid salt, an alkylnaphthalenesulfonic acid salt, an alkylphenoxypolyoxyethylenepropylsulfonic acid salt, a polyoxyethylene alkyl sulfophenyl ether salt, *N*-methyl-*N*-oleyltaurin sodium salt, an *N-*alkylsulfosuccinic monoamide disodium salt, a petroleum sulfonic acid salt, sulfated caster oil, sulfated beef-tallow oil, a sulfuric eater salt of fatty acid alkyl ester, an alkylsulfuric acid ester salt, a polyoxyethylene alkyl ether sulfuric acid ester salt, a fatty acid monoglyceride sulfuric acid ester salt, a polyoxyethylene alkyl phenyl ether sulfuric acid ester salt, a polyoxyethylene styryl phenyl ether sulfuric acid ester salt, an alkylphosphoric acid ester salt, a polyoxyethylene alkyl ether phosphoric acid ester salt, a polyoxyethylene alkyl phenyl ether phosphoric acid ester salt, a partially saponified styrene/maleic anhydride copolymer, a partially saponified olefin/maleic anhydride copolymer and a formaldehyde condensate of naphthalenesulfonic acid salt. Among them, a dialkylsulfosuccinic acid salt, an alkylsulfuric acid ester salt, an alkylnaphthalenesulfonic acid salt, an α-olefinsulfonic acid salt and an alkyldiphenyl ether disulfonaic acid salt are particularly preferably used.

Preferred examples of the cationic surfactant include an alkylamine salt and a quaternary ammonium salt.

Preferred examples of the amphoteric surfactant include an alkylcarboxybetaine, an alkylimidazoline, and an alkylaminocarboxylic acid.

Preferred examples of the nonionic surfactant include a polyoxyethylene alkyl ether, a polyoxyethylene alkyl phenyl ether, polyoxyethylene polystyryl phenyl ether, polyoxyethylene polyoxypropylene alkyl ether, a glycerol fatty acid partial ester, a sorbitan fatty acid partial ester, a pentaerythritol fatty acid partial ester, propylene glycol monofatty acid ester, sucrose fatty acid partial ester, a polyoxyethylene sorbitan fatty acid partial ester, a polyoxyethylene sorbitol fatty acid partial ester, a polyethylene glycol fatty acid ester, a polyglycerol fatty acid partial ester, a polyoxyethylenated cast oil, a polyoxyethyleneglycerol fatty acid partial ester, a fatty acid diethanolamide, an *N,N*-bis-2-hydroxyalkylamine, polyoxyethylene alkylamine, triethanolamine fatty acid ester, trialkylamine oxide, polypropylene glycol having a molecular weight of 200 to 5,000, trimethylolpropane, a glycerol or sorbitol polyoxyethylene or polyoxypropylene adduct, and an acetylene glycol system. A fluoro or silicone nonionic surfactant can be used as the same.

With regard to the surfactant, two or more types may be used in combination. It is not necessary to particularly limit the amount of surfactant used, but it is preferably 0.01 to 20 wt % relative to the total weight of the gumming liquid, and more preferably 0.05 to 10 wt %.

As the perservative, known perservatives used in the fields such as fields of fiber, wood processing, food, medicine, cosmetic and agriculture can be employed. Known perservatives, for example, a quaternary ammonium salt, a monovalent phenol derivative, a divalent phenol derivative, a polyvalent phenol derivative, an imidazole derivative, a pyrazolopyrimidine derivative, a monovalent naphthol, a carbonate, a sulfone derivative, an organic tin compound, a cyclopentane derivative, a phenyl derivative, a phenol ether derivative, a phenol ester derivative, a hydroxylamine derivative, a nitrile derivative, a naphthaline, a pyrrole derivative, a quinoline derivative, a benzothiazole derivative, a secondary amine, a 1,3,5-triazine derivative, a thiadiazole derivative, an anilide derivative, a pyrrole derivative, a halogen derivative, a dihydric alcohol derivative, a dithiol, a cyanic acid derivative, a thiocarbamide derivative, a diamine derivative, an isothiazole derivative, a monohydric alcohol, a saturated aldehyde, an unsaturated monocarboxylic acid, a saturated ether, an unsaturated ether, a lactone, an amino acid derivative, hydantoin, a cyanuric acid derivative, a guanidine derivative, a pyridine derivative, a saturated monocarboxylic acid, a benzenecarboxylic acid derivative, a hydroxycarboxylic acid derivative, biphenyl, a hydroxamic acid derivative, an aromatic alcohol, a halogenophenol derivative, a benzenecarboxylic acid derivative, a mercaptocarboxylic acid derivative, a quaternary ammonium salt derivative, a triphenylmethane derivative, hinokitiol, a furan derivative, a benzofuran derivative, an acridine derivative, an isoquinoline derivative, an arsine derivative, a thiocarbamic acid derivative, a phosphoric acid ester, a halogenobenzene derivative, a quinone derivative, a benzenesulfonic acid derivative, a monoamine derivative, an organic phosphoric acid ester, a piperazine derivative, a phenazine derivative, a pyrimidine derivative, a thiophanate derivative, an imidazoline derivative, an isoxazole derivative or an ammonium salt derivative can be used. Particularly preferable examples of the antiseptic agent include salt of pyridinethiol-1-oxide, salicylic acid and a salt thereof, 1,3,5-trishydroxyethylhexahydro-S-triazine, 1,3,5-trishydroxymethylhexahydro-S-triazine, 1,2-benzisothiazolin-3-one, 5-chloro-2-methyl-4-isothiazolin-3-one and 2-bromo-2-nitro-1,3-propanediol.

It is preferable to use in combination at least two types of preservatives in order to exhibit efficacy toward various types of molds and bacteria.

The preferable content of a preservative added is an amount that exhibits stable efficacy toward bacteria, molds, yeasts, etc., and preferably in the range of 0.01 to 4 wt % relative to the total weight of the gumming liquid, depending on the type of bacterium, molds, or yeast.

The gumming liquid may be include the oleophilic substance.

Preferable examples of the oleophilic substance include an organic carboxylic acid having 5 to 25 carbon atoms, for example, oleic acid, lanolic acid, valeric acid, nonylic acid, capric acid, myristic acid or palmitic acid and castor oil.

The oleophilic substances may be used singly or in combination of two or more thereof.

The content of the oleophilic substance in the gumming liquid is preferably in a range 0.005 to 10% by weight, more preferably 0.05 to 5% by weight, relative to the total weight of the gumming liquid.

In addition, as a wetting agent, glycerol, ethylene glycol, propylene glycol, triethylene glycol, butylene glycol, hexylene glycol, diethylene glycol, dipropylene glycol, glycerin, trimethylolpropane, diglycerin, and polyoxyethylene, etc. may be added to the gumming liquid as necessary.

The wetting agent may be used singly or in combination of two or more thereof.

The content of the wetting agent is preferably 0.1 to 5 wt % relative to the total weight of the gumming liquid.

Moreover, a chelating compound may be added to the gumming liquid.

The gumming liquid is ordinarily marketed as a concentrated solution and is diluted by addition of tap water, well water or the like to use. Calcium ion or the like included in the tap water or well water used for the dilution adversely affects printing and may be apt to cause stain on the printed material. In such a case, the problem can be solved by adding the chelating compound. Preferred examples of the chelating compound include ethylenediaminetetraacetic acid, the potassium salt thereof, or the sodium salt thereof; diethylenetriaminepentaacetic acid, the potassium salt thereof, or the sodium salt thereof; triethylenetetraminehexaacetic acid, the potassium salt thereof, or the sodium salt thereof; hydroxyethylethylenediaminetriacetic acid, the potassium salt thereof, or the sodium salt thereof; nitrilotriacetic acid or the sodium salt thereof; an organic phosphonic acid such as 1-hydroxyethane-1,1-diphosphonic acid, the potassium salt thereof, or the sodium salt thereof; aminotri(methylenephosphonic acid), the potassium salt thereof, or the sodium salt thereof; and a phosphonoalkanetricarboxylic acid. An organic amine salt is also effective instead of the sodium salt or potassium salt of the chelating compounds.

As the chelating agent, one that is present stably in the gumming liquid composition and does not inhibit printing properties is selected.

The amount of chelating agent added is preferably 0.001 to 1.0 wt % relative to the total weight of the gumming liquid.

The gumming liquid may include an antifoaming agent, and a silicone antifoaming agent is particularly preferable.

Furthermore, any of an emulsifying dispersion type and a solubilizing type antifoaming agent may be used.

The content of the antifoaming agent is preferably in the range of 0.001 to 1.0 wt % relative to the total weight of the gumming liquid.

The gumming liquid may also be prepared as an emulsion dispersion type. In the gumming liquid of emulsion dispersion type, an organic solvent is used as the oil phase thereof. Moreover, the gumming liquid may be in the form of solubilization type (emulsification type) by the aid of the surfactant as described above.

The organic solvent preferably has solubility of 5% by weight or less in water at 20°C and a boiling point of 160°C or more. The organic solvent includes a plasticizer having a solidification point of 15°C or less and a boiling point of 300° C or more under 1 atmospheric pressure, for example, a phthalic acid diester such as dibutyl phthalate, diheptyl phthalate, di-n-octyl phthalate, di(2-ethylhexyl)phthalate, dinonyl phthalate, didecyl phthalate, dilauryl phthalate or butyl benzyl phthalate, an aliphatic dibasic acid ester such as dioctyl adipate, butyl glycol adipate, dioctyl azelate, dibutyl sebacate, di(2-ethylhexyl)sebacate or dioctyl sebacate, an epoxidized triglyceride such as epoxidized soybean oil, a phosphate such as tricresyl phosphate, trioctyl phosphate or trischloroethyl phosphate and a benzoates such as benzyl benzoate.

Examples of the other alcohol type organic solvent include 2-octanol, 2-ethylhexanol, nonanol, *n*-decanol, undecanol, *n*-dodecanol, trimethylnonyl alcohol, tetradecanol and benzyl alcohol. Examples of a glycol type organic solvent include ethylene glycol monophenyl ether, ethylene glycol monobenzyl ether, butyl cellosolve and octylene glycol.

In selecting the compound, particularly, odor is taken account of. The amount of the organic solvent used is preferably 0.1 to 5% by weight, more preferably 0.5 to 3% by weight, relative to the de-oleophilizing agent. The organic solvents may be used singly or in combination of two or more thereof.

As the other gumming liquid, a gumming liquid described in EP 1,342,568 B1 and EP 1,788,444 A1, etc. is also preferably used.

The gumming liquid is produced by preparing an aqueous phase while controlling the temperature of 40°C ±5°C with stirring at a high speed, gradually adding dropwise an oil phase prepared to the aqueous phase, thoroughly stirring and emulsifying and dispersing by passing through a homogenizer of pressure type.

The reminder of the gumming liquid is water. It is advantageous in view of transportation that the gumming liquid is stored in the form of a concentrated solution in which the content of water is reduced in comparison with the time of use and the concentrated solution is diluted with water at the use. In such a case, the concentration degree is preferably in a level that each component of the gumming liquid does not cause separation or deposition.

The developer in the developing step, water in the washing step and gumming liquid in the de-oleophilizing step can be independently used at appropriate temperature, and they are preferably used in a temperature range of 10 to 50° C.

In the present invention, it is optionally possible to comprise a drying step after the any steps. Particularly, the drying step is preferably comprised as the last step at an automatic processor, and is more preferably comprised between the washing step and the de-oleophilizing step when these steps are comprised.

The drying step is preferably carried out by blowing dry wind of appropriate temperature after removing most of the developer by a roller nip.

### (Exposure step)

The process for making a lithographic printing plate of the present invention comprises a step of imagewise exposing the negative-working lithographic printing plate precursor (exposure step).

The exposure step is carried out prior to the development step. In the exposure step, the negative-working lithographic printing plate precursor obtained in the precursor production step is preferably exposed through a transparent original image having a line image, a halftone image, etc. or is preferably imagewise exposed by means of laser light scanning, etc. based on digital data.

The 'image' referred to in the present invention is a concept that includes an image in the narrow sense, such as graphics or pictorial photographs, as well as characters, numerals, symbols, etc., and also includes one in which the above are mixed.

Preferred examples of a light source preferable for the image exposure include a carbon arc lamp, a mercury lamp, a xenon lamp, a metal halide lamp, a strobe, an ultraviolet ray, an infrared ray or a laser beam. The laser beam is particularly preferable and includes a solid laser or semiconductor laser emitting an infrared ray having a wavelength of 760 to 1,200 nm, an ultraviolet semiconductor laser emitting light having a wavelength of 250 to 420 and an argon ion laser or an FD-YAG laser emitting visible light. Among them, from the standpoint of simplification of the plate making, a laser emitting an infrared ray which enables the work under a white lamp or a yellow lamp is preferable.

With regard to the infrared laser, the output is preferably 100 mW or more, the exposure time per pixel is preferably within 20 microseconds, and the irradiation energy is preferably 10 to 300 mJ/cm². In order to shorten the exposure time, it is preferred to use a multibeam laser device.

### (Precursor production step)

The process for making a lithographic printing plate of the present invention comprises a step of producing a negative-working lithographic printing plate precursor comprising, above a support, a photopolymerizable photosensitive layer (also called simply a 'photosensitive layer') (precursor production step).

Constituent elements and components of the lithographic printing plate precursor that can be used in the present invention are explained below.

### <Lithographic printing plate precursor>

The lithographic printing plate precursor used in the present invention has an ability to form a negative-working image in which an image area is formed from a region that has been imagewise exposed and cured and a non-image area is formed by removing an unexposed portion by processing as described above. In the present invention, 'comprising a photosensitive layer above a support' means both a case in which a photosensitive layer is directly provided on a support and a case in which another layer is provided between a photosensitive layer and a support, and does not exclude the presence of any layer that is provided in the lithographic printing plate precursor as desired such as a protective layer, an undercoat layer, an intermediate layer, or a back coat layer.

### Photosensitive layer

As a representative image formation mechanism for a photosensitive layer of a lithographic printing plate precursor used in the present invention, an embodiment comprising (Component a) a sensitizing dye, (Component b) a polymerization initiator, and (Component c) a polymerizable compound and an exposed region is polymerized and cured to thus form an image area can be preferably cited. That is, the photosensitive layer preferably comprises (Component a) a sensitizing dye, (Component b) a polymerization initiator, and (Component c) a polymerizable compound. Further, the photopolymerizable photosensitive layer further comprises an acrylic polymer comprising a vinyl carbazole compound-derived monomer unit or a urethane-acrylic hybrid polymer.

Furthermore, it is preferable that the photosensitive layer is a photosensitive layer that is sensitive to infrared light.

Moreover, it is more preferable that the photosensitive layer is sensitive to infrared light and comprises a triphenylalkylborate salt or a tetraphenylborate salt, and it is yet more preferable that it further comprises a copper phthalocyanine pigment.

Furthermore, it is also preferable that the photosensitive layer is sensitive to infrared light and does not contain a borate salt but contains a coloring dye.

These photosensitive layers that are sensitive to infrared light particularly preferably comprise a cyanine dye and an iodonium salt.

Each component contained in the photosensitive layer is explained in sequence.

### (Component a) Sensitizing dye

The photosensitive layer preferably comprises (Component a) a sensitizing dye.

Adding to the photosensitive layer, for example, a sensitizing dye having a maximum absorption at 350 to 450 nm, a sensitizing dye having a maximum absorption at 500 to 600 nm, or an IR absorber having a maximum absorption at 750 to 1,400 nm enables a high sensitivity lithographic printing plate precursor corresponding to a 405 nm violet laser, a 532 nm green laser, or an 803 nm IR laser, which are usually used in the present field, to be provided.

The sensitizing dye having a maximum absorption in the wavelength region of 350 to 450 nm is first explained.

Examples of such a sensitizing dye include a merocyanine dye, a benzopyran, a coumarin, an aromatic ketone, and an anthracene.

Among sensitizing dyes having an absorption maximum in the wavelength region of 350 to 450 nm, from the viewpoint of high sensitivity a dye represented by Formula (IV) below is preferable.

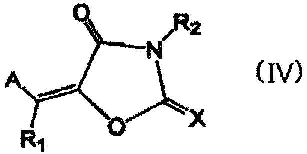

In Formula (IV), A denotes an optionally substituted aromatic ring group or heterocyclic group, X denotes an oxygen atom, a sulfur atom, or N-(R₃). R₁, R₂, and R₃ independently denote a monovalent non-metallic atomic group, and A and R₁, and R₂ and R₃ may be bonded to each other to form an aliphatic or aromatic ring.

Formula (IV) is explained in further detail.

R₁, R₂, and R₃ in Formula (IV) are independently a monovalent non-metallic atomic group, and preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxyl group, or a halogen atom.

A in Formula (IV) denotes an optionally substituted aromatic group or heterocyclic group, and examples of the optionally substituted aromatic ring or hetero ring include the same substituted or unsubstituted aryl groups and substituted or unsubstituted aromatic heterocyclic residues cited for R₁, R₂, and R₃ of Formula (IV).

Specific examples of such a sensitizing dye include compounds described in paragraphs 0047 to 0053 of JP-A-2007-58170.

Furthermore, a sensitizing dye represented by Formulae (V) to (VII) below may also be used.

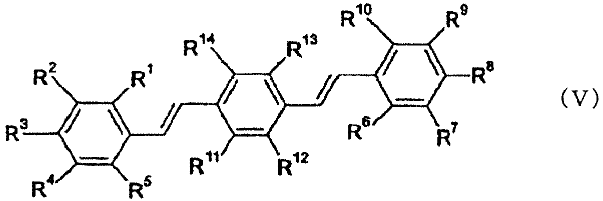

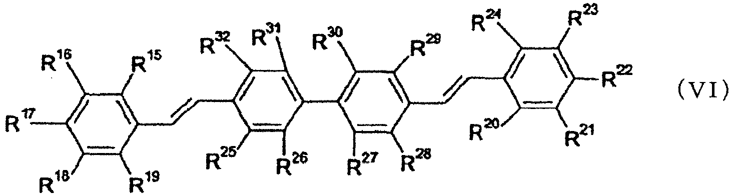

In Formula (V), R¹ to R¹⁴ independently denote a hydrogen atom, an alkyl group, an alkoxy group, a cyano group, or a halogen atom. At least one of R¹ to R¹⁰ denotes an alkoxy group having 2 or more carbons.

In Formula (VI), R¹⁵ to R³² independently denote a hydrogen atom, an alkyl group, an alkoxy group, a cyano group, or a halogen atom. At least one of R¹⁵ to R²⁴ denotes an alkoxy group having 2 or more carbons.

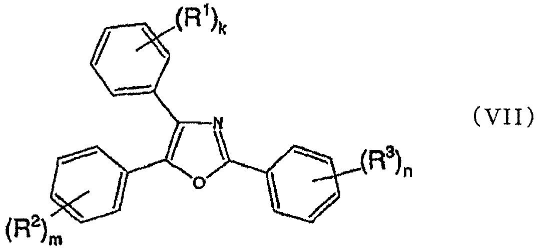

In Formula (VII), R¹, R², and R³ independently denote a halogen atom, an alkyl group, an aryl group, an aralkyl group, an -NR⁴R⁵ group, or an -OR⁶ group, R⁴, R⁵, and R⁶ independently denote a hydrogen atom, an alkyl group, an aryl group, or an aralkyl group, and k, m, and n independently denote an integer of 0 to 5.

Furthermore, sensitizing dyes described in JP-A-2007-171406, JP-A-2007-206216, JP-A-2007-206217, JP-A-2007-225701, JP-A-2007-225702, JP-A-2007-316582, and JP-A-2007-328243 may also be used.

The content of a sensitizing dye having a maximum absorption at 350 to 450 nm is preferably 0.05 to 30 parts by weight relative to 100 parts by weight of the total solids content of the photosensitive layer, more preferably 0.1 to 20 parts by weight, and yet more preferably 0.2 to 10 parts by weight. The solids content referred to here is the amount, excluding solvent, in the photosensitive layer or the composition.

The sensitizing dye having a maximum absorption at 750 to 1,400 nm that is suitably used in the present invention is explained in detail below.

The sensitizing dye like this includes an infrared absorber, and attains an electronically excited state with high sensitivity by irradiation with (exposure to) an IR laser, and it is surmised that electron transfer, energy transfer, generation of heat (photothermal conversion), etc. related to the electronically excited state acts on a polymerization initiator present in the photosensitive layer so as to cause a chemical change of the polymerization initiator, thus generating an active radial. In any case, adding a sensitizing dye having a maximum absorption at 750 to 1,400 nm is particularly suitable for production of a plate that is directly drawn using an IR laser having a wavelength of 750 nm to 1,400 nm, and compared with a conventional lithographic printing plate precursor, high image formation performance can be exhibited.

The infrared absorber is preferably a dye having an absorption maximum at a wavelength of 750 nm to 1,400 nm.

As the dye, commercial dyes and known dyes described in the literature such as 'Senryo Binran' (Dye Handbook) (Ed. The Society of Synthetic Organic Chemistry, Japan, 1970), etc. may be used. Specific examples thereof include an azo dye, a metal complex salt azo dye, a pyrazolone azo dye, a naphthoquinone dye, an anthraquinone dye, a phthalocyanine dye, a carbonium dye, a quinoneimine dye, a methine dye, a cyanine dye, a squarylium dye, a pyrylium salt, and a metal thiolate complex.

Among these dyes, a cyanine dye, a squarylium dye, a pyrylium salt, a nickel thiolate complex, and an indolenine cyanine dye are preferable, a cyanine dye and an indolenine cyanine dye are more preferable, and a cyanine dye represented by Formula (a) below is particularly preferable.

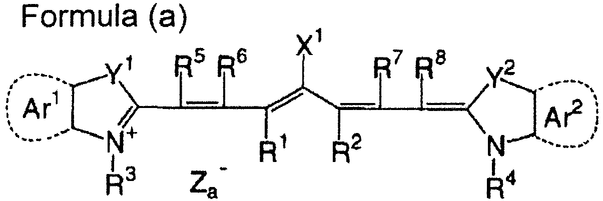

In Formula (a), X¹ denotes a hydrogen atom, a halogen atom, -NPh₂, X²-L¹, or the group shown below. Here, Ph denotes a phenyl group, X² denotes an oxygen atom, a nitrogen atom, or a sulfur atom, L¹ denotes a hydrocarbon group having 1 to 12 carbon atoms, a hetero atom-containing aromatic ring, or a hetero atom-containing hydrocarbon group having 1 to 12 carbon atoms. The hetero atom referred to here means N, S, O, a halogen atom, or Se. Xₐ⁻ is defined in the same manner as for Zₐ⁻, which is described later, and R^{a} independently denotes a hydrogen atom or a substituent selected from the group consisting of an alkyl group, an aryl group, a substituted or unsubstituted amino group, and a halogen atom.

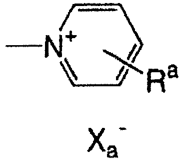

R¹ and R² independently denote a hydrocarbon group having 1 to 12 carbon atoms. From the viewpoint of storage stability of a photosensitive layer coating liquid, R¹ and R² are preferably hydrocarbon groups having two or more carbon atoms, and it is particularly preferable for R¹ and R² to be bonded to each other to form a 5-membered ring or a 6-membered ring.

Ar¹ and Ar² may be identical to or different from each other, and denote an optionally substituted aromatic hydrocarbon group.

Preferred examples of the aromatic hydrocarbon group include a benzene ring and a naphthalene ring. Preferred examples of the substituent include a hydrocarbon group having no greater than 12 carbon atoms, a halogen atom, and an alkoxy group having no greater than 12 carbon atoms.

Y¹ and Y² may be identical to or different from each other, and denote a sulfur atom or a dialkylmethylene group having no greater than 12 carbon atoms.

R³ and R⁴ may be identical to or different from each other, and denote an optionally substituted hydrocarbon group having no greater than 20 carbon atoms. Preferred examples of the substituent include an alkoxy group having no greater than 12 carbon atoms, a carboxy group, and a sulfo group.

R⁵, R⁶, R⁷, and R⁸ may be identical to or different from each other, and denote a hydrogen atom or a hydrocarbon group having no greater than 12 carbon atoms. From the availability of starting materials, a hydrogen atom is preferable.

Furthermore, Zₐ⁻ denotes a counteranion. When a cyanine dye represented by Formula (a) has an anionic substituent in its structure and neutralization of charge is unnecessary, Zₐ⁻ is not required. From the viewpoint of storage stability of the photosensitive layer coating liquid, Zₐ⁻ is preferably a halogen ion, a perchlorate ion, a tetrafluoroborate ion, a hexafluorophosphate ion, or a sulfonate ion, and particularly preferably a perchlorate ion, a hexafluorophosphate ion, or an arylsulfonate ion. Furthermore, from the viewpoint of high sensitivity, a triphenylalkylborate ion or a tetraphenylborate ion is also preferably used.

One containing no halide ion as a counterion is particularly preferable.

In the present invention, it is preferable to use a water-soluble cyanine dye as a sensitizing dye.

Examples of the water-soluble cyanine dye include those described in JP-A-2004-351823, and those having as a hydrophilic group in the molecule at least one group selected from the group consisting of a sulfonic acid group and/or a salt thereof, a phosphonic acid group and/or a salt thereof, a carboxylic acid group and/or a salt thereof, and a hydroxy group are preferable.

Among them, one having in the molecule at least two from a sulfonic acid group and/or a salt thereof and a phosphonic acid group and/or a salt thereof and having as a counterion an inorganic ion is yet more preferable.

Specific examples of the water-soluble cyanine dye that is suitable in the present invention are shown below, but the present invention should not be construed as being limited thereby. In the specific examples below, Me denotes a methyl group and Et denotes an ethyl group.

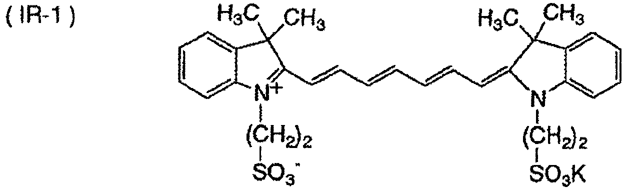

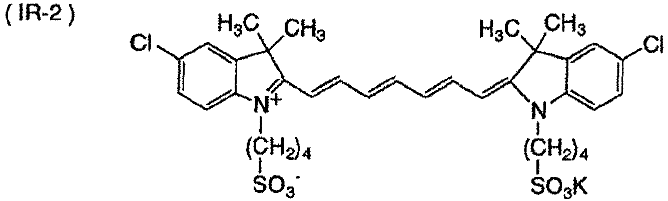

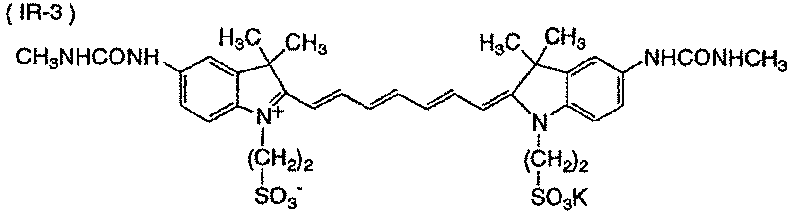

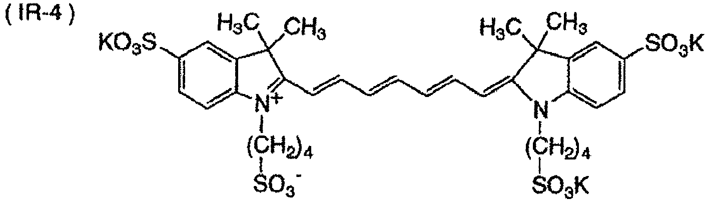

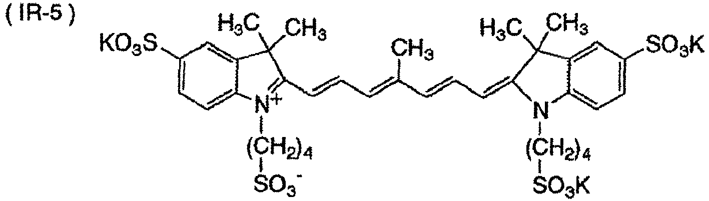

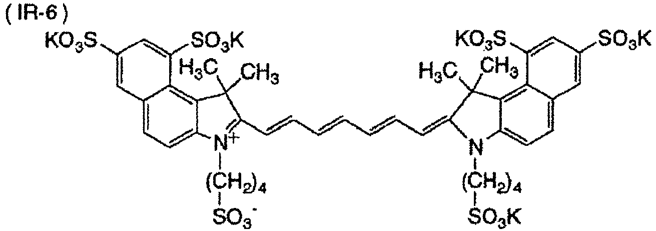

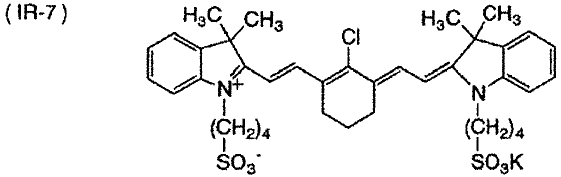

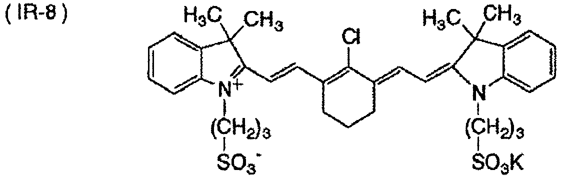

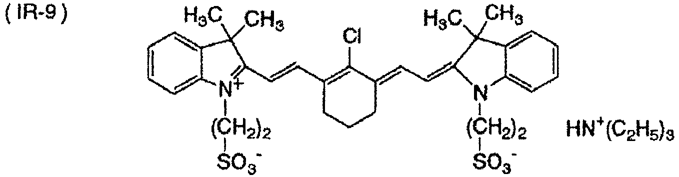

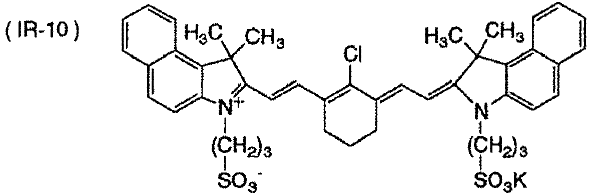

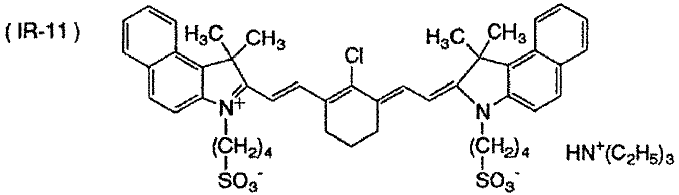

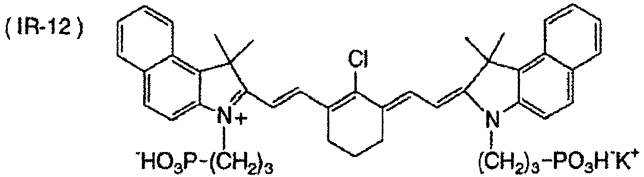

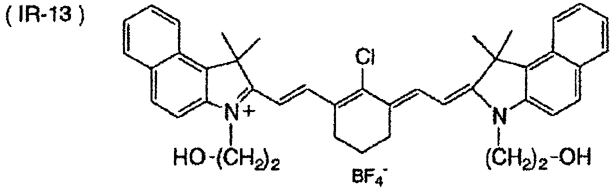

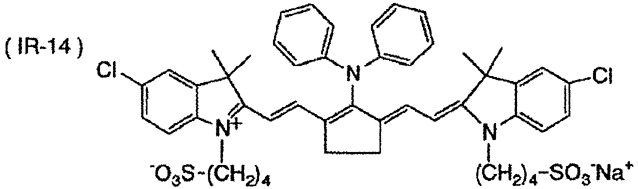

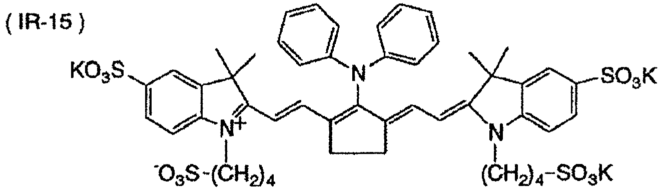

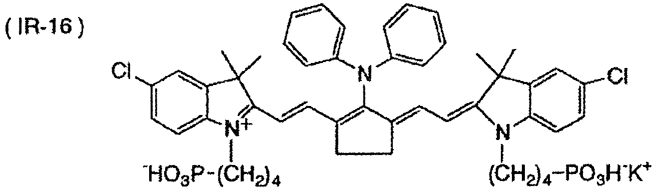

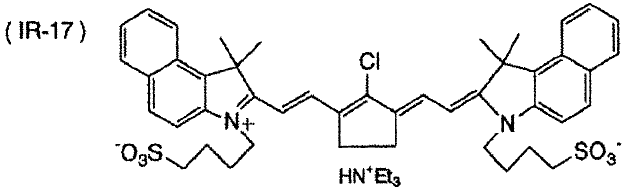

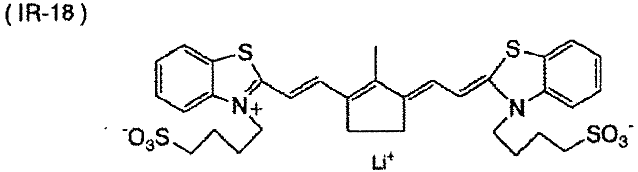

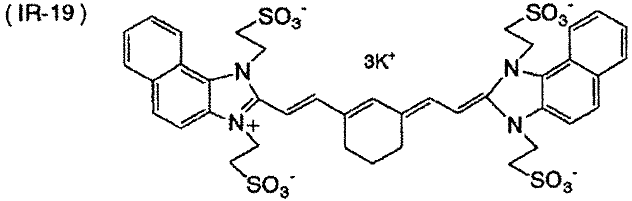

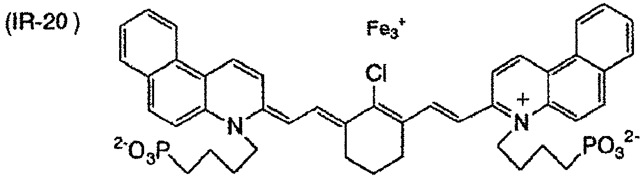

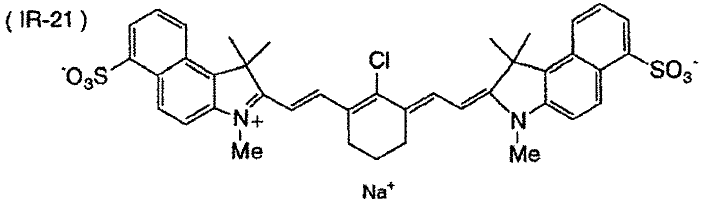

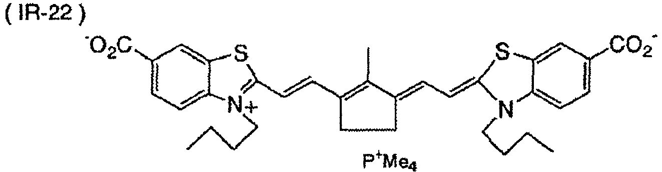

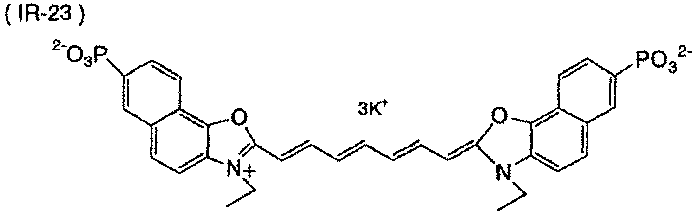

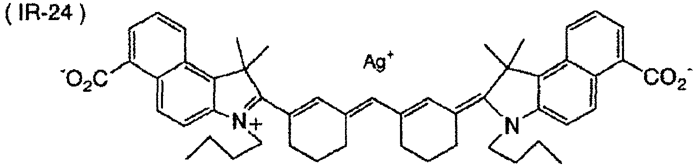

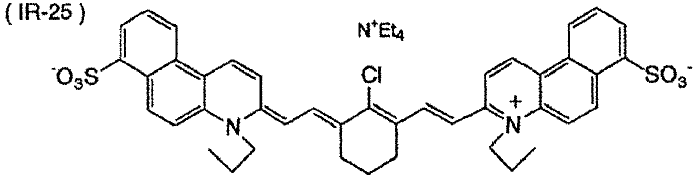

As a pigment, commercial pigments and pigments described in 'Karaa Indekkusu' (C. I.) Binran (Handbook), 'Saishin Ganryo Binran' (Latest Pigments Handbook) (Ed. Nippon Ganryo Gijutsu Kyokai, 1977), 'Saishin Ganryo Ouyo Gijutsu' (Latest Pigment Application Techniques' (CMC Publishing, 1986), and 'Insatsu Inki Gijutsu' (Printing Ink Techniques) (CMC Publishing, 1984) may be used.

Examples of the type of a pigment include a black pigment, a yellow pigment, an orange pigment, a brown pigment, a red pigment, a purple pigment, a blue pigment, a green pigment, a fluorescent pigment, a metal powder pigment and, in addition, polymer-binding dyes. Specifically, an insoluble azo pigment, an azo lake pigment, a condensed azo pigment, a chelate azo pigment, a phthalocyanine type pigment, an anthraquinone type pigment, perylene and perinone type pigments, a thioindigo type pigment, a quinacridone type pigment, a dioxazine type pigment, an isoindolinone type pigment, a quinophthalone type pigment, a dye lake pigment, an azine pigment, a nitroso pigment, a nitro pigment, a natural pigment, a fluorescent pigment, an inorganic pigment, carbon black, etc. may be used. Among these pigments, carbon black is preferable.

These pigments may be used with or without a surface treatment being carried out. As a method for the surface treatment, a method in which the surface is coated with a resin or wax, a method in which a surfactant is deposited, a method in which a reactive material (e.g. a silane coupling agent, an epoxy compound, a polyisocyanate, etc.) is bonded to the pigment surface, etc. can be considered. The above-mentioned surface treatment methods are described in 'Kinzoku Sekken no Seishitsu to Ouyo' (Properties and Applications of Metal Soaps) (SAIWAISHOBO), 'Insatsu Inki Gijutsu' (Printing Ink Techniques) (CMC Publishing, 1984), and 'Saishin Ganryo Ouyo Gijutsu' (Latest Pigment Application Techniques) (CMC Publishing, 1986).

The particle size of the pigment is preferably in the range of 0.01 µm to 10 µm, more preferably in the range of 0.05 µm to 1 µm, and particularly preferably in the range of 0.1 µm to 1 µm. When in above-mentioned range, the dispersion stability of the pigment in the photosensitive layer is excellent and a uniform photosensitive layer can be obtained.

As a method for dispersing the pigment, a known dispersion technique used for ink production, toner production, etc. may be used. Examples of a dispersion machine include an ultrasonic disperser, a sand mill, an attritor, a pearl mill, a super mill, a ball mill, an impeller, a disperser, a KD mill, a colloidal mill, a dynatron, a three roll mill, and a pressure kneader. Details are described in 'Saishin Ganryo Ouyo Gijutsu' (Latest Pigment Application Techniques) (CMC Publishing, 1986).

The sensitizing dye may be added to the same layer as other components or may be added to another layer provided separately.

From the viewpoint of uniformity in the photosensitive layer and durability of the photosensitive layer, the content of the sensitizing dye is preferably 0.01 to 50 wt % relative to the total content of solids forming the photosensitive layer, and more preferably 0.1 to 10 wt %; in the case of a dye it is particularly preferably 0.5 to 10 wt %, and in the case of a pigment it is particularly preferably 0.1 to 10 wt %.

### (Component b) Polymerization initiator

The photosensitive layer in the present invention preferably contains a polymerization initiator (hereinafter, also called an 'initiator compound').

An initiator compound is a compound that undergoes chemical change by actions such as electron transfer, energy transfer, or generation of heat caused by the electronically excited state of a sensitizing dye to thus generate at least one type selected from a radical, an acid, or a base. Hereinafter, a radical, an acid, and a base thus generated are simply called 'active species'. When an initiator compound is used, in practice sufficient sensitivity cannot be obtained. As one mode in which a sensitizing dye and an initiator compound are used in combination, they may be made into a single compound by an appropriate chemical method (linking the sensitizing dye and the initiator compound by a chemical bond, etc.) and used.

It is surmised that many of these initiator compounds usually form an active species via at least one initial chemical process represented by (1) to (3) below. That is, (1) reductive decomposition of an initiator compound based on an electron transfer reaction from a sensitizing dye in an electronically excited state to the initiator compound, (2) oxidative decomposition of an initiator compound based on electron transfer from the initiator compound to a sensitizing dye in an electronically excited state, and (3) decomposition of an initiator compound in an electronically excited state based on energy transfer from a sensitizing dye in an electronically excited state to the initiator compound. Although there is often some ambiguity with respect to which individual initiator compound belongs to which type of (1) to (3), the sensitizing dye in the present invention exhibits a very high sensitizing effect in combination with any type of these initiator compounds.

As the initiator compoundin the prensent invention, a compound known to a person skilled in the art may be used without any restrictions, and specific examples thereof include a trihalomethyl compound, a carbonyl compound, an organic peroxide, an azo type compound, an azide compound, a metallocene compound, a hexaarylbiimidazole compound, an organic boron compound, a disulfone compound, an oxime ester compound, an onium salt compound, and an iron arene complex. Among them, it is preferably at least one type selected from the group consisting of a hexaarylbiimidazole-based compound, an onium salt, a trihalomethyl compound, and a metallocene compound, and it is particularly preferably a hexaarylbiimidazole-based compound. Furthermore, the polymerization initiator may be used in a combination of two or more types as appropriate.

As the hexaarylbiimidazole compound, there can be cited lophine dimers described in JP-B-45-37377 and JP-B-44-86516 (JP-B denotes a Japanese examined patent application publication), and examples thereof include 2,2'-bis(*o*-chlorophenyl)-4,4',5,5'-tetraphenylbiimidazole, 2,2'-bis(*o-*bromophenyl)-4,4',5,5'-tetraphenylbiimidazole, 2,2'-bis(*o,p*-dichlorophenyl)-4,4',5,5'-tetraphenylbiimidazole, 2,2'-bis(*o*-chlorophenyl)-4,4',5,5'-tetra(*m-*methoxyphenyl)biimidazole, 2,2'-bis(*o,o*'-dichlorophenyl)-4,4',5,5'-tetraphenylbiimidazole, 2,2'-bis(*o*-nitrophenyl)-4,4',5,5'-tetraphenylbiimidazole, 2,2'-bis(*o*-methylphenyl)-4,4',5,5'-tetraphenylbiimidazole, and 2,2'-bis(*o*-trifluoromethylphenyl)-4,4',5,5'-tetraphenylbiimidazole.

The hexaarylbiimidazole-based compound is particularly preferably used in combination with a sensitizing dye having a maximum absorption at 350 to 450 nm.

Examples of the onium salt (functioning as an ionic polymerization initiator in the present invention, not as an acid generator) preferably used in the present invention are represented by Formulae (RI-I) to (RI-III) below.

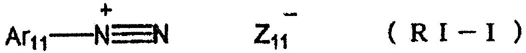

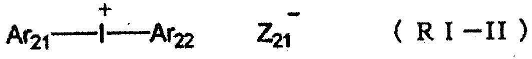

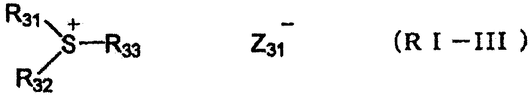

In Formula (RI-I), Ar₁₁ denotes an aryl group that has not more than 20 carbons and that may have 1 to 6 substituents. Preferable examples of the substituent include an alkyl group having 1 to 12 carbons, an alkenyl group having 2 to 12 carbons, an alkynyl group having 2 to 12 carbons, an aryl group having 6 to 12 carbons, an alkoxy group having 1 to 12 carbons, an aryloxy group having 6 to 12 carbons, a halogen atom, an alkylamino group having 1 to 12 carbons, a dialkylamino group having 2 to 12 carbons, an alkylamide group or arylamide group having 1 to 12 carbons, a carbonyl group, a carboxy group, a cyano group, a sulfonyl group, a thioalkyl group having 1 to 12 carbons, and a thioaryl group having 6 to 12 carbons.

Z₁₁⁻ denotes a monovalent anion, and specific examples of the monovalent anion include a halide ion, a perchlorate ion, a hexafluorophosphate ion, a tetrafluoroborate ion, a triphenylalkyl borate ion, a tetraphenyl borate ion, a sulfonate ion, a sulfinate ion, a thiosulfonate ion, or a sulfate ion. Among them, a perchlorate ion, a hexafluorophosphate ion, a tetrafluoroborate ion, a sulfonate ion, and a sulfinate ion are preferable from the viewpoint of stability, and a triphenylalkyl borate ion and a tetraphenyl borate ion are preferable from the viewpoint of high sensitivity.

In Formula (RI-II), Ar₂₁ and Ar₂₂ independently denote an aryl group that has not more than 20 carbons and that may have 1 to 6 substituents. Preferable examples of the substituent include an alkyl group having 1 to 12 carbons, an alkenyl group having 2 to 12 carbons, an alkynyl group having 2 to 12 carbons, an aryl group having 6 to 12 carbons, an alkoxy group having 1 to 12 carbons, an aryloxy group having 6 to 12 carbons, a halogen atom, an alkylamino group having 1 to 12 carbons, a dialkylamino group having 2 to 12, an alkylamide group or arylamide group having 1 to 12 carbons, a carbonyl group, a carboxy group, a cyano group, a sulfonyl group, a thioalkyl group having 1 to 12 carbons, or a thioaryl group having 6 to 12 carbons.

Z₂₁⁻ denotes a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion, and a carboxylate ion. Among them, a perchlorate ion, a hexafluorophosphate ion, a tetrafluoroborate ion, a triphenylalkyl borate ion, a tetraphenyl borate ion, a sulfonate ion, a sulfinate ion, and a carboxylate ion are preferable from the viewpoint of stability and reactivity, and a triphenylalkyl borate ion and a tetraphenyl borate ion are particularly preferable from the viewpoint of high sensitivity.

In Formula (RI-III), R₃₁, R₃₂, and R₃₃ independently denote an aryl group that has not more than 20 carbons and that may have 1 to 6 substituents, an alkyl group, an alkenyl group, or an alkynyl group. Among them, the aryl group is preferable from the viewpoint of reactivity and stability.

Examples of the substituent include an alkyl group having 1 to 12 carbons, an alkenyl group having 2 to 12 carbons, an alkynyl group having 2 to 12 carbons, an aryl group having 6 to 12 carbons, an alkoxy group having 1 to 12 carbons, an aryloxy group having 6 to 12 carbons, a halogen atom, an alkylamino group having 1 to 12 carbons, a dialkylamino group having 2 to 12 carbons, an alkylamide group or arylamide group having 1 to 12 carbons, a carbonyl group, a carboxy group, a cyano group, a sulfonyl group, a thioalkyl group having 1 to 12 carbons, and a thioaryl group having 6 to 12 carbons.

Z₃₁⁻ denotes a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion, and a carboxylate ion. Among them, a perchlorate ion, a hexafluorophosphate ion, a tetrafluoroborate ion, a triphenylalkyl borate ion, a tetraphenyl borate ion, a sulfonate ion, a sulfinate ion, and a carboxylate ion are preferable from the viewpoint of stability and reactivity, and a triphenylalkyl borate ion and a tetraphenyl borate ion are particularly preferable from the viewpoint of high sensitivity.

Carboxylate ions described in JP-A-2002-148790 and JP-A-2001-343742 are also preferably used.

The onium salt is particularly preferably used in combination with an infrared absorber having a maximum absorption at 750 to 1,400 nm.

As other polymerization initiators, polymerization initiators described in JP-A-2007-171406, JP-A-2007-206216, JP-A-2007-206217, JP-A-2007-225701, JP-A-2007-225702, JP-A-2007-316582, and JP-A-2007-328243 may preferably be used.

The polymerization initiator in the present invention may be preferably used singly or in a combination of two or more types.

The content of polymerization initiator used in the photosensitive layer in the present invention is preferably 0.01 to 20 wt % relative to the total weight of the solids content of the photosensitive layer, more preferably 0.1 to 15 wt %, and yet more preferably 1.0 to 10 wt %.

### (Component c) Polymerizable compound

The photosensitive layer preferably comprises (Component c) a polymerizable compound.

The polymerizable compound (Component c) that can be used in the present invention is an addition-polymerizable compound comprising at least one ethylenically unsaturated bond; a compound having at least one terminal ethylenically unsaturated bond is preferable, and a compound having two or more thereof is more preferable.

As the polyfunctional ethylenically unsaturated compound, compounds having 2 to 20 terminal ethylenically unsaturated groups are preferable. These compound groups are widely known in the present industrial field, and, in the present invention, these may be used without particular limitation. These have chemical forms such as a monomer, a prepolymer, that is, a dimer, a trimer and an oligomer, or copolymers of monomers, and mixtures thereof.

Examples of the monomer include unsaturated carboxylic acids (such as acrylic acid, methacrylic acid, itaconic acid, crotonic acid, isocrotonic acid and maleic acid), and esters and amides thereof. Preferably esters of an unsaturated carboxylic acid and an aliphatic polyhydric alcoholic compound, or amides of an unsaturated carboxylic acid and an aliphatic polyvalent amine compound are used. Moreover, addition reaction products of unsaturated carboxylic acid esters or amides having a nucleophilic substituent such as a hydroxyl group, an amino group, or a mercapto group with polyfunctional isocyanates or epoxies, and dehydrating condensation reaction products with a polyfunctional carboxylic acid, etc. are also used preferably. Moreover, addition reaction products of unsaturated carboxylic acid esters or amides having an electrophilic substituent such as an isocyanato group or an epoxy group with monofunctional or polyfunctional alcohols, amines, or thiols, and substitution reaction products of unsaturated carboxylic acid esters or amides having a leaving group such as a halogen group or a tosyloxy group with monofunctional or polyfunctional alcohols, amines, or thiols are also preferable. Moreover, as another example, the use of compounds obtained by replacing the unsaturated carboxylic acid with a vinyl compound, an allyl compound, an unsaturated phosphonic acid, styrene, a vinyl ether or the like is also possible.

Specific examples of ester monomers comprising an ester of an aliphatic polyhydric alcohol compound and an unsaturated carboxylic acid include acrylic acid esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and a polyester acrylate oligomer.

Examples of methacrylic acid esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[*p*-(3-methacryloxy-2-hydroxypropoxy)phenyl]dimethylmethane, and bis[*p-*(methacryloxyethoxy)phenyl]dimethylmethane.

Examples of itaconic acid esters include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

Examples of crotonic acid esters include ethylene glycol dicrotonate, tetramethylene glycol dicrotonate, pentaerythritol dicrotonate, and sorbitol tetradicrotonate.

Examples of isocrotonic acid esters include ethylene glycol diisocrotonate, pentaerythritol diisocrotonate, and sorbitol tetraisocrotonate.

Examples of maleic acid esters include ethylene glycol dimaleate, triethylene glycol dimaleate, pentaerythritol dimaleate, and sorbitol tetramaleate.

As examples of other esters, aliphatic alcohol-based esters described in JP-B-46-27926, JP-B-51-47334 and JP-A-57-196231, those having an aromatic skeleton described in JP-A-59-5240, JP-A-59-5241, and JP-A-2-226149, those having an amino group described in JP-A-1-165613, etc. may also be used preferably.

The above-mentioned ester monomers may be used as a mixture.

Furthermore, specific examples of amide monomers including an amide of an aliphatic polyamine compound and an unsaturated carboxylic acid include *N,N'*-methylenebisacrylamide, *N,N'*-methylenebismethacrylamide, 1,6-hexamethylenebisacrylamide, 1,6-hexamethylenebismethacrylamide, diethylenetriaminetrisacrylamide, xylylenebisacrylamide, and xylylenebismethacrylamide.

Preferred examples of other amide-based monomers include those having a cyclohexylene structure described in JP-B-54-21726.

Furthermore, a urethane-based addition-polymerizable compound produced by an addition reaction of an isocyanate and a hydroxy group is also suitable, and specific examples thereof include a vinylurethane compound comprising two or more polymerizable vinyl groups per molecule in which a hydroxy group-containing vinyl monomer represented by Formula (i) below is added to a polyisocyanate compound having two or more isocyanate groups per molecule described in JP-B-48-41708.

CH₂=C(R⁴)COOCH_{2CH}(R⁵)OH (i)

(R⁴ and R⁵ independently denote H or CH₃.)

Furthermore, urethane acrylates described in JP-A-51-37193, JP-B-2-32293, and JP-B-2-16765, and urethane compounds having an ethylene oxide-based skeleton described in JP-B-58-49860, JP-B-56-17654, JP-B-62-39417, JP-B-62-39418 are also preferable.

Furthermore, by use of an addition-polymerizable compound having an amino structure or a sulfide structure in the molecule described in JP-A-63-277653, JP-A-63-260909, and JP-A-1-105238, a photosensitive resin composition having very good photosensitive speed can be obtained.

Other examples include polyfunctional acrylates and methacrylates, for example, polyester acrylates and epoxy acrylates obtained by reacting an epoxy resin with acrylic acid or methacrylic acid, described in JP-A-48-64183, JP-B-49-43191, and JP-B-52-30490. Specific unsaturated compounds described in JP-B-46-43946, JP-B-1-40337, and JP-B-1-40336, and vinylphosphonic acid-based compounds described in JP-A-2-25493 can also be cited. In some cases, a structure containing a perfluoroalkyl group described in JP-A-61-22048 can be preferably used. Moreover, photocurable monomers or oligomers described in Nippon Secchaku Kyokaishi (Journal of Japan Adhesion Society), Vol. 20, No. 7, pp. 300-308 (1984) can also be used.

Details of a method for using the polymerizable compound, for example, selection of the structure, single or combined use, or amount added, can be appropriately determined in accordance with the characteristic design of the final lithographic printing plate precursor. For example, the compound is selected from the following standpoints.

From the viewpoint of sensitivity, a structure having a large unsaturated group content per molecule is preferable, and in many cases, a di- or higher-functional compound is preferable. Also, in order to increase the strength of the image area, that is, the cured film, a tri- or higher-functional compound is preferable. The combined use of compounds different in the number of functional groups or in the type of polymerizable group (for example, an acrylic acid ester, a methacrylic acid ester, a styrene compound, or a vinyl ether compound) is an effective method for controlling both sensitivity and strength.

The selection and method of use of the polymerizable compound are also important factors for compatibility and dispersibility with other components (for example, a binder polymer, a polymerization initiator, or a colorant) in the photosensitive layer. For example, compatibility may be improved in some cases by using a compound of low purity or by using two or more types of compounds in combination. A specific structure may be selected for the purpose of improving adhesion to a support, a protective layer, which is described below, etc.

In the present invention, the content of the polymerizable compound (Component c) used in the photosensitive layer is preferably 5 to 80 wt % relative to the total solids content of the photosensitive layer, and more preferably 25 to 75 wt %.

In the method of using the polymerizable compound, appropriate structure, combination, and amount added can be freely selected by taking account of the degree of polymerization inhibition due to oxygen, resolution, fogging properties, change in refractive index, surface tackiness, etc. Furthermore, depending on the case, the layer construction, for example, an undercoat layer or an overcoat layer, and the coating method may also be considered.

### (Component d) Binder polymer

The photosensitive layer comprises one type or two or more types of binder polymer (Component d).

As the binder polymer, any one of various polymers that are known in the present industrial field to be used in a photosensitive layer of a negative-working lithographic printing plate precursor, etc. may be used with the proviso that the binder polymer comprises an acrylic polymer comprising a vinyl carbazole compound-derived monomer unit or a urethane-acrylic hybrid polymer.

The binder polymer that can be used in the present invention preferably has a weight-average molecular weight of 2,000 to 1,000,000, and more preferably 10,000 to 200,000. The binder polymer preferably has an acid value (mgKOH/g) of 20 to 400 when it is determined by using a known method.

Some binders are water-insoluble but soluble in a general alkaline developer. Examples of such a binder polymer include but are not limited to, (meth)acrylic acid ester resins, polyvinyl acetals, phenolic resin, polymers derived from styrene, *N*-substituted cyclic imides or maleic anhydrides, such as those described in EP Pat. No. 1,182,033 and U.S. Pat. Nos. 6,309,792, 6,352,812 (Shimazu et al.), U.S. Pat. Nos. 6,569,603, and 6,893,797. The vinyl carbazole polymers having pendant *N*-carbazole moieties as described in U.S. Pat. No. 4,774,163 and the polymers having pendant vinyl groups as described in U.S. Pat. Nos. 8,899,994 and 4,511,645, and EP Pub. Pat. No. 1,182,033 are also useful.

The binder polymer that is useful in the present invention has a hydrophobic skeleton and is formed from both constituent repeating units a) and b) below or only from the constituent repeating unit b).
a) A repeating unit having a pendant cyano group directly bonded to the hydrophobic skeleton.
b) A repeating unit having a pendant group comprising a poly(alkylene oxide) segment.

These polymeric binders comprise poly(alkyleneoxide) segments and preferably poly(ethyleneoxide) segments. These polymers can be graft copolymers having a main chain polymer and poly(alkyleneoxide) pendant side chains or segments of block copolymers having blocks of (alkyleneoxide)-containing recurring units and non(alkyleneoxide)-containing recurring units. Both graft and block copolymers can additionally have pendant cyano groups attached directly to the hydrophobic backbone. The alkylene oxide constitutional units are preferably an alkylene oxide group having 1 to 6 carbons, and more preferably an alkylene oxide group having 1 to 3 carbons. The alkylene portions can be linear or branched or substituted versions thereof. Poly(ethyleneoxide) and poly(propyleneoxide) segments are preferred and poly(ethyleneoxide) segments are most preferred.

In some embodiments, the binder polymer may comprise only the constituent repeating unit comprising a poly(alkyleneoxide) segment, and in other embodiments the polymer binder may comprise the constituent repeating unit comprising a poly(alkyleneoxide) segment and the constituent repeating unit comprising a pendant cyano group directly bonded to the hydrophobic skeleton. As one example, such a constituent repeating unit may comprise a pendant group comprising a cyano, cyano-substituted, or cyano-terminal alkylene group. The repeating unit may be derived from an ethylenically unsaturated monomer such as for example acrylonitrile, methacrylonitrile, methylcyanoacrylate, ethylcyanoacrylate, or a combination thereof. However, a cyano group may be introduced into a polymer by other conventional means. Examples of such a cyano group-containing binder polymer are described in the specification of US Pat. Laid-open No. 2005/003285.

By way of example, such polymeric binders can be formed by polymerization of a combination or mixture of suitable ethylenically unsaturated polymerizable monomers or macromers, such as:
A) acrylonitrile, methacrylonitrile, or a combination thereof,
B) poly(alkyleneoxide) esters of acrylic acid or methacrylic acid, such as poly(ethylene glycol) methyl ether acrylate, poly(ethylene glycol) methyl ester methacrylate, or a combination thereof, and
C) optionally, monomers such as acrylic acid, methacrylic acid, styrene, hydroxystyrene, acrylate esters, methacrylate esters, acrylamide, methacrylamide, or a combination of such monomers.

The amount of poly(alkyleneoxide) segment in such a binder polymer is preferably 0.5 to 60 wt%, more preferably 2 to 50 wt%, yet more preferably 5 to 40 wt%, and particularly preferably 5 to 20 wt%. The amount of (alkyleneoxide) segment in the block copolymer is preferably 5 to 60 wt%, more preferably 10 to 50 wt%, and yet more preferably 10 to 30 wt%. A polymer binder comprising a poly(alkyleneoxide) side chain may be present in the form of dispersed particles.

The binder polymer is preferably one comprising constituent repeating units derived from one or more types of (meth)acrylic acid, a (meth)acrylate, styrene and a styrene derivative, vinylcarbazole, and a poly(alkylene glycol) (meth)acrylate. Furthermore, the binder polymer is more preferably one comprising constituent repeating units derived from two or more types of the above monomers.

The binder polymer in the present invention is particularly preferably a polymer comprising a vinylcarbazole compound-derived monomer unit, and most preferably a polymer comprising a vinylcarbazole compound-derived monomer unit and further an acrylonitrile-derived monomer unit. Furthermore, the polymer is preferably an acrylic polymer (also called an 'acrylic resin'). In addition, the acrylic polymer referred to here is a polymer in which a (meth)acrylate compound is homopolymerized or copolymerized.

The binder polymer is preferably 10 to 70 wt% relative to the total solids content of the photosensitive layer, and more preferably 20 to 50 wt%.

Furthermore, the photosensitive layer preferably comprises a urethane-acrylic hybrid polymer that is uniformly dispersed in the layer. This hybrid polymer is more preferably in the form of particles. This hybrid polymer has a weight-average molecular weight of 50,000 to 500,000 and has an average particle size of the particles of 10 to 10,000 nm, preferably 30 to 500 nm, and more preferably 30 to 150 nm. These hybrid polymers may be aromatic or aliphatic depending on the structure of a starting material used in production. Two or more types of urethane-acrylic hybrid polymer particles may be used as a mixture. For example, a Hybridur 570 polymer dispersion and a Hybridur 870 polymer dispersion may be used by mixing.

The urethane-acrylic hybrid polymer that can be used in the present invention may usually be produced as follows. First, a polyol and an excess amount of a diisocyanate are reacted, thus giving a polyurethane prepolymer dispersed in water. The prepolymer preferably has a carboxy group. Subsequently, the prepolymer is mixed with at least one vinyl monomer such as an acrylate monomer or a substituted/unsubstituted styrene monomer and further with a tertiary amine, and this mixture is dispersed in water. By initiating polymerization by adding an oil-soluble initiator to this aqueous dispersion, a hybrid polymer that is dispersed in water as colloidal particles can be obtained. This dispersion is not a simple mixture of a polyurethane dispersion and an acrylic emulsion but a product in which polymerization of a urethane and polymerization of an acrylic component have occurred at the same time and have completed. The urethane-acrylic hybrid polymer particles are preferably dispersion-stabilized by a negative charge.

Furthermore, as described in the specification of US Pat. No. 3,684,758, a method in which a polyurethane dispersion is first produced and an acrylic monomer is then added thereto to thus form an acrylic polymer in the presence of the polyurethane dispersion is also a useful method for obtaining a urethane-acrylic hybrid polymer dispersion.

As an alternative method, a method in which a urethane prepolymer and an acrylic monomer are dispersed together in water and a urethane polycondensation reaction and an acrylic polymerization reaction are made to progress at the same time is also described in for example the specifications of US Pat. No. 4,644,030 and US Pat. No. 5,173,526.

Details of the other production method and physical properties of the urethane-acrylic hybrid polymer are described by Galgoci et al. in JCT Coatings Tech., 2 (13), 28 to 36 (February, 2005).

With regard to the urethane-acrylic hybrid polymer that can be used in the present invention, the diisocyanate compound used as a starting material for the urethane is particularly preferably diphenylmethane diisocyanate, m-tolylene diisocyanate, isophorone diisocyanate, or dicyclohexylmethane diisocyanate. That is, the urethane-acrylic hybrid polymer particularly preferably has a monomer unit derived from a compound selected from the group consisting of diphenylmethane diisocyanate, m-tolylene diisocyanate, isophorone diisocyanate, and dicyclohexylmethane diisocyanate.

The urethane-acrylic hybrid polymer that is preferably used in the present invention may be a commercial product that is a dispersion of urethane-acrylic hybrid polymer particles, such as Hybridur 540, 560, 570, 580, 870, 878, or 880 available from Air Products and Chemicals, Inc. (Allentown, Pennsylvania). These dispersions generally comprise urethane-acrylic hybrid polymer particles at a solids content of at least 30 wt%, and are dispersed in an appropriate aqueous medium, which may comprise a commercially available surfactant, antifoaming agent, dispersant, or preservative and, furthermore, a pigment or a water-dispersible organic solvent as additional components.

The urethane-acrylic hybrid polymer is preferably contained at 10 to 70 wt% relative to the total solids content of the photosensitive layer, and more preferably at 10 to 50 wt%.

### -Other components-

### (1) Surfactant

The photosensitive layer in the present invention may comprise a surfactant in order to promote developability and improve the coated surface condition.

Examples of the surfactant include a nonionic surfactant, an anionic surfactant, a cationic surfactant, an amphoteric surfactant, and a fluorine-based surfactant.

Preferred examples of a surfactant include a fluorine-based surfactant containing a perfluoroalkyl group in the molecule. Examples of such a fluorine-based surfactant include an anionic type such as a perfluoroalkylcarboxylic acid salt, a perfluoroalkylsulfonic acid salt, or a perfluoroalkylphosphoric acid ester; an amphoteric type such as a perfluoroalkylbetaine; a cationic type such as a perfluoroalkyltrimethylammonium salt; and a nonionic type such as a perfluoroalkylamine oxide, a perfluoroalkyl ethylene oxide adduct, an oligomer containing a perfluoroalkyl group and a hydrophilic group, an oligomer containing a perfluoroalkyl group and a lipophilic group, an oligomer containing a perfluoroalkyl group, a hydrophilic group, and a lipophilic group, or a urethane containing a perfluoroalkyl group and a lipophilic group. Furthermore, a fluorine-based surfactant described in JP-A-62-170950, JP-A-62-226143, or JP-A-60-168144 may also be preferably cited.

The surfactant may be used singly or in a combination of two or more types.

The content of the surfactant is preferably 0.001 to 10 wt % of the total solids content of the photosensitive layer, and more preferably 0.01 to 5 wt %.

### (2) Colorant

The photosensitive layer in the present invention may contain as an image colorant a dye or a pigment having a large absorption in the visible light region. It is preferable to add a colorant since it becomes easy to differentiate between an image area and a non-image area after image formation.

Examples of the pigment that is used in the present invention include a phthalocyanine-based pigment, an azo-based pigment, and pigments such as carbon black and titanium oxide. In the present invention, it is particularly preferable to use a copper phthalocyanine pigment from the viewpoint of image formation sensitivity and printing durability.

On the other hand, with regard to the dye, when the photosensitive layer contains a triphenylalkylborate salt or a tetraphenylborate salt (including a case in which it is present as a counterion of a polymerization initiator or an infrared-absorbing dye (IR dye)), although the reason is not clear, the lithographic printing plate precursor might become susceptible to fogging by faint light, and ease of handling during plate making is greatly degraded, but when a borate salt is not contained in the photosensitive layer, a dye may be used as a colorant in the same manner as for the pigment.

Specific examples of the dye include Oil Yellow #101, Oil Yellow #103, Oil Pink #312, Oil Green BG, Oil Blue BOS, Oil Blue #603, Oil Black BY, Oil Black BS, Oil Black T-505 (all from Orient Chemical Industry Co., Ltd.), Victoria Pure Blue, Crystal Violet (CI42555), Methyl Violet (CI42535), Ethyl Violet, Rhodamine B (CI45170B), Malachite Green (CI42000), Methylene Blue (CI52015), and dyes described in JP-A-62-293247.

The content of the colorant is preferably 0.01 to 10 wt% relative to the total solids content of the photosensitive layer.

### (3) Printing-out agent

The photosensitive layer in the present invention may comprise a compound whose color is changed by an acid or a radical in order to form a printed-out image.

Examples of such a compound include various types of dyes such as diphenylmethane-based, triphenylmethane-based, thiazine-based, oxazine-based, xanthene-based, anthraquinone-based, iminoquinone-based, azo-based, and azomethine-based dyes.

The content of a dye whose color is changed by an acid or a radical is preferably 0.01 to 10 wt% relative to the photosensitive layer solids content. (4) Polymerization inhibitor

The photosensitive layer in the present invention preferably contains a small amount of a thermal polymerization inhibitor in order to inhibit undesired thermal polymerization of the compound having a polymerizable ethylenically unsaturated bond, that is, polymerizable compound (C) during the production process of the photosensitive layer or the storage of the lithographic printing plate precursor.

Examples of the thermal polymerization inhibitors include hydroquinone, *p*-methoxyphenol, di-*t*-butyl-*p*-cresol, pyrogallol, *t-*butylcatechol, benzoquinone, 4,4'-thiobis(3-methyl-6-*t*-butylphenol), 2,2'-methylenebis(4-methyl-6-*t*-butylphenol), and a cerium (I) salt of *N-*nitrosophenylhydroxylamine.

The content of the polymerization inhibitor in the photosensitive layer is preferably in the range of 0.01 to 5 wt % relative to the total weight of solids in the photosensitive layer.

### (5) Higher fatty acid derivative

Furthermore, in the photosensitive layer on the present invention, in order to avoid polymerization inhibition due to oxygen, a higher fatty acid derivative such as behenic acid or behenic amide may be added and allowed to localize on the photosensitive layer surface during the drying step after the coating, as necessary.

The content of the higher fatty acid derivative in the photosensitive layer is preferably in the range 0.1 to 10 wt % relative to the total weight of solids in the photosensitive layer.

### (6) Plasticizer

A plasticizer may be added to the recording layer of the present invention in order to impart flexibility to the coating.

Examples of the plasticizer used include butylphthalyl butyl glycolate, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, and oligomers and polymers of acrylic acid or methacrylic acid.

The content of the plasticizer is preferably no greater than 30 wt % relative to the total solids content of the photosensitive layer.

### (7) Inorganic particles

The photosensitive layer in the present invention may comprise inorganic particles in order to improve cured film strength and improve developability.

Preferred examples of the inorganic particles include silica, alumina, magnesium oxide, titanium oxide, magnesium carbonate, calcium alginate, and mixtures thereof. They may be used for strengthening a film, improving adhesion at an interface by roughening a surface, etc.

The inorganic particles preferably have an average particle size of 5 nm to 10 µm, and more preferably 0.5 µm to 3 µm. When in this range, they are dispersed stably in the photosensitive layer and the film strength of the photosensitive layer is fully maintained, thus enabling a non-image area that is formed to have excellent hydrophilicity that can suppress staining during printing.

The inorganic particles described above may easily be obtained as a commercial product such as a colloidal silica dispersion.

The content of the inorganic particles is preferably no greater than 40 wt% relative to the total solids content of the photosensitive layer, and more preferably no greater than 30 wt%. (8) Low-molecular-weight hydrophilic compound

The photosensitive layer in the present invention may comprise a low-molecular-weight hydrophilic compound in order to improve developability without degrading printing durability.

With regard to the low-molecular-weight hydrophilic compound, examples of a water-soluble organic compound include glycols such as ethylene glycol, diethylene glycol, triethylene glycol, propylene glycol, dipropylene glycol, and tripropylene glycol, ether or ester derivatives thereof, polyhydroxy compounds such as glycerol and pentaerythritol, organic amines such as triethanolamine, diethanolamine, and monoethanolamine, salts thereof, organic sulfonic acids such as an alkylsulfonic acid, toluenesulfonic acid, and benzenesulfonic acid, salts thereof, organic sulfamic acids such as an alkylsulfamic acid, salts thereof, organic sulfuric acids such as an alkylsulfuric acid and an alkyl ether sulfuric acid, salts thereof, organic phosphonic acids such as phenylphosphonic acid, salts thereof, organic carboxylic acids such as tartaric acid, oxalic acid, citric acid, malic acid, lactic acid, gluconic acid, and an amino acid, and salts thereof.

Among them, an organic sulfonic acid, an organic sulfamic acid, or an organic sulfate such as a sodium salt or a lithium salt of an organic sulfuric acid is preferably used.

These compounds have a small hydrophobic moiety structure, have hardly any interfacial activation effect, and are clearly differentiated from the surfactants described above, for which a long-chain alkylsulfonate, a long-chain alkylbenzenesulfonate, etc. is preferably used.

The amount of low-molecular-weight hydrophilic compound added to the photosensitive layer is preferably 0.5 to 20 wt% relative to the total solids content of the photosensitive layer, more preferably 1 to 10 wt%, and yet more preferably 2 to 8 wt%. When in this range, good developability and printing durability can be obtained.

With regard to the low-molecular-weight hydrophilic compound, one type may be used on its own or two or more types may be used as a mixture.

### (9) Oleophilizing agent

The lithographic printing plate precursor that can be used in the present invention may comprise in the photosensitive layer and/or the protective layer a phosphonium compound as an oleophilizing agent in order to improve ink laydown.

Preferred examples of the phosphonium compound include compounds described in JP-A-2006-297907 or JP-A-2007-50660.

As the oleophilizing agent, in addition to a phosphonium compound, a nitrogen-containing compound can also be cited as a desirable example. Preferred examples of the nitrogen-containing compound include an amine salt, a quaternary ammonium salt, an imidazolinium salt, a benzimidazolinium salt, a pyridinium salt, and a quinolinium salt. Among them, a quaternary ammonium salt and a pyridinium salt are preferably used.

The amount of oleophilizing agent added to the photosensitive layer or the protective layer is preferably 0.01 to 20 wt% of the solids content of each layer, more preferably 0.05 to 10 wt%, and yet more preferably 0.1 to 5 wt%. When in this range, good ink laydown can be obtained.

### (10) Chain transfer agent or co-sensitizer

The photosensitive layer may comprise a known compound referred to as a chain transfer agent or a co-sensitizer, which further improve the sensitivity or have a function of suppressing polymerization inhibition by oxygen, etc.

Examples of such a compound include amines such as compounds described in M. R. Sander et al., 'Journal of Polymer Society', Vol. 10, p. 3173 (1972), JP-B-44-20189, JP-A-51-82102, JP-A-52-134692, JP-A-59-138205, JP-A-60-84305, JP-A-62-18537, JP-A-64-33104, and Research Disclosure No. 33825, and specific examples include triethanolamine, *N*-phenylglycine, *N*-phenylaspartic acid, ethyl *p*-dimethylaminobenzoate, and *N,N*-dialkylaniline derivatives such as *p*-formyldimethylaniline and *p*-methylthiodimethylaniline.

The othe examples of a compound functioning as a chain transfer agent include a group of compounds having SH, PH, SiH, or GeH in the molecules. These compounds can donate hydrogen to a low activity radical species to generate a radical or are oxidized and then deprotonated to generate a radical.

The photosensitive layer of the present invention may preferably employ as a chain transfer agent a thiol compound (e.g. a 2-mercaptobenzimidazole, a 2-mercaptobenzothiazole, a 2-mercaptobenzoxazole, a 3-mercaptotriazole, a 5-mercaptotetrazole, etc.) in particular. Among them, a thiol compound described in JP-A-2006-091479, etc. is particularly preferably used. In accordance with the use of the thiol compound as a chain transfer agent, a problem of odor and degradation of sensitivity due to evaporation from the photosensitive layer or diffusion to another layer can be avoided, the storage stability is excellent, and a lithographic printing plate precursor having high sensitivity and high plate life can be obtained.

The amount of sensitizer or chain transfer agent used is preferably 0.01 to 20 wt% relative to the total solids content of the photosensitive layer, more preferably 0.1 to 15 wt%, and yet more preferably 1.0 to 10 wt%.

### Formation of Photosensitive Layer

The photosensitive layer in the present invention is formed by dispersing or dissolving each of the necessary components described above in a solvent to prepare a coating liquid, applying the liquid above a support, and drying.

As the solvent used here, there can be cited for example ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, *N,N*-dimethylacetamide, *N,N*-dimethylformamide, tetramethylurea, *N-*methylpyrrolidone, dimethylsulfoxide, sulfolane, γ-butyrolactone, toluene, and water, but the present invention should not be construed as being limited thereto.

These solvents may be used singly or in a combination of two or more types as a mixture.

The solids content concentration of the coating liquid is preferably 1 to 50 wt %.

The photosensitive layer in the present invention may also be formed by preparing a plurality of coating liquids by dispersing or dissolving the same or different components described above in the same or different solvents and repeatedly coating and drying a plurality of times.

The amount (solids content) of the photosensitive layer that the support is coated with after coating and drying may be varied depending on the use, but normally it is preferably 0.3 to 3.0 g/m². In the above-mentioned range good sensitivity and good film properties of the photosensitive layer can be obtained.

Various methods can be used for the coating. Examples of the method include bar coater coating, spin coating, spray coating, curtain coating, dip coating, air knife coating, blade coating, and roll coating.

### (Protective Layer)

In the lithographic printing plate precursor according to the invention, it is preferable to provide a protective layer (overcoat layer) on the image-recording layer.

The protective layer has a function for preventing, for example, occurrence of scratch in the image-recording layer or ablation caused by exposure with a high illuminance laser beam, in addition to the function for restraining an inhibition reaction against the image formation by means of oxygen blocking.

Components constituting the protective layer will be described below.

Ordinarily, the exposure process of a lithographic printing plate precursor is performed in the air. The image-forming reaction occurred upon the exposure process in the image-recording layer may be inhibited by a low molecular weight compound such as oxygen or a basic substance present in the air. The protective layer prevents the low molecular weight compound such as oxygen or a basic substance from penetrating into the image-recording layer and as a result, the inhibition of image-forming reaction at the exposure process in the air can be avoided.

Accordingly, the property required of the protective layer is to reduce permeability of the low molecular compound such as oxygen. Furthermore, the protective layer preferably has good transparency to light used for the exposure, is excellent in an adhesion property to the photosensitive layer, and can be easily removed during the developing step after the exposure. With respect to the protective layer having such properties, there are described, for example, in U.S. Pat. No. 3,458,311 and JP-B-55-49729.

Examples of a material used in the protective layer include any water-soluble polymer and water-insoluble polymer can be appropriately selected to use. Specifically, a water-soluble polymer such as polyvinyl alcohol, a modified polyvinyl alcohol, polyvinyl pyrrolidone, polyvinyl imidazole, polyacrylic acid, polyacrylamide, a partially saponified product of polyvinyl acetate, an ethylene-vinyl alcohol copolymer, a water-soluble cellulose derivative, gelatin, a starch derivative or gum arabic, and a polymer such as polyvinylidene chloride, poly(meth)acrylonitrile, polysulfone, polyvinyl chloride, polyethylene, polycarbonate, polystyrene, polyamide or cellophane.

The polymers may be used in combination of two or more thereof, as necessary.

Examples of a relatively useful material that can be used in the protective layer include a water-soluble polymer compound excellent in crystallinity. Specifically, polyvinyl alcohol, polyvinyl pyrrolidone, polyvinyl imidazole, a water-soluble acrylic resin, for example, polyacrylic acid, gelatin or gum arabic is preferably used. Above all, polyvinyl alcohol, polyvinyl pyrrolidone and polyvinyl imidazole are more preferably used from the standpoint of capability of coating with water as a solvent and easiness of removal with dampening water at the printing. Among them, polyvinyl alcohol (PVA) provides most preferable results on the fundamental properties, for example, oxygen blocking property or removability with development.

The polyvinyl alcohol that can be used in the protective layer may be partially substituted with ester, ether or acetal as long as it contains unsubstituted vinyl alcohol units having the necessary water solubility. In the same way, part of the polyvinyl alcohol may include another copolymer component. For example, polyvinyl alcohols of various degrees of polymerization having at random various types of hydrophilic modified sites such as an anion-modified site modified with an anion such as a carboxy group or a sulfo group, a cation-modified site modified with a cation such as an amino group or an ammonium group, a silanol-modified site, and a thiol-modified site, and polyvinyl alcohols of various degrees of polymerization having at the terminal of the polymer chain various types of modified sites such as the above-mentioned anion-modified site, the above-mentioned cation-modified site, a silanol-modified site, and a thiol-modified site and, furthermore, an alkoxy-modified site, a sulfide-modified site, an ester-modified site of vinyl alcohol with various types of organic acids, an ester-modified site of the above-mentioned anion-modified site with an alcohol, and an epoxy-modified site can be preferably used.

Among them, an anionically-modified polyvinyl alcohol is most preferable since dispersion stability in the developer is good. The content of the anionically-modified polyvinyl alcohol is preferably 10 to 50 wt% of the total solids content of the protective layer, and more preferably 20 to 40 wt%.

Preferable examples of the polyvinyl alcohol include those having a hydrolysis degree (a saponification degree) of 71 to 100% by mole and a polymerization degree of 300 to 2,400. Specific examples of the polyvinyl alcohol include PVA-105, PVA-110, PVA-117, PVA-117H, PVA-120, PVA-124, PVA-124H, PVA-CS, PVA-CSt PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 produced by Kuraray Co., Ltd.

Specific examples of the modified polyvinyl alcohol include that having an anion-modified cite such as KL-318, KL-118, KM-618, KM-118 or SK-5102, that having a cation-modified cite, for example, C-318, C-118 or CM-318, that having a terminal thiol-modified cite such as M-205 or M-115, that having a terminal sulfide-modified cite such as MP-103, MP-203, MP-102 or MP-202, that having an ester-modified cite with a higher fatty acid at the terminal such as HL-12F or HL-1203 and that having a reactive silane-modified cite such as R-1130, R-2105 or R-2130.

It is also preferable that the protective layer contains an inorganic stratiform compound, that is, an inorganic compound having a stratiform structure and a tabular shape. By using the inorganic stratiform compound together, in addition that the oxygen blocking property is more increased and the film strength of the protective layer is more increased to improve the scratch resistance, a matting property is imparted to the protective layer.

The inorganic stratiform compound includes, for example, mica, for example, natural mica represented by the following formula: A(B, C)₂₋₅D₄O₁₀(OH, F, O)₂, (wherein A represents Li, K, Na, Ca, Mg or an organic cation, B and C indepentdently represents Fe (II), Fe(III), Mn, Al, Mg or V, and D represents Si or Al) or synthetic mica, talc represented by the formula: 3MgO· 4SiO· H₂O, teniolite, montmorillonite, saponite, hectolite and zirconium phosphate.

Examples of the mica compound include natural micas such as muscovite, paragonite, phlogopite, biotite, and lepidolite. Examples of synthetic micas include non-swelling micas such as fluorine-phologopite KMg₃(AlSi₃O₁₀)F₂ or potassium tetrasilicic mica KMg_{2.5}(Si₄O₁₀)F₂, and swelling micas such as Na tetrasililic mica NaMg_{2.5}(Si₄O₁₀)F₂, Na or Li taeniolite (Na,Li)Mg₂Li(Si₄O₁₀)F₂, or montmorillonite-based Na or Li hectorite (Na,Li)_{1/8}Mg_{2/5}Li_{1/8}(Si₄O₁₀)F₂. Moreover, synthetic smectite is also useful.

Among the acbove-mentioned mica compounds, fluorine-based swelling mica which is a synthetic stratiform compound is particularly useful. That is, swelling clay minerals such as mica, montmorillonite, saponite, hectolite, and bentonite have a layered structure comprising on the order of 10 to 15 Å thick unit crystal lattice layers, and metal atom substitution within the lattice is markedly larger than other clay minerals. As a result, the lattice layer is deficient in positive charge, and in order to compensate for positive ions of organic cations such as Li⁺, Na⁺, Ca²⁺, Mg²⁺, an amine salt, a quaternary ammonium salt, phosphoniumu salt, and sulfoniumu salt, etc. are adsorbed between layers. These stratiform compounds are swollen by water. When shear is applied in this state, it easily cleaves, thus forming a stable sol in water. This tendency is strong for bentonite and a swelling synthetic mica, which are useful in the present invention, and particularly from the viewpoint of readily availability and uniformity of quality a swelling synthetic mica is preferably used.

The shape of the atratiform compound used is a tabular particle shape, from the viewpoint of control of diffusion, the thinner the better, and with regard to the planar size, the larger the better as long as the smoothness of the coated surface and transmission of actinic radiation are not inhibited. Therefore, the aspect ratio is at least 20, preferably at least 100, and particularly preferably at least 200. The aspect ratio is the ratio of thickness to major axis of a particle and can be measured, for example, from a projection view of a particle by microphotography. The larger the aspect ratio, the greater the effect obtained.

As for the particle size of the stratiform compound used in the protective layer in the present invention, the average major axis is preferably 0.3 to 20 µm, more preferably 0.5 to 10 µm, and particularly preferably 1 to 5 µm. When in this range, penetration of oxygen or moisture can be fully suppressed, dispersion stability in a coating solution is sufficient, and coating can be carried out stably. The average thickness of the particles is preferably no greater than 0.1 µm, more preferably no greater than 0.05 µm, and yet more preferably no greater than 0.01 µm. Specifically, in the inorganic stratiform compound, the thickness of the swelling synthetic mica, which is a representative compound, is on the order of 1 to 50 nm and the planar size is on the order of 1 to 20 µm.

When such an inorganic stratiform compound particle having a large aspect ratio is incorporated into the protective layer, strength of the coated layer increases and penetration of oxygen or moisture can be effectively inhibited so that the protective layer can be prevented from deterioration due to deformation, and even when the lithographic printing plate precursor is preserved for a long period of time under a high humidity condition, it is prevented from decrease in the image-forming property thereof due to the change of humidity and exhibits excellent preservation stability.

Examples of common dispersing method for using the stratiform compound in the protective layer are described below.

Specifically, 5 to 10 parts by weight of a swellable stratiform compound which is exemplified as a preferable stratiform compound is added to 100 parts by weight of water to adapt the compound to water and to be swollen, followed by dispersing using a dispersing machine. The dispersing machine used include, for example, a variety of mills conducting dispersion by directly applying mechanical power, a high-speed agitation type dispersing machine providing a large shear force and a dispersion machine providing ultrasonic energy of high intensity. Specific examples thereof include a ball mill, a sand grinder mill, a visco mill, a colloid mill, a homogenizer, a dissolver, a polytron, a homomixer, a homoblender, a keddy mill, a jet agitor, a capillary type emulsifying device, a liquid siren, an electromagnetic strain type ultrasonic generator and an emulsifying device having Polman whistle. A dispersion containing from 5 to 10% by weight of the inorganic stratiform compound thus prepared is highly viscous or gelled and exhibits extremely good preservation stability.

In the formation of a coating solution for protective layer using the dispersion, it is preferred that the dispersion is diluted with water, sufficiently stirred and then mixed with a binder solution.

The content of the inorganic stratiform compound in the protective layer is preferably 5/1 to 1/100 in terms of a weight ratio of the inorganic stratiform compound to an amount of a binder used in the protective layer. When a plural kind of the inorganic stratiform compounds is used together, it is preferred that the total amount of the inorganic stratiform compounds is in the range of weight ratio described above.

As other additive for the protective layer, glycerin, dipropylene glycol, propionamide, cyclohexane diol, sorbitol or the like can be added in an amount corresponding to several % by weight of the water-soluble or water-insoluble polymer to impart flexibility. Moreover, a known additive, for example, a water-soluble (meth)acrylic polymer or a water-soluble plasticizer can be added in order to improve the physical property of the protective layer.

Furthermore, the protective layer according to the invention is formed using a coating solution for protective layer as described below and to the coating solution for protective layer may be added known additives for increasing an adhesion property to the image-recording layer or for improving time-lapse stability of the coating solution.

Specifically, an anionic surfactant, a nonionic surfactant, a cationic surfactant or a fluorine-based surfactant can be added to the coating solution of protective layer in order to improve the coating property. More specifically, an anionic surfactant, for example, sodium alkyl sulfate or sodium alkyl sulfonate; an amphoteric surfactant, for example, alkylamino carboxylic acid salt or alkylamino dicarboxylic acid salt; or a non-ionic surfactant, for example, polyoxyethylene alkyl phenyl ether can be added.

The amount of the surfactant added is 0.1 to 100% by weight of the water-soluble or water-insoluble polymer.

Moreover, for the purpose of improving the adhesion property to the image-recording layer, for example, it is described in JP-A-49-70702 and GB 1,303,578 A that sufficient adhesion can be obtained by mixing 20 to 60% by weight of an acrylic emulsion, a water-insoluble vinyl pyrrolidone-vinyl acetate copolymer or the like in a hydrophilic polymer mainly comprising polyvinyl alcohol and coating the mixture on the photosensitive layer. In the present invention, any of such known techniques can be used.

Moreover, other functions can also be provided to the protective layer. For example, by adding a coloring agent (for example, a water-soluble dye), which is excellent in permeability for infrared ray used for the exposure and capable of efficiently absorbing light at other wavelengths, a safe light adaptability can be improved without causing decrease in the sensitivity.

The formation of the protective layer is performed by coating a coating solution for the protective layer prepared by dispersing or dissolving the components of the protective layer in a solvent on the photosensitive layer, followed by drying.

The coating solvent may be appropriately selected in view of the binder used, and when a water-soluble polymer is used, distilled water or purified water is preferably used as the solvent.

A coating method of the protective layer is not particularly limited, and known methods, for example, methods described in U.S. Pat. No. 3,458,311 and JP-B-55-49729 can be utilized.

Specifically, in the formation of the protective layer, for example, a blade coating method, an air knife coating method, a gravure coating method, a roll coating method, a spray coating method, a dip coating method or a bar coating method is used.

The coating amount of the protective layer is preferably in a range 0.02 to 3 g/m², more preferably in a range 0.05 to 1 g/m², and most preferably in a range 0.1 to 0.4 g/m², in terms of the coating amount after drying.

### Support

In the present invention, the support used in the lithographic printing plate precursor is not particularly limited and may be a dimensionally stable plate-form hydrophilic support. Examples thereof include paper, paper laminated with a plastic (e.g. polyethylene, polypropylene, polystyrene, etc.), a metal plate (e.g. aluminum, zinc, copper, etc.), a plastic film (e.g. cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, etc.), and paper or plastic film on which the above-mentioned metal is laminated or vapor-deposited. Preferred examples of the support include a polyester film and an aluminum plate. Among them, an aluminum plate is preferable since dimensional stability is good and it is relatively inexpensive.

The aluminum sheet is a pure aluminum sheet, an alloy sheet containing aluminum as a main component and a small amount of a different element, or a thin film of aluminum or an aluminum alloy laminated with a plastic. Examples of the different element contained in the aluminum alloy include silicon, iron, manganese, copper, magnesium, chromium, zinc, bismuth, nickel, and titanium. The content of the different element in the alloy is preferably equal to or less than 10 wt%. In the present invention, a pure aluminum sheet is preferable, but since it is difficult to produce completely pure aluminum because of the refining technique, a trace amount of a different element may be contained. The composition of the aluminum sheet is not specified, and a known generally used material may be utilized as appropriate.

Prior to the aluminum sheet being used, it is preferably subjected to a surface treatment such as a surface roughening treatment or an anodizing treatment. Surface treatment makes it easy to improve the hydrophilicity and ensure that there is good adhesion between a photosensitive layer and the support. Prior to the aluminum sheet being subjected to the surface roughening treatment, it may be subjected as desired to a degreasing treatment using a surfactant, an organic solvent, an aqueous alkaline solution, etc. in order to remove rolling oil on the surface.

The surface roughening treatment for the aluminum sheet surface may be carried out by various types of methods, and examples thereof include a mechanical surface roughening treatment, an electrochemical surface roughening treatment (a surface roughening treatment involving dissolving the surface electrochemically), and a chemical surface roughening treatment (a surface roughening treatment involving selectively dissolving the surface chemically).

As a method for the mechanical surface roughening treatment, a known method such as a ball grinding method, a brush grinding method, a blast grinding method, or a buff grinding method may be used. In rolling of alminium, a transcription method of transcribing uneven shape by a roll having uneven may be used.

As a method for the electrochemical surface roughening treatment, for example, a method in which alternating current or direct current is applied in an electrolyte solution containing an acid such as hydrochloric acid or nitric acid can be cited. It is also possible to employ a method as described in JP-A-54-63902 in which a mixed acid is used.

The aluminum sheet subjected to a surface roughening treatment is subjected as necessary to an alkali etching treatment using an aqueous solution of potassium hydroxide, sodium hydroxide, etc.; furthermore, after neutralization, it may be subjected to an anodizing treatment as desired in order to improve the abrasion resistance.

As an electrolyte that may be used for the anodizing treatment of the aluminum sheet, various types of electrolytes that form a porous oxide film may be used. Sulfuric acid, hydrochloric acid, oxalic acid, phosphoric acid, chromic acid, or a mixed acid thereof may be preferably used. Among them, sulfuric acid, oxalic acid, and phosphoric acid are more preferable, and phosphoric acid is yet more preferable. The concentration of these electrolytes may be determined as appropriate according to the type of electrolyte.

Conditions for the anodizing treatment depend on the type of electrolyte used and cannot be specified, but in general the electrolyte solution concentration is 1 to 80 wt%, the solution temperature is 5°C to 70°C, the current density is 5 to 60 A/dm², the voltage is 1 to 100 V, and the electrolysis time is 10 sec. to 5 min. The amount of anodized film formed is preferably 1.0 to 5.0 g/m², and more preferably 1.5 to 4.0 g/m². It is preferable for it to be in this range since good printing durability and good scratch resistance of a non-image area of a lithographic printing plate can be obtained.

As the support that can be used in the present invention, a substrate that has been subjected to the above-mentioned surface treatment and has an anodized film may be used as it is, but in order to further improve the adhesion to the upper layer, and the hydrophilicity, the contamination resistance, insulation ability, etc., the substrate may appropriately be subjected as necessary to a treatment for enlarging micropores of the anodized film, a sealing treatment, or a surface hydrophilization treatment involving immersion in an aqueous solution containing a hydrophilic compound, which are described in JP-A-2001-253181 or JP-A-2001-322365. These enlarging and sealing treatments are not limited to those described therein, and any conventionally known methods may be employed.

The sealing treatment may be vapor sealing, a treatment with an aqueous solution containing an inorganic fluorine compound such as a single treatment with fluorozirconic acid or a treatment with sodium fluoride, vapor sealing with added lithium chloride, or a sealing treatment with hot water.

The sealing treatment that can be used in the present invention is not particularly limited, and a conventionally known method may be used. Among these, the sealing treatment with an aqueous solution containing an inorganic fluorine compound, the sealing treatment with vapor, and the sealing treatment with hot water are preferable. Each thereof is explained below.

### <1> Sealing treatment with aqueous solution containing inorganic fluorine compound

In the sealing treatment with an aqueous solution containing an inorganic fluorine compound, a metal fluoride can suitably be used as the inorganic fluorine compound.

Specific examples thereof include sodium fluoride, potassium fluoride, calcium fluoride, magnesium fluoride, sodium fluorozirconate, potassium fluorozirconate, sodium fluorotitanate, potassium fluorotitanate, ammonium fluorozirconate, ammonium fluorotitanate, potassium fluorotitanate, fluorozirconic acid, fluorotitanic acid, hexafluorosilicic acid, nickel fluoride, iron fluoride, fluorophosphoric acid, and ammonium fluorophosphate. Among them, sodium fluorozirconate, sodium fluorotitanate, fluorozirconic acid, and fluorotitanic acid are preferable.

The concentration of the inorganic fluorine compound in the aqueous solution is preferably at least 0.01 wt % from the viewpoint of sealing of micropores on an anodized coating being carried out sufficiently, and more preferably at least 0.05 wt %, and it is preferably no greater than 1 wt % from the viewpoint of contamination resistance, and more preferably no greater than 0.5 wt %.

The aqueous solution containing an inorganic fluorine compound preferably further contains a phosphate compound. It is preferable for a phosphate compound to be contained since the hydrophilicity of the surface of the anodized coating improves and the machine developability and the contamination resistance can be improved.

Preferred examples of the phosphate compound include phosphates of a metal such as an alkali metal or an alkaline earth metal.

Specific examples thereof include zinc phosphate, aluminum phosphate, ammonium phosphate, ammonium phosphate dibasic, ammonium dihydrogen phosphate, potassium dihydrogen phosphate, potassium phosphate dibasic, calcium phosphate, ammonium sodium hydrogen phosphate, magnesium hydrogen phosphate, magnesium phosphate, ferrous phosphate, ferric phosphate, sodium dihydrogen phosphate, sodium phosphate, sodium phosphate dibasic, lead phosphate, calcium dihydrogen phosphate, lithium phosphate, phosphotungstic acid, ammonium phosphotungstate, sodium phosphotungstate, ammonium phosphomolybdate, sodium phosphomolybdate, sodium phosphite, sodium tripolyphosphate, and sodium pyrophosphate. Among these, sodium dihydrogen phosphate, sodium phosphate dibasic, potassium dihydrogen phosphate, and potassium phosphate dibasic are preferable.

The combination of the inorganic fluorine compound and the phosphate compound is not particularly limited, but the aqueous solution preferably comprises at least sodium fluorozirconate as the inorganic fluorine compound and at least sodium dihydrogen phosphate as the phosphate compound.

The concentration of the phosphate compound in the aqueous solution is preferably at least 0.01 wt % from the viewpoint of improving machine developability and contamination resistance, and more preferably at least 0.1 wt %, and it is preferably no greater than 20 wt % from the viewpoint of solubility, and more preferably no greater than 5 wt %.

The proportion of each compound in the aqueous solution is not particularly limited, but the ratio by weight of the inorganic fluorine compound and the phosphate compound is preferably 1/200 to 10/1, and more preferably 1/30 to 2/1.

Furthermore, the temperature of the aqueous solution is preferably at least 20°C, and more preferably at least 40°C, and it is preferably no higher than 100°C, and more preferably no higher than 80°C.

Moreover, the pH of the aqueous solution is preferably at least 1, and more preferably at least 2, and it is preferably no greater than 11, and more preferably no greater than 5.

A method for the sealing treatment with the aqueous solution containing an inorganic fluorine compound is not particularly limited and, for example, an immersion method and a spray method may be used. They may be employed once or a plurality of times, or in a combination of two or more types.

Among these, the immersion method is preferable. When the treatment is carried out by the immersion method, the treatment time is preferably at least 1 sec., and more preferably at least 3 sec., and it is preferably no greater than 100 sec., and more preferably no greater than 20 sec.

### <2> Sealing treatment with steam

With regard to the sealing treatment with steam, for example, a method in which an anodized coating is contacted with steam at high pressure or normal pressure continuously or discontinuously can be cited.

The temperature of the steam is preferably at least 80°C, and more preferably at least 95°C, and it is preferably no greater than 105°C.

The pressure of the steam is preferably in the range of (atmospheric pressure - 50 mmAq) to (atmospheric pressure + 300 mmAq) (1.008 x 10⁵ to 1.043 x 10⁵ Pa).

Furthermore, the time for which the coating is contacted with steam is preferably at least 1 sec., and more preferably at least 3 sec., and it is preferably no greater than 100 sec., and more preferably no greater than 20 sec.

### <3> Sealing treatment with hot water

With regard to the sealing treatment with hot water, for example, a method in which an aluminum plate having an anodized coating formed thereon is immersed in hot water can be cited.

The hot water may contain an inorganic salt (e.g. a phosphate) or an organic salt.

The temperature of the hot water is preferably at least 80°C, and more preferably at least 95°C, and it is preferably no greater than 100°C.

Furthermore, the time for which immersion in hot water is carried out is preferably at least 1 sec., and more preferably at least 3 sec., and it is preferably no greater than 100 sec., and more preferably no greater than 20 sec.

With regard to a hydrophilization treatment that is used in the present invention, there is an alkali metal silicate method, as disclosed in US Pat. Nos. 2,714,066, 3,181,461, 3,280,734, and 3,902,734. In this method, a support is immersed in an aqueous solution of sodium silicate, etc., or subjected to electrolysis. In addition, there is a method in which a support is treated with potassium fluorozirconate, as described in JP-B-36-22063, a method in which a support is treated with polyacrylic acid, as described in US Pat. No. 3,136,636, and a method in which a support is treated with polyvinylphosphonic acid, as described in US Pat. Nos. 3,276,868, 4,153,461, and 4,689,272. Among them, a treatment with alkaline metal silicate and a treatment with polyvinylphosphonic acid are preferable, and a treatment with polyvinylphosphonic acid is more preferable.

When a support having insufficient surface hydrophilicity such as a polyester film is used as a support in the present invention, it is preferable to coat the surface with a hydrophilic layer so as to make the surface hydrophilic.

As the hydrophilic layer, a hydrophilic layer, described in JP-A-2001-199175, formed by coating with a coating liquid containing a colloid of an oxide or hydroxide of at least one element selected from the group consisting of beryllium, magnesium, aluminum, silicon, titanium, boron, germanium, tin, zirconium, iron, vanadium, antimony, and a transition metal, a hydrophilic layer, described in JP-A-2002-79772, having an organic hydrophilic matrix obtained by crosslinking or pseudo-crosslinking an organic hydrophilic polymer, a hydrophilic layer having an inorganic hydrophilic matrix obtained by sol-gel exchange involving dehydration and condensation reactions of a polyalkoxysilane, titanate, zirconate or aluminate, or a hydrophilic layer formed from an organic thin film having a surface containing a metal oxide is preferable. Among them, a hydrophilic layer formed by coating with a coating liquid containing a colloid of an oxide or hydroxide of silicon is preferable.

Furthermore, when a polyester film, etc. is used as a support in the present invention, it is preferable to provide an antistatic layer on a hydrophilic layer side, the opposite side, or both sides of the support. When an antistatic layer is provided between the support and a hydrophilic layer, it also contributes to an improvement in adhesion to the hydrophilic layer. As an antistatic layer, a polymer layer, described in JP-A-2002-79772, in which metal oxide microparticles or a matting agent are dispersed, etc. may be used.

The support preferably has a center line average roughness of 0.10 to 1.2 µm. When in the above-mentioned range, good adhesion to the photosensitive layer, good plate life, and good stain resistance can be obtained.

The thickness of the support is preferably 0.1 to 0.6 mm, and more preferably 0.15 to 0.4 mm.

### Backcoat layer

After applying a surface treatment to the support or forming the undercoat layer (mentioned later) above the support, a backcoat layer may as necessary be provided on the back surface of the support.

As the backcoat layer, there can preferably be cited, for example, a coating layer comprising an organic polymer compound described in JP-A-5-45885, and a coating layer comprising a metal oxide obtained by hydrolysis and polycondensation of an organic metal compound or an inorganic metal compound described in JP-A-6-35174. Among them, use of an alkoxy compound of silicon such as Si(OCH₃)₄, Si(OC₂H₅)₄, Si(OC₃H₇)₄, or Si(OC₄H₉)₄ is preferable since starting materials are inexpensive and readily available.

### Undercoat Layer

In the lithographic printing plate precursor according to the invention, an undercoat layer is provided between the support and the photosensitive layer, as necessary.

The undercoat layer makes removal of the photosensitive layer from the support in the unexposed area easy so that the development property can be improved.

Furthermore, it is advantageous that in the case of infrared laser exposure, since the undercoat layer acts as a heat insulating layer, heat generated upon the exposure does not diffuse into the support and is efficiently utilized so that increase in sensitivity can be achieved.

Preferred specific examples of a compound for the undercoat layer include a silane coupling agent having an addition-polymerizable ethylenically unsaturated bond reactive group described in JP-A-10-282679 and a phosphorus compound having an ethylenically unsaturated bond reactive group described in JP-A-2-304441.

A compound for the undercoat layer preferably has adsorbability to the hydrophilic surface of the support. Whether adsorptivity to the hydrophilic surface of the support is present or not can be judged, for example, by the following method.

A test compound is dissolved in an easily soluble solvent to prepare a coating solution, and the coating solution is coated and dried on a support so as to have the coating amount after drying of 30 mg/m². After thoroughly washing the support coated with the test compound using the easily soluble solvent, the residual amount of the test compound that has not been removed by the washing is measured to calculate the adsorption amount of the test compound to the support. For measuring the residual amount, the residual amount of the test compound may be directly determined, or may be calculated by determining the amount of the test compound dissolved in the washing solution. The determination for the test compound can be performed, for example, by X-ray fluorescence spectrometry measurement, reflection absorption spectrometry measurement or liquid chromatography measurement. The compound having the adsorptivity to support is a compound that remains by 1 mg/m² or more even after conducting the washing treatment described above.

The compound for the undercoat layer gives adsorbability by introducing an adsorbing group for the support (hereinafter, also called simply an "adsorbing group"). The adsorbing group to the surface of the support is a functional group capable of forming a chemical bond (for example, an ionic bond, a hydrogen bond, a coordinate bond or a bond with intermolecular force) with a substance (for example, metal or metal oxide) or a functional group (for example, a hydroxy group) present on the hydrophilic surface of the support. The adsorbing group is preferably an acid group or a cationic group.

The acid group preferably has an acid dissociation constant (pKa) of 7 or less. Examples of the acid group include a phenolic hydroxy group, a carboxyl group, -SO₃H, -OSO₃H, -PO₃H₂, -OPO₃H₂, -CONHSO₂-, -SO₂NHSO₂- and -COCH₂COCH₃. Among them, -OPO₃H₂ and -PO₃H₂ are particularly preferred. The acid group may be the form of a metal salt.

The cationic group is preferably an onium group. Examples of the onium group include an ammonium group, a phosphonium group, an arsonium group, a stibonium group, an oxonium group, a sulfonium group, a selenonium group, a stannonium group and iodonium group. Among them, the ammonium group, phosphonium group and sulfonium group are preferred, the ammonium group and phosphonium group are more preferred, and the ammonium group is most preferred.

Preferred examples of the monomer having the adsorbing group which is used in the synthesis of the polymer resin suitable for the compound for undercoat layer include a compound represented by the following formula (U1) or (U2):

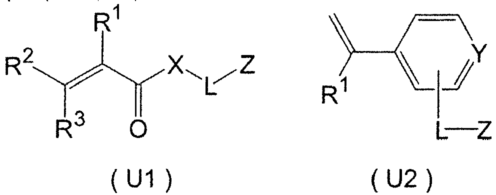

In formulae (U1) and (U2), R¹, R² and R³ independently represents a hydrogen atom, halogen atom or an alkyl group having 1 to 6 carbons.

R¹, R² and R³ independently represents preferably a hydrogen atom or an alkyl group having 1 to 6 carbons, more preferably a hydrogen atom or an alkyl group having 1 to 3 carbons, most preferably a hydrogen atom or a methyl group. R² and R³ are particularly preferably a hydrogen atom.

Z represents a functional group adsorbing to the hydrophilic surface of the support. With respect to the adsorbing functional group, the above description on the adsorbing group can be referred to.

L represents a single bond or a divalent connecting group. L is preferably a divalent aliphatic group (for example, an alkylene group, a substituted alkylene group, an alkenylene group, a substituted alkenylene group, an alkynylene group or a substituted alkynylene group), a divalent aromatic group (for example, an arylene group or a substituted alylene group), a divalent heterocyclic group or a combination of each of the groups described above with an oxygen atom (-O-), a sulfur atom (-S-), an imino group (-NH-), a substituted imino group (-NR-, where R represents an aliphatic group, an aromatic group or a heterocyclic group) or a carbonyl group (-CO-).

The divalent aliphatic group may form a cyclic structure or a branched structure. The number of carbon atoms of the divalent aliphatic group is preferably 1 to 20, more preferably 1 to 15, and most preferably from 1 to 10. The divalent aliphatic group is preferably a saturated aliphatic group rather than an unsaturated aliphatic group. The divalent aliphatic group may have a substituent. Examples of the substituent include a halogen atom, a hydroxy group, an aromatic group and a heterocyclic group.

The number of carbon atoms of the divalent aromatic group is preferably 6 to 20, more preferably 6 to 15, and most preferably 6 to 10. The divalent aromatic group may have a substituent. Examples of the substituent include a halogen atom, a hydroxy group, an aliphatic group, an aromatic group and a heterocyclic group.

The divalent heterocyclic group preferably has a 5-membered or 6-membered ring as the hetero ring. Other heterocyclic ring, an aliphatic ring or an aromatic ring may be condensed to the heterocyclic ring. The divalent heterocyclic group may have a substituent. Examples of the substituent include a halogen atom, a hydroxy group, an oxo group (-O), a thioxo group (-S), an imino group (-NH), a substituted imino group (-N-R, where R represents an aliphatic group, an aromatic group or a heterocyclic group), an aliphatic group, an aromatic group and a heterocyclic group.

L is preferably a divalent connecting group containing a plurality of polyoxyalkylene structures. The polyoxyalkylene structure is more preferably a polyoxyethylene structure. In other words, L preferably contains -(OCH₂CH₂)ₙ- (n is an integer of 2 or more).

In formula (U1), X represents an oxygen atom (-O-) or imino group (-NH-). X is preferably an oxygen atom.

In formula (U2), Y represents a carbon atom or a nitrogen atom. When Y is a nitrogen atom and L is connected to Y to form a quaternary pyridinium group, Z is not required and may be a hydrogen atom because the quaternary pyridinium group itself exhibits the adsorptivity.

Representative examples of the compound represented by formula (U1) or (U2) are set forth below. In compounds below, Me denotes methyl group, and Et denotes ethyl group.

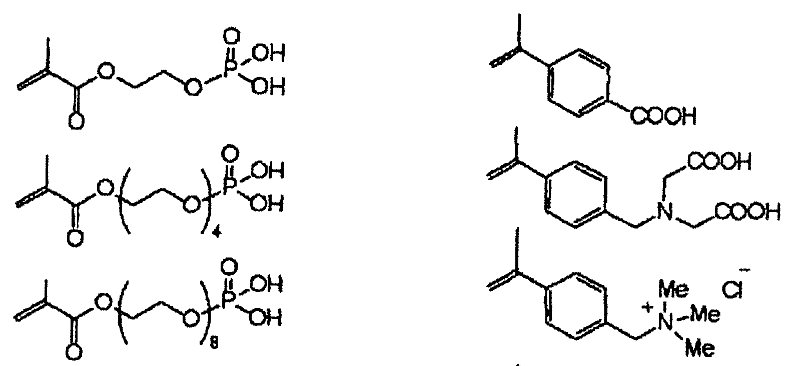

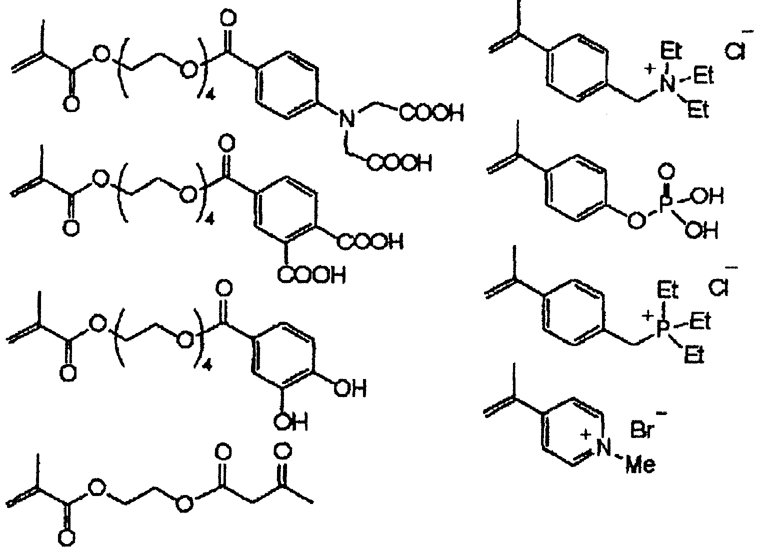

The compound for undercoat layer preferably has a hydrophilic group.

Preferred examples of the hydrophilic group include a hydroxy group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfo group and a phosphoric acid group. Among them, a sulfo group, which has highly hydrophilic property, is preferable.

Specific examples of the monomer having a sulfo group include a sodium salt or amine salt of methallyloxybenzenesulfonic acid, allyloxybenzenesulfonic acid, allylsulfonic acid, vinylsulfonic acid, p-styrenesulfonic acid, methallylsulfonic acid, acrylamido-tert-butylsulfonic acid, 2-acrylamido-2-methylpropanesulfonic acid or (3-acryloyloxypropyl)buthylsulfonic acid. Among them, from the standpoint of the hydrophilic property and handling property in the synthesis thereof sodium salt of 2-acrylamido-2-methylpropanesulfonic acid is preferable.

The compound for undercoat layer preferably has a crosslinkable group. The crosslinkable group acts to improve the adhesion property to the image area. In order to impart the crosslinking property to the compound for undercoat layer, introduction of a crosslinkable functional group such as an ethylenically unsaturated bond, etc. into the side chain of the polymer or introduction by formation of a salt structure between a polar substituent of a resin and a compound containing a substituent having a counter charge to the polar substituent and an ethylenically unsaturated bond is used.

Examples of the polymer having the ethylenically unsaturated bond in the side chain thereof include a polymer of an ester or amide of acrylic acid or methacrylic acid, wherein the ester or amide residue (R in -COOR or -CONHR) has the ethylenically unsaturated bond.

Examples of the residue (R described above) having an ethylenically unsaturated bond include -CH=CH₂, -C(CH₃)=CH₂, -(CH₂)ₙCR¹=CR²R³, -(CH₂O)ₙCH₂CR¹=CR²R³, -(CH₂CH₂O)ₙCH₂CR¹=CR²R³, -(CH₂)ₙNH-CO-O-CH₂CR¹=CR²R³, -(CH₂)ₙ-O-CO-CR¹=CR²R³ and -(CH₂CH₂O)₂-X (In formulae, R¹ to R³ each represents a hydrogen atom, a halogen atom or an alkyl group having from 1 to 20 carbon atoms, an aryl group, alkoxy group or arytoxy group, or R¹ and R² or R¹ and R³ may be combined with each other to form a ring. n represents an integer of 1 to 10. X represents a dicyclopentadienyl residue).

Specific examples of the ester residue include -CH=CH₂, -C(CH₃)=CH₂, -CH₂CH=CH₂ (described in JP-B-7-21633), -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂-NHCOO-CH₂CH=CH₂, and -CH₂CH₂O-X (In formula, X represents a dicyclopentadienyl residue).

Specific examples of the amide residue include -CH=CH₂, -C(CH₃)=CH₂, -CH₂CH=CH₂, -CH₂CH₂O-Y (In formula, Y represents a cyclohexene residue) and -CH₂CH₂OCO-CH=CH₂.

As a monomer having a crosslinkable group for the polymer for undercoat layer, an ester or amide of acrylic acid or methacrylic acid having the crosslinkable group described above is preferably used.

The content of the crosslinkable group in the compound for undercoat layer (content of the radical polymerizable unsaturated double bond determined by iodine titration) is preferably 0.1 to 10.0 mmol, more preferably 1.0 to 7.0 mmol, and most preferably 2.0 to 5.5 mmol, relative to 1 g of the compound. In the range described above, preferable compatibility between the sensitivity and stain resistance and good preservation stability can be achieved.

Preferred examples of the compound for the undercoat layer include a compound having a adsorbing group for the support and a crosslinkable group can be cited. Such a compound includes a compound obtained by polymerizing at least a monomer having an adsorbing group and a monomer having a crosslinkable group.

The weight average molecular weight of the polymer for undercoat layer is preferably 5,000 or more, and more preferably 10,000 to 300,000. The number average molecular weight of the polymer is preferably 1,000 or more, and more preferably 2,000 to 250,000. The polydispersity (weight average molecular weight/number average molecular weight) thereof is preferably from 1.1 to 10.

The polymer for the undercoat layer may be any of a random polymer, a block polymer, a graft polymer and the like, and is preferably a random polymer.

The compound for the undercoat layer may be used singly or in a combination with two or more thereof.

A coating solution for undercoat layer is obtained by dissolving the compound for the undercoat layer in an organic solvent (for example, methanol, ethanol, acetone or methyl ethyl ketone) and/or water.

The coating solution for the undercoat layer may contain an infrared absorbing agent.

In order to coat the coating solution for the undercoat layer on the support, various methods can be used. Examples of the method include bar coater coating, spin coating, spray coating, curtain coating, dip coating, air knife coating, blade coating and roll coating.

The coating amount (solid content) of the undercoat layer is preferably 0.1 to 100 mg/m², and more preferably 1 to 30 mg/m².

A lithographic printing plate obtained by the process for making a lithographic printing plate of the present invention is, for example, mounted on a plate cylinder of a printer and suitably used for printing a large number of sheets of printed material while supplying dampening water and a printing ink.

### EXAMPLES

The present invention is specifically explained below by reference to Examples, but the present invention should not be construed as being limited to these Examples. 'Parts' and '%' are on a weight basis unless otherwise specified. Furthermore, the figures on the bottom right of the parentheses showing the chemical structure of polymers denotes molar ratio unless otherwise specified.

### <Synthesis of polymer particles and explanation of terms for chemical substances used in photosensitive layer coating solution>

PEGMA: 50 wt% aqueous solution of poly(ethylene glycol) methyl ether methacrylate with an average number-average molecular weight (Mn) of about 2,080 available from Sigma-Aldrich (St. Louis, Missouri),
Hybridur 580: urethane-acrylic hybrid polymer dispersion (40%) available from Air Products and Chemicals
Hybridur 870: urethane-acrylic hybrid polymer dispersion (40%) available from Air Products and Chemicals
SR399: dipentaerythritol pentaacrylate available from Sartomer Company Inc. Japan
NK-Ester A-DPH: dipentaerythritol hexaacrylate available from Nakamura Gosei Kagaku Kogyo Co., Ltd.
CD9053: trifunctional organic acid ester compound available from Sartomer Company Inc. Japan
Fluor N2900: surfactant available from Cytnix
Masurf FS-1520: alkyl fluoride group-containing amphoteric surfactant available from Mason Chemical

### <Synthesis of binder polymer 1>

A 3-necked flask equipped with a magnetic stirrer, a water bath, and an N₂ inlet was charged with AIBN (2,2'-azobis(isobutyronitrile), Vazo-64, obtained from Du Pont, 1.6 parts), methyl methacrylate (20 parts), acrylonitrile (24 parts), *N*-vinylcarbazole (20 parts, obtained from Polymer Dajac), methacrylic acid (16 parts), and dimethyl acetamide (DMAC, 320 parts). The reaction mixture was heated to 60°C and stirred overnight (16 hours) under the protection of N₂. This gave a 20% solution of binder polymer 1 in DMAC.

The composition of binder polymer 1 was methyl methacrylate/acrylonitrile/*N*-vinylcarbazole/methacrylic acid = 21/48/11/20 (molar ratio), and when the molecular weight was measured in tetrahydrofuran by gel permeation chromatography, Mw (weight-average molecular weight) was about 52,000.

### <Synthesis of binder polymer 2>

200 parts of the DMAC solution of binder polymer 1 synthesized above was weighed, and potassium hydroxide (2.6 parts) in water (20 parts) was slowly added thereto, thus forming a viscous liquid. After the mixture was stirred for 10 min., allyl bromide (6.7 parts) was added, and the mixture was stirred at 55°C for 3 hours. 36% conc. hydrochloric acid (6 parts) in DMAC (20 parts) was added to the flask, and the reaction mixture was stirred for a further 3 hours. The reaction mixture thus formed was then slowly added dropwise to a mixture of 12,000 parts of ice water and 20 parts of conc. hydrochloric acid while stirring. A precipitate thus formed was filtered, washed with 1,608 parts of propanol, and subsequently washed with 2,000 parts of water. A white powder was obtained after filtration. The powder was dried at room temperature (10°C to 25°C) overnight and then at 50°C for 3 hours, thus giving about 40 parts of binder polymer 2 as a solid substance.

The composition of binder polymer 2 was methyl methacrylate/acrylonitrile/*N*-vinylcarbazole/allyl methacrylate = 21/48/11/20 (molar ratio), and Mw measured as above was about 57,000.

### <Synthesis of binder polymer 3>

A 20% solution of binder polymer 3 in DMAC was obtained in the same manner as for binder polymer 1 except that acrylonitrile was not used, the amount of methyl methacrylate was changed to 65 parts, and the amount of DMAC was changed to 400 parts.

The composition of binder polymer 3 was methyl methacrylate/*N-*vinylcarbazole/methacrylic acid = 69/11/20 (molar ratio), and Mw measured as above was about 55,000.

### <Synthesis of binder polymer 4>

A 20% solution of binder polymer 4 in DMAC was obtained in the same manner as for binder polymer 1 except that *N*-vinylcarbazole was not used, the amount of methyl methacrylate was changed to 30 parts, and the amount of DMAC was changed to 280 parts.

The composition of binder polymer 4 was methyl methacrylate/acrylonitrile/methacrylic acid = 32/48/20 (molar ratio), and Mw measured as above was about 50,000.

### <Synthesis of binder polymer 5>

A four-necked ground glass flask equipped with a heating mantle, a temperature controller, a mechanical stirrer, a reflux condenser, a dropping funnel, and a nitrogen supply inlet was charged with DMAC (100.7 parts) and PEGMA (50% aqueous solution, 20 parts), and the reaction mixture was heated to 80°C under a flow of nitrogen. A mixture of DMAC (125 parts), vinylcarbazole (25 parts), acrylonitrile (35 parts), styrene (20 parts), methacrylic acid (10 parts), and AIBN (0.5 parts, Vazo-64) was added to the above at 80°C over 2 hours, and a reaction was subsequently carried out for 15 hours while adding 1.25 parts of Vazo-64. From quantitative measurement of the nonvolatile content, the monomer reaction conversion was at least 99%. A polymer solution thus obtained was reprecipitated using 6,000 parts of water/ice (3:1) that was being stirred at high speed, and a polymer powder thus precipitated was filtered and then dried at room temperature for 24 hours and at 43°C for 2 days, thus giving binder polymer 5 as a powder. The yield was 95%, and the acid value was 69 mg KOH/g (theoretical value: 65).

The composition of binder polymer 5 was PEGMA/acrylonitrile/vinylcarbazole/styrene/methacrylic acid = 0.5/60/12/17/11 (molar ratio), and Mw measured as above was about 100,000.

### <Synthesis of urethane-acrylic hybrid polymer 1>

A reactor purged with nitrogen was charged with Formrez 55-56 (poly(neopentyl adipate), which is a polyol available from Witco Chemical, Mw about 2,000) (100 parts). Added to this were methylene dicyclohexyl diisocyanate (90.6 parts) and as a tin catalyst 10% DABCO T-12 (dibutyltin dilaurate available from Air Products and Chemicals) (0.25 parts). This mixture was stirred at 92°C for 3 hours. While stirring constantly, dimethylolpropionic acid (14.8 parts) was added, and subsequently 1-methyl-2-pyrrolidinone (54.6 parts) was added. The mixture was further maintained at 92°C for 5 hours.

The prepolymer was cooled to 75°C, and butyl methacrylate (141.6 parts) and 1,6-hexanediol diacrylate (0.88 parts) were added. After the mixture was stirred for 15 min., when the free NCO% was measured, the NCO content was substantially 0%. Subsequently, the mixture was cooled to 25°C, triethylamine (10.66 parts) was added, and a reaction was carried out for 1 hour. After neutralization, the prepolymer/monomer mixture was dispersed in deionized water (489.97 parts). In order to carry out chain extension, ethylenediamine (8.97 parts) was dissolved in deionized water (16.67 parts) and added to the reactor, and a reaction was carried out for 2 hours. Subsequently, Vazo-64 free radical initiator (AIBN available from Du Pont) (0.88 parts) dissolved in 1-methyl-2-pyrrolidinone (6.93 parts) was added, and a mixture of butyl methacrylate (31.44 parts) and 2-hydroxyethyl methacrylate (29.12 parts) was also added. 5 min. later the dispersion was heated to 75°C and maintained there for 2 hours.

After polymerization was completed, the dispersion was filtered using a filter, thus giving urethane-acrylic hybrid polymer 1.

The Mw of the urethane-acrylic hybrid polymer 1 thus obtained was estimated to be about 150,000. When the particle size thereof was measured using an LA-910 laser diffraction/scattering type particle size distribution analyzer manufactured by Horiba, Ltd., the ma (average diameter of area distribution) was 360 nm and the mv (average diameter of volume distribution; center of gravity of distribution) was 440 nm.

### <Synthesis of urethane-acrylic hybrid polymer 2>

A reactor purged with nitrogen was charged with Formrez 55-56 (poly(neopentyl adipate), which is a polyol available from Witco Chemical, Mw about 2,000) (200.1 parts). Added to this were methylene dicyclohexyl diisocyanate (105.3 parts) and as a tin catalyst 10% DABCO T-12 (dibutyltin dilaurate available from Air Products and Chemicals) (0.52 parts). This mixture was stirred at 92°C for 3 hours. While stirring constantly, dimethylolpropionic acid (26.8 parts) was added, and subsequently 1-methyl-2-pyrrolidinone (110 parts) was added. The mixture was further maintained at 92°C for 5 hours.

The prepolymer was cooled to 75°C, and methyl methacrylate (199.7 parts) was added. After the mixture was stirred for 15 min., when the free NCO% was measured, the NCO content was about 1 to 1.5%. Subsequently, the mixture was cooled to 25°C, triethylamine (19.5 parts) was added, and a reaction was carried out for 1 hour. After neutralization, methyl methacrylate (64.2 parts) and 2-hydroxyethyl methacrylate (64.2 parts) were added, and the mixture was stirred for 5 min.. Then, the prepolymer was dispersed in deionized water (800.2 parts). In order to stop chain extension, diethanol amine (18.6 parts) was dissolved in deionized water (32.5 parts) and added to the reactor, and a reaction was carried out for 2 hours. Subsequently, Vazo-67 free radical initiator (2,2'-azobis(2-methylbutyronitrile) available from Du Pont) (3.94 parts) and a thiol chain transfer agent 1-dodecylthiol (20.2 parts) dissolved in 1-methyl-2-pyrrolidinone (13.52 parts) were added. 5 min. later the dispersion was heated to 75°C and maintained there for 2 hours, thus giving urethane-acrylic hybrid polymer 2.

The Mw of the urethane-acrylic hybrid polymer 2 thus obtained was estimated to be about 30,000. The particle size measured by the method above was ma = 230 nm and mv = 350 nm.

### <Synthesis of urethane-acrylic hybrid polymer 3>

Urethane-acrylic hybrid polymer 3 was synthesized in the same manner as for urethane-acrylic hybrid polymer 1 except that the diisocyanate compound used was changed from methylenedicyclohexyl diisocyanate to diphenylmethane diisocyanate (MDI).

The Mw of the urethane-acrylic hybrid polymer 3 thus obtained was estimated to be about 100,000. The particle size measured by the method above was ma = 300 nm and mv = 380 nm.

### <Synthesis of urethane-acrylic hybrid polymer 4>

Urethane-acrylic hybrid polymer 4 was synthesized in the same manner as for urethane-acrylic hybrid polymer 1 except that the diisocyanate compound used was changed from methylenedicyclohexyl diisocyanate to m-tolylene diisocyanate (TDI).

The Mw of the urethane-acrylic hybrid polymer 4 thus obtained was estimated to be about 130,000. The particle size measured by the method above was ma = 320 nm and mv = 400 nm.

### <Synthesis of urethane-acrylic hybrid polymer 5>

Urethane-acrylic hybrid polymer 5 was synthesized in the same manner as for urethane-acrylic hybrid polymer 1 except that the diisocyanate compound used was changed from methylenedicyclohexyl diisocyanate to isophorone diisocyanate (IpDI).

The Mw of the urethane-acrylic hybrid polymer 5 thus obtained was estimated to be about 150,000. The particle size measured by the method above was ma = 340 nm and mv = 450 nm.

### <Synthesis of urethane-acrylic hybrid polymer 6>

Urethane-acrylic hybrid polymer 6 was synthesized in the same manner as for urethane-acrylic hybrid polymer 1 except that the diisocyanate compound used was changed from methylenedicyclohexyl diisocyanate to hexamethylene diisocyanate (HMDI).

The Mw of the urethane-acrylic hybrid polymer 6 thus obtained was estimated to be about 180,000. The particle size measured by the method above was ma = 420 nm and mv = 520 nm.

### (Examples 1 to 124 and Comparative Examples 1 to 30)

### <Preparation of lithographic printing plate precursor (1) >

### (1) Preparation of support (1)

A 0.3 mm thick aluminum plate (material: JIS A 1050) was subjected to a degreasing treatment with a 10 wt % aqueous solution of sodium aluminate at 50°C for 30 sec in order to remove rolling oil on the surface thereof. Thereafter, the aluminum plate surface was grained using three nylon brushes implanted with bundled bristles having a diameter of 0.3 mm and an aqueous suspension (specific gravity: 1.1 g/cm³) of pumice having a median diameter of 25 µm and then washed well with water. The plate was etched by immersing it in a 25 wt % aqueous solution of sodium hydroxide at 45°C for 9 sec and, after washing with water, was immersed in a 20 wt % aqueous solution of nitric acid at 60°C for 20 sec, followed by washing with water. The amount of etching of the grained surface was about 3 g/m².

Subsequently, the aluminum plate was subjected to a consecutive electrochemical surface roughening treatment using an AC voltage of 60 Hz. An electrolytic liquid used here was a 1 wt % aqueous solution of nitric acid (containing 0.5 wt % of aluminum ion) at a liquid temperature of 50°C. The electrochemical surface roughening treatment was carried out using as an AC power source waveform a trapezoidal rectangular wave alternating current having a duty ratio of 1:1 and a time TP from zero to peak current value of 0.8 msec, with a carbon electrode as the counter electrode. Ferrite was used as an auxiliary anode. The current density was 30 A/dm² as a peak current value, and 5% of the current flowing from the power source was diverted to the auxiliary anode. The quantity of electricity in the nitric acid electrolysis was 175 C/dm² when the aluminum plate was the anode. Following this, washing with water was carried out by means of a spray.

Subsequently, the aluminum plate was subjected to an electrochemical surface roughening treatment in the same manner as in the nitric acid electrolysis above using, as an electrolytic liquid, a 0.5 wt % aqueous solution of hydrochloric acid (containing 0.5 wt % of aluminum ion) at a liquid temperature of 50°C under conditions of a quantity of electricity of 50 C/dm² when the aluminum plate was the anode, and was then washed with water by spraying. The plate was then treated in a 15 wt % aqueous solution of sulfuric acid (containing 0.5 wt % of aluminum ion) as an electrolytic liquid at a current density of 15 A/dm² to provide a direct current anodized film of 2.5 g/m², was then washed with water, and dried.

Furthermore, steam at 100°C was sprayed onto the anodized film at a pressure of 1.033 × 10⁵ Pa for 8 seconds, thus carrying out a sealing treatment.

Subsequently, in order to guarantee hydrophilicity for a non-image area, a silicate treatment was carried out using a 2.5 wt% aqueous solution of sodium silicate No. 3 at 75°C for 6 sec. The amount of Si attached was 10 mg/m². Subsequently, washing with water was carried out, thus giving support (1). The center line average roughness (Ra) of this substrate was measured using a stylus having a diameter of 2 µm and found to be 0.51 µm.

### (2) Formation of undercoat layer

A support having an undercoat layer was then produced by coating support (1) above with coating solution (1) for undercoat layer below at a dry coat weight of 20 mg/m².
Coating solution (1) for undercoat layer
Compound (1) for undercoat layer having structure below: 0.18 parts
Methanol: 55.24 parts
Water : 6.15 parts

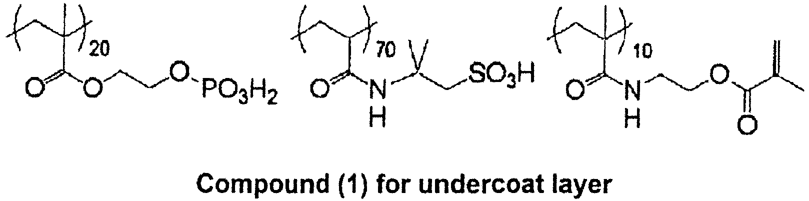

### (3) Formation of photosensitive layer

A photosensitive layer was formed at a dry coat weight of 1.0 g/m² by bar-coating the undercoat layer with photosensitive layer coating solution (1) having the composition below and drying in an oven at 100°C for 60 sec.

Photosensitive layer coating solution (1) was prepared by mixing and stirring 10.467 parts of photosensitive liquid (1) below and 1.00 parts of an aqueous dispersion of the urethane-acrylic hybrid polymer used in the present invention and described in Table 4 immediately before coating.
Photosensitive liquid (1)
Binder polymer described in Table 4: 0.240 parts as solids content
Infrared absorbing agent (1) below: 0.030 parts
Polymerization initiator (A) below: 0.162 parts
Polymerizable compound (tris(acryloyloxyethyl) isocyanurate) (NK ester A-
9300, Shin-Nakamura Chemical Co., Ltd.): 0.192 parts
Dipentaerythritol pentaacrylate: 0.062 parts
Pionin A-20 (Takemoto Oil & Fat Co., Ltd.): 0.055 parts
Benzyldimethyloctylammonium PF₆ salt: 0.018 parts
Fluorine-based surfactant (1) below: 0.008 parts
Methyl ethyl ketone: 1.091 parts
1-Methoxy-2-propanol: 8.609 parts

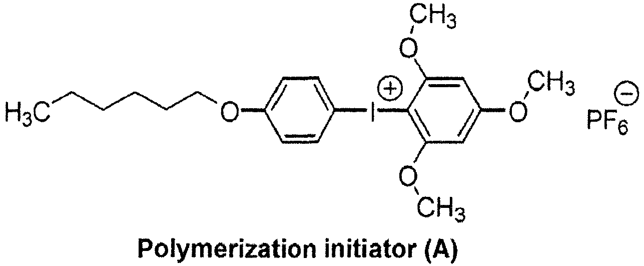

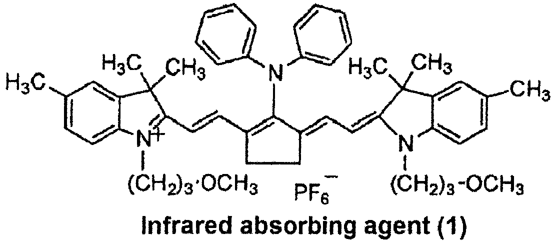

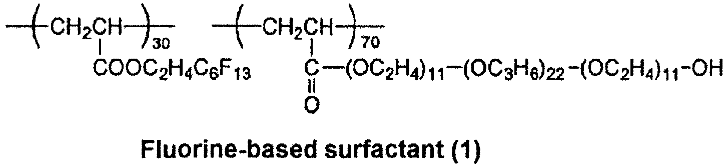

### (3) Formation of protective layer

Lithographic printing plate precursor (1) was obtained by forming a protective layer at a dry coat weight of 0.15 g/m² by bar-coating the photosensitive layer with protective layer coating solution (1) having the composition below and then drying in an oven at 120°C for 60 sec.
Coating solution (1) for protective layer
Inorganic layered compound dispersion (1) below: 1.5 parts
Polyvinyl alcohol (CKS50, The Nippon Synthetic Chemical Industry Co., Ltd., sulfonic acid-modified, degree of saponification at least 99 mole%, degree of polymerization 300) 6 wt% aqueous solution: 0.55 parts
Polyvinyl alcohol (PVA-405, Kuraray Co., Ltd., degree of saponification 81.5
mole%, degree of polymerization 500) 6 wt% aqueous solution: 0.03 parts
Surfactant manufactured by Nihon Emulsion Co., Ltd.
(Emalex 710) 1 wt% aqueous solution: 0.86 parts
Ion-exchanged water: 6.0 parts

### -Preparation of inorganic layered compound dispersion (1)-

6.4 parts of a Somasif ME-100 synthetic mica (Co-op Chemical Co., Ltd.) was added to 193.6 parts of ion-exchanged water, and dispersion was carried out using a homogenizer until the average particle size (laser scattering method) became 3 µm. The aspect ratio of dispersed particles thus obtained was at least 100.

### <Preparation of lithographic printing plate precursor (2)>

### (1) Preparation of support (2)

An aluminum plate that had been subjected to the electrochemical surface roughening treatment in the preparation of support (1) was provided with 1.5 g/m² of a direct current anodized film using 2.5 M phosphoric acid as an electrolyte at a voltage of 50 V and a maximum electric current density of 2 A/dm², then washed with water, and dried.

Subsequently, steam at 100°C at a pressure of 1.033 × 10⁵ Pa was sprayed onto the above anodized film for 15 sec., thus carrying out a sealing treatment.

Subsequently, it was immersed in a 0.4 wt% polyvinyl phosphonic acid aqueous solution at a liquid temperature of 50°C for 10 sec., washed with water, and dried, thus giving support (2).

### (2) Formation of undercoat layer, photosensitive layer, and protective layer

Lithographic printing plate precursor (2) was obtained in the same manner as for lithographic printing plate precursor (1) except that support (2) above was used, no undercoat layer was provided, a photosensitive layer with a dry coat weight of 1.2 g/m² was provided by bar-coating photosensitive layer coating solution (2) below instead of photosensitive layer coating solution (1) and drying in an oven at 82°C for 90 sec., and a protective layer with a dry coat weight of 0.4 g/m² was provided by bar-coating protective layer coating solution (2) below instead of protective layer coating solution (1).

### Photosensitive layer coating solution (2)

Binder polymer described in Table 1 or Table 2: 1.75 parts as solids content Urethane-acrylic hybrid polymer described in Table 1 or Table 2: 2.34 parts as solids content
SR399: 2.66 parts
NK-Ester A-DPH: 2.66 parts
CD9053: 0.53 parts
Bis(*t*-butylphenyl)iodonium tetraphenylborate: 0.96 parts
Fluor N2900: 0.11 parts
Pigment 1: 0.73 parts
Infrared absorbing agent (2) below: 0.27 parts
Ion-exchanged water: 13.77 parts
1-Methoxy-2-propanol: 48.18 parts
2-Butyrolactone: 13.77 parts
2-Butanone: 61.94 parts 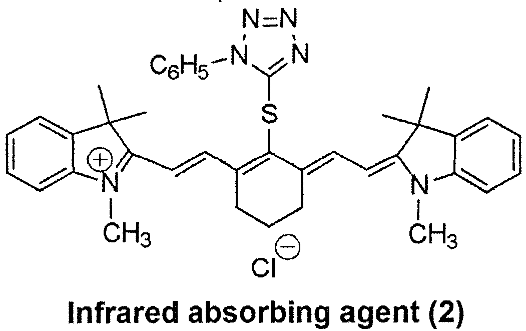 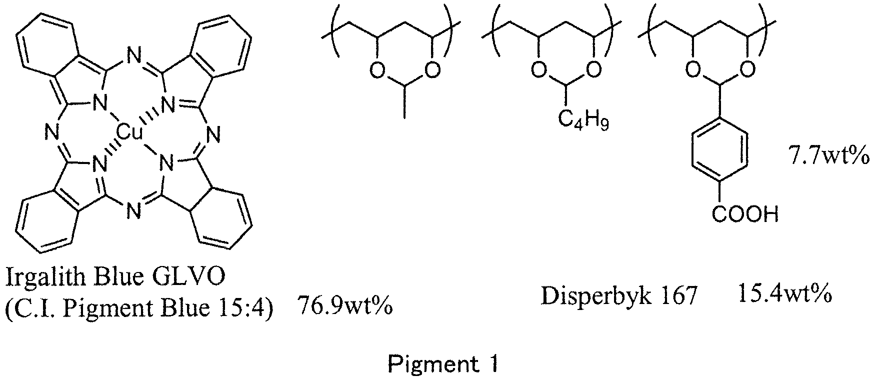
Irgalith Blue GLVO: pigment available from Ciba-Geigy Ltd.
Disperbyk 167: dispersant available from Byk Chemie
Coating solution (2) for protective layer
Polyvinyl alcohol (PVA-405, Kuraray Co., Ltd., degree of saponification 81.5 mole%, degree of polymerization 500) 6 wt% aqueous solution: 66.33 parts Masurf 1520: 0.02 parts
Ion-exchanged water: 8.65 parts

### <Preparation of lithographic printing plate precursor (3)>

### (1) Preparation of support (3)

The treatment with polyacrylic acid in the formation of support (2) was changed to a treatment with poly(vinylphosphonic acid). That is, an aluminum plate that had been subjected to the treatments prior to the treatment with poly(vinylphosphonic acid) in the preparation of support (2) was immersed in a 1.0 wt% aqueous solution of polyacrylic acid at a liquid temperature of 25°C for 8 seconds, washed with water, and dried, thus giving support (3).

### (2) Formation of photosensitive layer

Lithographic printing plate precursor (3) was obtained in the same manner as for lithographic printing plate precursor (1) except that support (3) above was subjected to bar coating, without providing an undercoat layer, by changing photosensitive layer coating solution (1) to photosensitive layer coating solution (3) below, dried in an oven at 90°C for 90 sec. to thus provide a photosensitive layer having a dry coat weight of 1.5 g/m², and subjected to bar coating by changing protective layer coating solution (1) to protective layer coating solution (3) below to thus provide a protective layer having a dry coat weight of 2.1 g/m².
Photosensitive layer coating solution (3)
Binder polymer described in Table 3: 8.50 parts as solids content
Reaction product of 1:2 hexamethylene diisocyanate and hydroxyethyl acrylate: 6.00 parts
Reaction product of 1:2 hexamethylene diisocyanate and pentaerythritol tetraacrylate: 6.00 parts
Polymerization initiator (B) below: 0.70 parts
Infrared absorbing agent (3) below: 0.20 parts
*N*-Phenyliminodiacetic acid: 0.25 parts
Crystal violet: 0.35 parts
Fluor N2900: 0.08 parts
1-Methoxy-2-propanol: 88.32 parts
2-Butyrolactone: 22.08 parts
2-Butanone: 110.40 parts 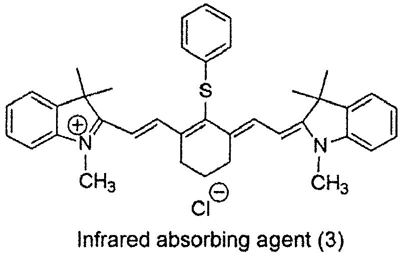 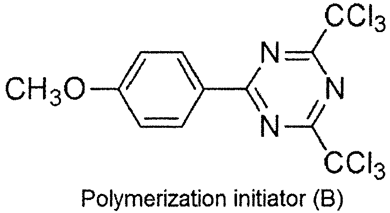
Coating solution (3) for protective layer
6 wt% aqueous solution of polyvinyl alcohol (PVA-105, Kuraray Co., Ltd., degree of saponification at least 98 mole%, degree of polymerization 500): 66.33 parts
1 wt% aqueous solution of surfactant (Emalex 710) manufactured by Nihon
Emulsion Co., Ltd.: 0.86 parts
Ion-exchanged water: 12.60 parts

### <Exposure>

Lithographic printing plate precursors (1) and (2) were exposed using a Luxel PLATESETTER T-6000III, equipped with an infrared semiconductor laser, manufactured by Fujifilm Corporation under conditions of a drum outer face rotational speed of 1,000 rpm, a laser output of 70%, and a resolution of 2,400 dpi.

On the other hand, lithographic printing plate precursor (3) was exposed using a Trendsetter 3244VX, equipped with an infrared semiconductor laser, manufactured by Creo under conditions of an output of 10 W, a drum outer face rotational speed of 150 rpm, and a resolution of 2,400 dpi. Exposure images included a solid image and a fine line image.

### <Processing>

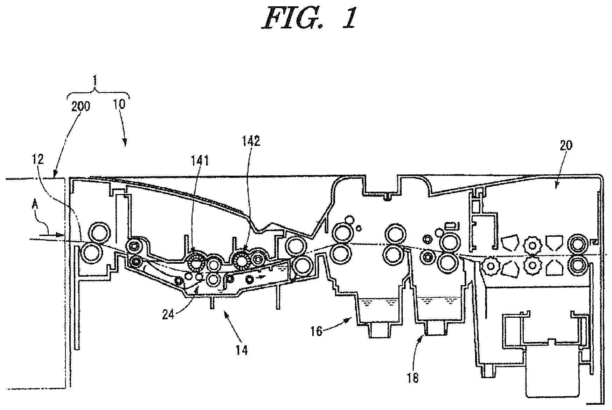

In Examples 1 to 124, excluding Examples 33, 50, 87, and 124, and Comparative Examples 1 to 30, the exposed precursors were subjected to processing using the automatic processing equipment shown in FIG. 1. In FIG. 1, development was carried out in development section 14, washing with water was carried out in water washing section 16, and de-oleophilization was carried out in de-oleophilization treatment section 18. The developers used are shown in Table 1 to Table 4. Water for washing and a de-oleophilization liquid used are described below.

The developer was used by circulating using a pump through a 'TCW-75N-PPS' cartridge filter (mesh size: 75 µm) manufactured by Advantec Toyo Kaisha, Ltd.

### Water for washing used in water washing step

Tap water was charged and then reused by circulating using a pump. Once it had been used for washing, it was reused after passing it through a 'TCW-75N-PPS' cartridge filter (mesh size: 75 µm) manufactured by Advantec Toyo Kaisha, Ltd.

### Gumming liquid in de-oleophilization step

'FN-6' gumming liquid manufactured by Fujifilm Corporation was used by diluting with an equal amount of tap water.

In Examples 33, 50, 87, and 124, the exposed precursors were processed using the automatic processing equipment shown in FIG. 2 and then dried using a dryer. The developers used are shown in Table 1 to Table 4 below.

### <Evaluation>

Odor of the developer, developability in processing (ease of removing non-image area), development sludge due to a component removed by development in the processing section, and fine line reproduction (sensitivity) and printing durability in printing with a lithographic printing plate produced by the processing were evaluated by the procedures below. The evaluation results are shown in Table 5 to Table 8.

### (1) Odor of developer

Sensory evaluation of solvent odor around the automatic processing equipment when carrying out the processing was carried out by 10 panelists, and the average score was ranked in accordance with the criteria below.
A: hardly any or unnoticeable solvent odor, very good.
B: slight solvent odor, but acceptable level.
C: strong solvent odor, unacceptable level in practice.
D: very strong solvent odor, bad.

### (2) Developability

Cyan density (C density) was measured using a Gretag densitometer for a non-image area of a processed lithographic printing plate and each support used in formation of each lithographic printing plate precursor (substrate that had been subjected to a surface treatment but not coated), and the difference (ΔD) in optical density was determined. ΔD in a range that gave good developability was 0 to 0.02, and a value up to 0.04 was an acceptable range. When this value was exceeded, problems such as ink staining were caused during printing due to a photosensitive layer component remaining on the non-image area, and it was a level that was not acceptable in practice.

### (3) Development sludge

A large number of lithographic printing plate precursors were subjected to running processing such that 20 m² of lithographic printing plate precursor per L of the developer was processed as above, the developer within the development bath was then discharged through a drain of the automatic processing equipment, and development sludge deposited on the base of the development bath was examined. Furthermore, the filter cartridge was removed from the circulation system, and development sludge captured on the filter surface was examined. Sensory evaluation of the amount and state of the development sludge was carried out and they were ranked in accordance with the criteria below.
A: Hardly any development sludge was found on either the development bath base or the filter surface, very good.
B: No development sludge was found on the development bath base but slight development sludge was found on the filter surface, it was considered that there would be no effect on washing properties in the development bath or filter lifespan, acceptable level.
C: Development sludge was found on the development bath base and the filter surface, it was considered that there would be an effect on washing properties in the development bath and filter lifespan, unacceptable level.
D: A very large amount of development sludge was found on the development bath base and the filter surface, very poor.

### (4) Sensitivity

As a method for evaluating the sensitivity of the lithographic printing plate precursor, the ability to reproduce an exposed fine line image (test chart in which the thickness of fine lines (fine line image area in non-image area) was changed from 5 µm to 50 µm in 5 µm stages) on the processed lithographic printing plate was evaluated visually on the lithographic printing plate by checking the thickness of fine lines that could be reproduced. That is, the smaller the value, the finer the line that was formed in an image in a good state, suggesting that the sensitivity was high.

### (5) Printing durability

A processed lithographic printing plate was set on a plate cylinder of a LITHRONE 26 printer manufactured by Komori Corporation. Ecolity-2 (Fujifilm Corporation)/tap water = 2/98 (ratio by volume) as dampening water and Values-G (N) black ink (Dainippon Ink and Chemicals, Incorporated) were used, printing was started by supplying the dampening water and the ink by a standard automatic printing start method of the LITHRONE 26, and printing was carried out on Tokubishi Art Paper (76.5 kg) at a printing speed of 10,000 sheets per hour. The plate surface was washed after every 5,000 sheets by means of Multicleaner E (plate cleaner, Fujifilm Corporation), the end of printing was defined as the time when the ink density of an image area had decreased such that a 5% halftone density of a 20 µm FM screen had decreased by 0.5% compared with that at the time of starting printing, and the number of sheets printed at that time was evaluated as a number of prints for plate life.

From the results in Table 5 to Table 8, it can be seen that in all of Examples 1 to 124, which employed the process for making a lithographic printing plate of the present invention, the results were good in terms of odor of the developer, developability, and development sludge due to a component removed by development, and lithographic printing plates having excellent sensitivity and printing durability could be obtained.

**(Table 1)**

| Example | Lithographic printing plate precursor | | | Processing | | |
|---|---|---|---|---|---|---|
| | Type | Binder polymer | Urethane-acrylic hybrid polymer | Developer | Amount of Component A added (parts) | Amount of Component B added (parts) |
| Ex. 1 | (2) | Polymer 1 | Hybridur 580 | Developer 1 | 80 | 500 |
| Ex. 2 | (2) | Polymer 1 | Hybridur 580 | Developer 1 | 400 | 500 |
| Ex. 3 | (2) | Polymer 1 | Hybridur 580 | Developer 1 | 1,000 | 500 |
| Ex. 4 | (2) | Polymer 1 | Hybridur 580 | Developer 1 | 2,500 | 500 |
| Ex. 5 | (2) | Polymer 1 | Hybridur 580 | Developer 1 | 3,500 | 500 |
| Ex. 6 | (2) | Polymer 1 | Hybridur 580 | Developer 1 | 1,000 | 80 |
| Ex. 7 | (2) | Polymer 1 | Hybridur 580 | Developer 1 | 1,000 | 300 |
| Ex. 8 | (2) | Polymer 1 | Hybridur 580 | Developer 1 | 1,000 | 800 |
| Ex. 9 | (2) | Polymer 1 | Hybridur 580 | Developer 1 | 1,000 | 1,200 |
| Ex. 10 | (2) | Polymer 1 | Hybridur 580 | Developer 1 | 1,000 | 1,800 |
| Ex. 11 | (2) | Polymer 1 | Hybridur 580 | Developer 2 | 400 | 500 |
| Ex. 12 | (2) | Polymer 1 | Hybridur 580 | Developer 2 | 1,000 | 500 |
| Ex. 13 | (2) | Polymer 1 | Hybridur 580 | Developer 2 | 2,500 | 500 |
| Ex. 14 | (2) | Polymer 1 | Hybridur 580 | Developer 2 | 1,000 | 300 |
| Ex. 15 | (2) | Polymer 1 | Hybridur 580 | Developer 2 | 1,000 | 800 |
| Ex. 16 | (2) | Polymer 1 | Hybridur 580 | Developer 3 | 400 | 500 |
| Ex. 17 | (2) | Polymer 1 | Hybridur 580 | Developer 3 | 1,000 | 500 |
| Ex. 18 | (2) | Polymer 1 | Hybridur 580 | Developer 3 | 2,500 | 500 |
| Ex. 19 | (2) | Polymer 1 | Hybridur 580 | Developer 3 | 1,000 | 300 |
| Ex. 20 | (2) | Polymer 1 | Hybridur 580 | Developer 3 | 1,000 | 800 |
| Ex. 21 | (2) | Polymer 1 | Hybridur 580 | Developer 4 | 400 | 500 |
| Ex. 22 | (2) | Polymer 1 | Hybridur 580 | Developer 4 | 1,000 | 500 |
| Ex. 23 | (2) | Polymer 1 | Hybridur 580 | Developer 4 | 2,500 | 500 |
| Ex. 24 | (2) | Polymer 1 | Hybridur 580 | Developer 5 | 400 | 500 |
| Ex. 25 | (2) | Polymer 1 | Hybridur 580 | Developer 5 | 1,000 | 500 |
| Ex. 26 | (2) | Polymer 1 | Hybridur 580 | Developer 5 | 2,500 | 500 |
| Ex. 27 | (2) | Polymer 1 | Hybridur 580 | Developer 8 | 1,000 | 500 |
| Ex. 28 | (2) | Polymer 1 | Hybridur 580 | Developer 9 | 1,000 | 500 |
| Ex. 29 | (2) | Polymer 1 | Hybridur 580 | Developer 10 | 1,000 | 500 |
| Ex. 30 | (2) | Polymer 1 | Hybridur 580 | Developer 11 | 1,000 | 500 |
| Ex. 31 | (2) | Polymer 1 | Hybridur 580 | Developer 12 | 1,000 | 500 |
| Ex. 32 | (2) | Polymer 1 | Hybridur 580 | Developer 20 | 1,000 | 500 |
| Ex. 33 | (2) | Polymer 1 | Hybridur 580 | Developer 21 | 500 | 500 |

**(Table 2)**

| Example | Lithographic printing plate precursor | | | Processing | | |
|---|---|---|---|---|---|---|
| | Type | Binder polymer | Urethane-acrylic hybrid polymer | Developer | Amount of Component A added (parts) | Amount of Component B added (parts) |
| Ex. 34 | (2) | Polymer 2 | Hybridur 580 | Developer 1 | 1,000 | 500 |
| Ex. 35 | (2) | Polymer 3 | Hybridur 580 | Developer 1 | 1,000 | 500 |
| Ex. 36 | (2) | Polymer 4 | Hybridur 580 | Developer 1 | 1,000 | 500 |
| Ex. 37 | (2) | Polymer 5 | Hybridur 580 | Developer 1 | 1,000 | 500 |
| Ex. 38 | (2) | Polymer 1 | None | Developer 1 | 1,000 | 500 |
| Ex. 39 | (2) | Polymer 2 | None | Developer 1 | 1,000 | 500 |
| Ex. 40 | (2) | Polymer 3 | None | Developer 1 | 1,000 | 500 |
| Ex. 41 * | (2) | Polymer 4 | None | Developer 1 | 1,000 | 500 |
| Ex. 42 | (2) | Polymer 5 | None | Developer 1 | 1,000 | 500 |
| Ex. 43 | (2) | Polymer 1 | Hybridur 870 | Developer 1 | 1,000 | 500 |
| Ex. 44 | (2) | Polymer 1 | Hybrid polymer 1 | Developer 1 | 1,000 | 500 |
| Ex. 45 | (2) | Polymer 1 | Hybrid polymer 2 | Developer 1 | 1,000 | 500 |
| Ex. 46 | (2) | Polymer 1 | Hybrid polymer 3 | Developer 1 | 1,000 | 500 |
| Ex. 47 | (2) | Polymer 1 | Hybrid polymer 4 | Developer 1 | 1,000 | 500 |
| Ex. 48 | (2) | Polymer 1 | Hybrid polymer 5 | Developer 1 | 1,000 | 500 |
| Ex. 49 | (2) | Polymer 1 | Hybrid polymer 6 | Developer 1 | 1,000 | 500 |
| Ex. 50 | (2) | Polymer 4 | Hybrid polymer 6 | Developer 21 | 500 | 500 |
| Comp. Ex. 1 | (2) | Polymer 1 | Hybridur 580 | Developer 6 | - | 500 |
| Comp. Ex. 2 | (2) | Polymer 1 | Hybridur 580 | Developer 7 | - | 500 |
| Comp. Ex. 3 | (2) | Polymer 1 | Hybridur 580 | Developer 13 | 1,000 | - |
| Comp. Ex. 4 | (2) | Polymer 1 | Hybridur 580 | Developer 14 | 1,000 | - |
| Comp. Ex. 5 | (2) | Polymer 1 | Hybridur 580 | Developer 15 | 1,000 | - |
| Comp. Ex. 6 | (2) | Polymer 1 | Hybridur 580 | Developer 16 | 1,000 | - |
| Comp. Ex. 7 | (2) | Polymer 1 | Hybridur 580 | Developer 17 | 1,000 | - |
| Comp. Ex. 8 | (2) | Polymer 1 | Hybridur 580 | Developer 18 | 1,000 | - |
| Comp. Ex. 9 | (2) | Polymer 1 | Hybridur 580 | Developer 19 | - | - |
| Comp. Ex. 10 | (2) | Polymer 1 | Hybridur 580 | SP-200 | - | - |

**(Table 3)**

| Example | Lithographic printing plate precursor | | | Processing | | |
|---|---|---|---|---|---|---|
| | Type | Binder polymer | Urethane-acrylic hybrid polymer | Developer | Amount of Component A added (parts) | Amount of Component B added (parts) |
| Ex. 51 | (3) | Polymer 1 | None | Developer 1 | 80 | 500 |
| Ex. 52 | (3) | Polymer 1 | None | Developer 1 | 400 | 500 |
| Ex. 53 | (3) | Polymer 1 | None | Developer 1 | 1,000 | 500 |
| Ex. 54 | (3) | Polymer 1 | None | Developer 1 | 2,500 | 500 |
| Ex. 55 | (3) | Polymer 1 | None | Developer 1 | 3,500 | 500 |
| Ex. 56 | (3) | Polymer 1 | None | Developer 1 | 1,000 | 80 |
| Ex. 57 | (3) | Polymer 1 | None | Developer 1 | 1,000 | 300 |
| Ex. 58 | (3) | Polymer 1 | None | Developer 1 | 1,000 | 800 |
| Ex. 59 | (3) | Polymer 1 | None | Developer 1 | 1,000 | 1,200 |
| Ex. 60 | (3) | Polymer 1 | None | Developer 1 | 1,000 | 1,800 |
| Ex. 61 | (3) | Polymer 1 | None | Developer 2 | 400 | 500 |
| Ex. 62 | (3) | Polymer 1 | None | Developer 2 | 1,000 | 500 |
| Ex. 63 | (3) | Polymer 1 | None | Developer 2 | 2,500 | 500 |
| Ex. 64 | (3) | Polymer 1 | None | Developed 2 | 1,000 | 300 |
| Ex. 65 | (3) | Polymer 1 | None | Developer 2 | 1,000 | 800 |
| Ex. 66 | (3) | Polymer 1 | None | Developer 3 | 400 | 500 |
| Ex. 67 | (3) | Polymer 1 | None | Developer 3 | 1,000 | 500 |
| Ex. 68 | (3) | Polymer 1 | None | Developer 3 | 2,500 | 500 |
| Ex. 69 | (3) | Polymer 1 | None | Developer 3 | 1,000 | 300 |
| Ex. 70 | (3) | Polymer 1 | None | Developer 3 | 1,000 | 800 |
| Ex. 71 | (3) | Polymer 1 | None | Developer 4 | 400 | 500 |
| Ex. 72 | (3) | Polymer 1 | None | Developer 4 | 1,000 | 500 |
| Ex. 73 | (3) | Polymer 1 | None | Developer 4 | 2,500 | 500 |
| Ex. 74 | (3) | Polymer 1 | None | Developer 5 | 400 | 500 |
| Ex. 75 | (3) | Polymer 1 | None | Developer 5 | 1,000 | 500 |
| Ex. 76 | (3) | Polymer 1 | None | Developer 5 | 2,500 | 500 |
| Ex. 77 | (3) | Polymer 1 | None | Developer 8 | 1,000 | 500 |
| Ex. 78 | (3) | Polymer 1 | None | Developer 9 | 1,000 | 500 |
| Ex. 79 | (3) | Polymer 1 | None | Developer 10 | 1,000 | 500 |
| Ex. 80 | (3) | Polymer 1 | None | Developer 11 | 1,000 | 500 |
| Ex. 81 | (3) | Polymer 1 | None | Developer 12 | 1,000 | 500 |
| Ex. 82 | (3) | Polymer 1 | None | Developer 20 | 1,000 | 500 |
| Ex. 83 | (3) | Polymer 1 | None | Developer 21 | 500 | 500 |
| Ex. 84 | (3) | Polymer 2 | None | Developer 1 | 1,000 | 500 |
| Ex. 85 | (3) | Polymer 3 | None | Developer 1 | 1,000 | 500 |
| Ex. 86 * | (3) | Polymer 4 | None | Developer 1 | 1,000 | 500 |
| Ex. 87 | (3) | Polymer 5 | None | Developer 1 | 1,000 | 500 |
| Comp. Ex. 11 | (3) | polymer 1 | None | Developer 6 | - | 500 |
| Comp. Ex. 12 | (3) | Polymer 1 | None | Developer 7 | - | 500 |
| Comp. Ex. 13 | (3) | Polymer 1 | None | Developer 13 | 1,000 | - |
| Comp. Ex. 14 | (3) | Polymer 1 | None | Developer 14 | 1,000 | - |
| Comp. Ex. 15 | (3) | Polymer 1 | None | Developer 15 | 1,000 | - |
| Comp. Ex. 16 | (3) | Polymer 1 | None | Developer 16 | 1,000 | - |
| Comp. Ex. 17 | (3) | Polymer 1 | None | Developer 17 | 1,000 | - |
| Comp. Ex. 18 | (3) | Polymer 1 | None | Developer 18 | 1,000 | - |
| Comp. Ex. 19 | (3) | Polymer 1 | None | Developer 19 | - | - |
| Comp. Ex. 20 | (3) | Polymer 1 | None | SP-200 | - | - |

**(Table 4)**

| Example | Lithographic printing plate precursor | | | Processing | | |
|---|---|---|---|---|---|---|
| | Type | Binder polymer | Urethane-acrylic hybrid polymer | Developer | Amount of Component A added (parts) | Amount of Component B added (parts) |
| Ex. 88 | (1) | Polymer 1 | None | Developer 1 | 80 | 500 |
| Ex. 89 | (1) | Polymer 1 | None | Developer 1 | 400 | 500 |
| Ex. 90 | (1) | Polymer 1 | None | Developer 1 | 1,000 | 500 |
| Ex. 91 | (1) | Polymer 1 | None | Developer 1 | 2,500 | 500 |
| Ex. 92 | (1) | Polymer 1 | None | Developer 1 | 3,500 | 500 |
| Ex. 93 | (1) | Polymer 1 | None | Developer 1 | 1,000 | 80 |
| Ex. 94 | (1) | Polymer 1 | None | Developer 1 | 1,000 | 300 |
| Ex. 95 | (1) | Polymer 1 | None | Developer 1 | 1,000 | 800 |
| Ex. 96 | (1) | Polymer 1 | None | Developer 1 | 1,000 | 1,200 |
| Ex. 97 | (1) | Polymer 1 | None | Developer 1 | 1,000 | 1,800 |
| Ex. 98 | (1) | Polymer 1 | None | Developer 2 | 400 | 500 |
| Ex. 99 | (1) | Polymer 1 | None | Developer 2 | 1,000 | 500 |
| Ex. 100 | (1) | Polymer 1 | None | Developer 2 | 2,500 | 500 |
| Ex. 101 | (1) | Polymer 1 | None | Developer 2 | 1,000 | 300 |
| Ex. 102 | (1) | Polymer 1 | None | Developer 2 | 1,000 | 800 |
| Ex. 103 | (1) | Polymer 1 | None | Developer 3 | 400 | 500 |
| Ex. 104 | (1) | Polymer 1 | None | Developer 3 | 1,000 | 500 |
| Ex. 105 | (1) | Polymer 1 | None | Developer 3 | 2,500 | 500 |
| Ex. 106 | (1) | Polymer 1 | None | Developer 3 | 1,000 | 300 |
| Ex. 107 | (1) | Polymer 1 | None | Developer 3 | 1,000 | 800 |
| Ex. 108 | (1) | Polymer 1 | None | Developer 4 | 400 | 500 |
| Ex. 109 | (1) | Polymer 1 | None | Developer 4 | 1,000 | 500 |
| Ex. 110 | (1) | Polymer 1 | None | Developer 4 | 2,500 | 500 |
| Ex. 111 | (1) | Polymer 1 | None | Developer 5 | 400 | 500 |
| Ex. 112 | (1) | Polymer 1 | None | Developer 5 | 1,000 | 500 |
| Ex. 113 | (1) | Polymer 1 | None | Developer 5 | 2,500 | 500 |
| Ex. 114 | (1) | Polymer 1 | None | Developer 8 | 1,000 | 500 |
| Ex. 115 | (1) | Polymer 1 | None | Developer 9 | 1,000 | 500 |
| Ex. 116 | (1) | Polymer 1 | None | Developer 10 | 1,000 | 500 |
| Ex. 117 | (1) | Polymer 1 | None | Developer 11 | 1,000 | 500 |
| Ex. 118 | (1) | Polymer 1 | None | Developer 12 | 1,000 | 500 |
| Ex. 119 | (1) | Polymer 1 | None | Developer 20 | 1,000 | 500 |
| Ex. 120 | (1) | Polymer 1 | None | Developer 21 | 500 | 500 |
| Ex. 121 | (1) | Polymer 2 | None | Developer 1 | 1,000 | 500 |
| Ex. 122 | (1) | Polymer 3 | None | Developer 1 | 1,000 | 500 |
| Ex. 123* | (1) | Polymer 4 | None | Developer 1 | 1,000 | 500 |
| Ex. 124 | (1) | Polymer 5 | None | Developer 1 | 1,000 | 500 |
| Comp. Ex. 21 | (1) | Polymer 1 | None | Developer 6 | - | 500 |
| Comp. Ex. 22 | (1) | Polymer 1 | None | Developer 7 | - | 500 |
| Comp. Ex. 23 | (1) | Polymer 1 | None | Developer 13 | 1,000 | - |
| Comp. Ex. 24 | (1) | Polymer 1 | None | Developer 14 | 1,000 | - |
| Comp. Ex. 25 | (1) | Polymer 1 | None | Developer 15 | 1,000 | - |
| Comp. Ex. 26 | (1) | Polymer 1 | None | Developer 16 | 1,000 | - |
| Comp. Ex. 27 | (1) | Polymer 1 | None | Developer 17 | 1,000 | - |
| Comp. Ex. 28 | (1) | Polymer 1 | None | Developer 18 | 1,000 | - |
| Comp. Ex. 29 | (1) | Polymer 1 | None | Developer 19 | - | - |
| Comp. Ex. 30 | (1) | Polymer 1 | None | SP-200 | - | - |

Examples 41, 86 and 123 are not anymore part of the invention.

### (Composition of developer used in development step)

### <Developer 1 (pH: 7.0)>

Water : amount that when combined with the other components made 10,000 parts
Ethylene glycol mono-*n*-hexyl ether: amount described in Table 1 to Table 4 (octanol/water partition coefficient = 1.86, solubility in water = 1.0 g/100 mL of water)
Nonionic surfactant shown as Compound Example B-14: amount described in Table 1 to Table 4
<Developer 2 (pH: 7.0)>
Water : amount that when combined with the other components made 10,000 parts
Ethylene glycol mono-*n*-butyl ether: amount described in Table 1 to Table 4 (octanol/water partition coefficient = 0.83, solubility in water = mutually mixing)
Nonionic surfactant shown as Compound Example B-14: amount described in Table 1 to Table 4

### <Developer 3 (pH: 7.0)>

Water : amount that when combined with the other components made 10,000 parts
Propylene glycol mono-*n*-butyl ether: amount described in Table 1 to Table 4 (octanol/water partition coefficient = no datum, solubility in water = 4.4 g/100 mL of water)
Nonionic surfactant shown as Compound Example B-14: amount described in Table 1 to Table 4

### <Developer 4 (pH: 7.0)>

Water : amount that when combined with the other components made 10,000 parts
Diethylene glycol mono-2-ethylhexyl ether: amount described in Table 1 to Table 4 (octanol/water partition coefficient = no datum, solubility in water = 0.3 g/100 mL of water)
Nonionic surfactant shown as Compound Example B-14: amount described in Table 1 to Table 4

### <Developer 5 (pH: 7.0)>

Water : amount that when combined with the other components made 10,000 parts
Ethylene glycol mono-*t*-butyl ether: amount described in Table 1 to Table 4 (octanol/water partition coefficient = 0.36, solubility in water = mutually mixing)
Nonionic surfactant shown as Compound Example B-14: amount described in Table 1 to Table 4

### <Developer 6 (pH: 7.0)>

Water : amount that when combined with the other components made 10,000 parts
Benzyl alcohol: 1,000 parts
(octanol/water partition coefficient = 1.1, solubility in water = 4.0 g/100 mL of water)
Nonionic surfactant shown as Compound Example B-14: amount described in Table 1 to Table 4

Developer 6 was not a single phase and separated into two phases.

### <Developer 7 (pH: 7.0)>

Water : amount that when combined with the other components made 10,000 parts
Ethyleneglycol monophenyl ether: 1,000 parts
   (octanol/water partition coefficient = 1.2, solubility in water = 2.7 g/100 mL of water)
Nonionic surfactant shown as Compound Example B-14: amount described in Table 1 to Table 4

Developer 7 was not a single phase and separated into two phases.

### <Developer 8 (pH: 7.0)>

Water : amount that when combined with the other components made 10,000 parts
Ethylene glycol mono-*n*-hexyl ether: amount described in Table 1 to Table 4 Nonionic surfactant shown as Compound Example B-12: amount described in Table 1 to Table 4

### <Developer 9 (pH: 7.0)>

Water : amount that when combined with the other components made 10,000 parts
Ethylene glycol mono-*n*-hexyl ether: amount described in Table 1 to Table 4 Nonionic surfactant shown as Compound Example B-15: amount described in Table 1 to Table 4 <Developer 10 (pH: 7.0)>
Water : amount that when combined with the other components made 10,000 parts
Ethylene glycol mono-*n*-hexyl ether: amount described in Table 1 to Table 4 Nonionic surfactant shown as Compound Example B-26: amount described in Table 1 to Table 4

### <Developer 11 (pH: 7.0)>

Water : amount that when combined with the other components made 10,000 parts
Ethylene glycol mono-*n*-hexyl ether: amount described in Table 1 to Table 4 Nonionic surfactant shown as Compound Example B-7: amount described in Table 1 to Table 4

### <Developer 12 (pH: 7.0)>

Water : amount that when combined with the other components made 10,000 parts
Ethylene glycol mono-*n*-hexyl ether: amount described in Table 1 to Table 4 Nonionic surfactant shown as Compound Example B-11: amount described in Table 1 to Table 4

### <Developer 13 (pH: 7.0)>

Water : amount that when combined with the other components made 10,000 parts
Ethylene glycol mono-*n*-hexyl ether: amount described in Table 1 to Table 4 Emalex 710 (nonionic surfactant, Nihon Emulsion Co., Ltd.): 500 parts

Developer 13 was a single phase but had increased viscosity.

### <Developer 14 (pH: 7.0)>

Water : amount that when combined with the other components made 10,000 parts
Ethylene glycol mono-*n*-hexyl ether: amount described in Table 1 to Table 4 Pluronic L31 (nonionic surfactant, ADEKA CORPORATION): amount described in Table 1 to Table 4

Developer 14 was not a single phase and separated into two phases.

### <Developer 15 (pH: 7.0)>

Water : amount that when combined with the other components made 10,000 parts
Ethylene glycol mono-*n*-hexyl ether: amount described in Table 1 to Table 4 PELEX NBL(anionic surfactant, Kao Corporation): amount described in Table 1 to Table 4

Developer 15 was not a single phase and separated into two phases.

### <Developer 16 (pH: 7.0)>

Water : amount that when combined with the other components made 10,000 parts
Ethylene glycol mono-*n*-hexyl ether: amount described in Table 1 to Table 4 Newcol B13SN (anionic surfactant, Nihon Emulsion Co., Ltd.): amount described in Table 1 to Table 4

### <Developer 17 (pH: 7.0)>

Water : amount that when combined with the other components made 10,000 parts
Ethylene glycol mono-*n*-hexyl ether: amount described in Table 1 to Table 4 Pionin B111(cationic surfactant, Takemoto Oil & Fat Co., Ltd.): amount described in Table 1 to Table 4

Developer 17 was not a single phase and separated into two phases.

### <Developer 18 (pH: 7.0)>

Water : amount that when combined with the other components made 10,000 parts
Ethylene glycol mono-*n*-hexyl ether: amount described in Table 1 to Table 4 Softazoline LPB-R (amphoteric surfactant, Kawaken Fine Chemicals Co., Ltd.): 500 parts

Developer 18 was a single phase but had increased viscosity.

### <Developer 19 (pH: 7.0)>

Water : amount that when combined with the other components made 10,000 parts
Benzyl alcohol: 1,000 parts
PELEX NBL (anionic surfactant, Kao Corporation): 500 parts

### <Developer 20 (pH: 7.0)>

Water : amount that when combined with the other components made 10,000 parts
Ethylene glycol mono-*n*-hexyl ether: amount described in Table 1 to Table 4 Nonionic surfactant shown as Compound Example B-14: amount described in Table 1 to Table 4
PELEX NBL (anionic surfactant, Kao Corporation): 500 parts

### <Developer 21 (pH: 9.8)>

Water: 7829.8 parts
Sodium carbonate: 130 parts
Sodium bicarbonate: 70 parts
Newcol B-13 (nonionic surfactant, Nippon Nyukazai Co., Ltd.): 500 parts Gum arabic: 250 parts
Hydroxyalkylated starch (Penon JE66, Nippon Starch Chemical Co.): 700 parts
Monoammonium phosphate: 20 parts
2-Bromo-2-nitropropane-1,3-diol: 0.1 parts
2-Methyl-4-isothiazolin-3-one: 0.1 parts
Ethylene glycol mono-*n*-hexyl ether: 500 parts
<Other developers in Table 1 to Table 4>
SP-200: benzyl alcohol-containing developer by KODAK

**(Table 5)**

| Example | Developer odor | Developability (density of non-image area C) | Development sludge | Sensitivity | Printing durability |
|---|---|---|---|---|---|
| Ex. 1 | A | 0.02 | A | 5 µm | 120,000 sheets |
| Ex. 2 | A | 0.01 | A | 5 µm | 120,000 sheets |
| Ex. 3 | A | 0 | A | 5 µm | 120,000 sheets |
| Ex. 4 | B | 0 | A | 5 µm | 120,000 sheets |
| Ex. 5 | B | 0 | A | 10 µm | 100,000 sheets |
| Ex. 6 | B | 0 | B | 5 µm | 120,000 sheets |
| Ex. 7 | A | 0 | B | 5 µm | 120,000 sheets |
| Ex. 8 | A | 0 | A | 5 µm | 120,000 sheets |
| Ex. 9 | A | 0.01 | A | 5 µm | 120,000 sheets |
| Ex. 10 | A | 0.02 | A | 5 µm | 120,000 sheets |
| Ex. 11 | A | 0.01 | A | 5 µm | 120,000 sheets |
| Ex. 12 | A | 0 | A | 5 µm | 120,000 sheets |
| Ex. 13 | B | 0 | A | 5 µm | 120,000 sheets |
| Ex. 14 | A | 0 | B | 5 µm | 120,000 sheets |
| Ex. 15 | A | 0 | A | 5 µm | 120,000 sheets |
| Ex. 16 | A | 0.01 | A | 5 µm | 120,000 sheets |
| Ex. 17 | B | 0 | A | 5 µm | 120,000 sheets |
| Ex. 18 | B | 0 | A | 5 µm | 120,000 sheets |
| Ex. 19 | B | 0 | B | 5 µm | 120,000 sheets |
| Ex. 20 | B | 0 | A | 5 µm | 120,000 sheets |
| Ex. 21 | B | 0.04 | A | 5 µm | 120,000 sheets |
| Ex. 22 | B | 0.03 | A | 5 µm | 120,000 sheets |
| Ex. 23 | B | 0.02 | A | 10 µm | 100,000 sheets |
| Ex. 24 | A | 0.04 | A | 5 µm | 120,000 sheets |
| Ex. 25 | A | 0.03 | A | 5 µm | 120,000 sheets |
| Ex. 26 | B | 0.02 | A | 10 µm | 100,000 sheets |
| Ex. 27 | A | 0 | B | 5 µm | 100,000 sheets |
| Ex. 28 | A | 0.02 | A | 5 µm | 120,000 sheets |
| Ex. 29 | A | 0 | B | 5 µm | 120,000 sheets |
| Ex. 30 | A | 0.01 | B | 5 µm | 120,000 sheets |
| Ex. 31 | B | 0.01 | B | 5 µm | 120,000 sheets |
| Ex. 32 | A | 0.01 | A | 5 µm | 120,000 sheets |
| Ex. 33 | B | 0 | B | 10 µm | 100,000 sheets |

**(Table 6)**

| Example | Developer odor | Developability (density of non-image area C) | Development sludge | Sensitivity | Printing durability |
|---|---|---|---|---|---|
| Ex. 34 | A | 0 | A | 5 µm | 120,000 sheets |
| Ex. 35 | A | 0 | A | 10 µm | 120,000 sheets |
| Ex. 36 | A | 0 | A | 5 µm | 100,000 sheets |
| Ex. 37 | A | 0 | A | 5 µm | 120,000 sheets |
| Ex. 38 | A | 0 | A | 5 µm | 100,000 sheets |
| Ex. 39 | A | 0 | A | 5 µm | 100,000 sheets |
| Ex. 40 | A | 0 | A | 10 µm | 100,000 sheets |
| Ex. 41 ∗ | A | 0 | A | 10 µm | 100,000 sheets |
| Ex 42 | A | 0 | A | 5 µm | 100,000 sheets |
| Ex. 43 | A | 0 | A | 5 µm | 120,000 sheets |
| Ex. 44 | A | 0 | A | 5 µm | 120,000 sheets |
| Ex. 45 | A | 0 | A | 5 µm | 120,000 sheets |
| Ex. 46 | A | 0 | A | 5 µm | 120,000 sheets |
| Ex. 47 | A | 0 | A | 5 µm | 120,000 sheets |
| Ex. 48 | A | 0 | A | 5 µm | 120,000 sheets |
| Ex. 49 | A | 0 | A | 5 µm | 100,000 sheets |
| Ex. 50 | A | 0 | A | 10 µm | 100,000 sheets |
| Comp. Ex. 1 | C | Developer streaks present | Evaluation not possible | Evaluation not possible | Evaluation not possible |
| Comp. Ex. 2 | C | Developer streaks present | Evaluation not possible | Evaluation not possible | Evaluation not possible |
| Comp. Ex. 3 | A | 0.3 | D | 40 µm | 100,000 sheets |
| Comp. Ex. 4 | C | Developer streaks present | Evaluation not possible | Evaluation not possible | Evaluation not possible |
| Comp. Ex. 5 | C | Developer streaks present | Evaluation not possible | Evaluation not possible | Evaluation not possible |
| Comp. Ex. 6 | A | 0 | D | 5 µm | 120,000 sheets |
| Comp. Ex. 7 | C | Developer streaks present | Evaluation not possible | Evaluation not possible | Evaluation not possible |
| Comp. Ex. 8 | A | 0.2 | D | 30 µm | 40,000 sheets |
| Comp. Ex. 9 | A | 0 | D | 10 µm | 100,000 sheets |
| Comp. Ex. 10 | A | 0 | D | 10 µm | 100,000 sheets |

**(Table 7)**

| Example | Developer odor | Developability (density of non-image area C) | Development sludge | Sensitivity | Printing durability |
|---|---|---|---|---|---|
| Ex. 51 | A | 0.03 | A | 5 µm | 120,000 sheets |
| Ex. 52 | A | 0.02 | A | 5 µm | 120,000 sheets |
| Ex. 53 | A | 0.01 | A | 5 µm | 120,000 sheets |
| Ex. 54 | B | 0 | A | 5 µm | 120,000 sheets |
| Ex. 55 | B | 0 | A | 10 µm | 100,000 sheets |
| Ex. 56 | B | 0 | B | 5 µm | 120,000 sheets |
| Ex. 57 | A | 0 | A | 5 µm | 120,000 sheets |
| Ex. 58 | A | 0.01 | A | 5 µm | 120,000 sheets |
| Ex. 59 | A | 0.02 | A | 5 µm | 120,000 sheets |
| Ex. 60 | A | 0.03 | A | 5 µm | 120,000 sheets |
| Ex. 61 | A | 0.02 | A | 5 µm | 120,000 sheets |
| Ex. 62 | A | 0.01 | A | 5 µm | 120,000 sheets |
| Ex. 63 | B | 0 | A | 5 µm | 120,000 sheets |
| Ex. 64 | A | 0 | A | 5 µm | 120,000 sheets |
| Ex. 65 | A | 0 | A | 5 µm | 120,000 sheets |
| Ex. 66 | A | 0.02 | A | 5 µm | 120,000 sheets |
| Ex. 67 | B | 0.01 | A | 5 µm | 120,000 sheets |
| Ex. 68 | B | 0 | A | 5 µm | 120,000 sheets |
| Ex. 69 | B | 0 | A | 5 µm | 120,000 sheets |
| Ex. 70 | B | 0 | A | 5 µm | 120,000 sheets |
| Ex. 71 | B | 0.04 | A | 5 µm | 120,000 sheets |
| Ex. 72 | B | 0.04 | A | 5 µm | 120,000 sheets |
| Ex. 73 | B | 0.03 | A | 10 µm | 100,000 sheets |
| Ex. 74 | A | 0.04 | A | 5 µm | 120,000 sheets |
| Ex. 75 | A | 0.04 | A | 5 µm | 120,000 sheets |
| Ex. 76 | B | 0.03 | A | 10 µm | 100,000 sheets |
| Ex. 77 | A | 0 | A | 5 µm | 100,000 sheets |
| Ex. 78 | A | 0.03 | A | 5 µm | 120,000 sheets |
| Ex. 79 | A | 0 | A | 5 µm | 120,000 sheets |
| Ex. 80 | A | 0.02 | A | 5 µm | 120,000 sheets |
| Ex. 81 | B | 0.02 | A | 5 µm | 120,000 sheets |
| Ex. 82 | A | 0.02 | A | 5 µm | 120,000 sheets |
| Ex. 83 | B | 0.01 | B | 10 µm | 100,000 sheets |
| Ex. 84 | A | 0 | A | 5 µm | 120,000 sheets |
| Ex. 85 | A | 0 | A | 10 µm | 120,000 sheets |
| Ex. 86* | A | 0 | A | 5 µm | 100,000 sheets |
| Ex. 87 | A | 0 | A | 5 µm | 120,000 sheets |
| Comp. Ex. 11 | C | Developer streaks present | Evaluation not possible | Evaluation not possible | Evaluation not possible |
| Comp. Ex. 12 | C | Developer streaks present | Evaluation not possible | Evaluation not possible | Evaluation not possible |
| Comp. Ex. 13 | A | 0.5 | C | 50 µm | 100,000 sheets |
| Comp. Ex. 14 | C | Developer streaks present | Evaluation not possible | Evaluation not possible | Evaluation not possible |
| Comp. Ex. 15 | C | Developer streaks present | Evaluation not possible | Evaluation not possible | Evaluation not possible |
| Comp. Ex. 16 | A | 0.02 | C | 10 µm | 120,000 sheets |
| Comp. Ex. 17 | C | Developer streaks present | Evaluation not possible | Evaluation not possible | Evaluation not possible |
| Comp. Ex. 18 | A | 0.4 | C | 40 µm | 40,000 sheets |
| Comp. Ex. 19 | A | 0.02 | C | 30 µm | 100,000 sheets |
| Comp. Ex. 20 | A | 0.02 | C | 30 µm | 100,000 sheets |

**(Table 8)**

| Example | Developer odor | Devalopability (density of non-image area C) | Development sludge | Sensitivity | Printing durability |
|---|---|---|---|---|---|
| Ex. 88 | A | 0.02 | A | 5 µm | 120,000 sheets |
| Ex. 89 | A | 0.01 | A | 5 µm | 120,000 sheets |
| Ex. 90 | A | 0 | A | 5 µm | 120,000 sheets |
| Ex. 91 | B | 0 | A | 5 µm | 120,000 sheets |
| Ex. 92 | B | 0 | A | 10 µm | 100,000 sheets |
| Ex. 93 | B | 0 | A | 5 µm | 120,000 sheets |
| Ex. 94 | A | 0 | A | 5 µm | 120,000 sheets |
| Ex. 95 | A | 0 | A | 5 µm | 120,000 sheets |
| Ex. 96 | A | 0.01 | A | 5 µm | 120,000 sheets |
| Ex. 97 | A | 0.02 | A | 5 µm | 120,000 sheets |
| Ex. 98 | A | 0.01 | A | 5 µm | 120,000 sheets |
| Ex. 99 | A | 0 | A | 6 µm | 120,000 sheets |
| Ex. 100 | B | 0 | A | 5 µm | 120,000 sheets |
| Ex. 101 | A | 0 | A | 5 µm | 120,000 sheets |
| Ex. 102 | A | 0 | A | 5 µm | 120,000 sheets |
| Ex. 103 | A | 0.01 | A | 5 µm | 120,000 sheets |
| Ex. 104 | B | 0 | A | 5 µm | 120,000 sheets |
| Ex. 105 | B | 0 | A | 5 µm | 120,000 sheets |
| Ex. 106 | B | 0 | A | 5 µm | 120,000 sheets |
| Ex. 107 | B | 0 | A | 5 µm | 120,000 sheets |
| Ex. 108 | B | 0.04 | A | 5 µm | 120,000 sheets |
| Ex. 109 | B | 0.03 | A | 5 µm | 120,000 sheets |
| Ex. 110 | B | 0.02 | A | 10 µm | 100,000 sheets |
| Ex. 111 | A | 0.04 | A | 5 µm | 120,000 sheets |
| Ex. 112 | A | 0.03 | A | 5 µm | 120,000 sheets |
| Ex. 113 | B | 0.02 | A | 10 µm | 100,000 sheets |
| Ex. 114 | A | 0 | A | 5 µm | 100,000 sheets |
| Ex. 115 | A | 0.02 | A | 5 µm | 120,000 sheets |
| Ex. 116 | A | 0 | A | 5 µm | 120,000 sheets |
| Ex. 117 | A | 0.01 | A | 5 µm | 120,000 sheets |
| Ex. 118 | B | 0.01 | A | 5 µm | 120,000 sheets |
| Ex. 119 | A | 0.01 | A | 5 µm | 120.000 sheets |
| Ex. 120 | B | 0 | A | 10 µm | 100,000 sheets |
| Ex. 121 | A | 0 | A | 5 µm | 120,000 sheets |
| Ex. 122 | A | 0 | A | 10 µm | 120,000 sheets |
| Ex. 123 * | A | 0 | A | 5 µm | 100,000 sheets |
| Ex. 124 | A | 0 | A | 5 µm | 120,000 sheets |
| Comp. Ex. 21 | C | Developer streaks present | Evaluation not possible | Evaluation not possible | Evaluation not possible |
| Comp. Ex. 22 | C | Developer streaks present | Evaluation not possible | Evaluation not possible | Evaluation not possible |
| Comp. Ex. 23 | A | 0.3 | C | 50 µm | 40,000 sheets |
| Comp. Ex. 24 | C | Developer streaks present | Evaluation not possible | Evaluation not possible | Evaluation not possible |
| Comp. Ex. 25 | C | Developer streaks present | Evaluation not possible | Evaluation not possible | Evaluation not possible |
| Comp. Ex. 26 | A | 0 | C | 20 µm | 80,000 sheets |
| Comp. Ex. 27 | C | Developer streaks present | Evaluation not possible | Evaluation not possible | Evaluation not possible |
| Comp. Ex. 28 | A | 0.2 | C | 50 µm | 20,000 sheets |
| Comp. Ex. 29 | A | 0 | C | 40 µm | 40,000 sheets |
| Comp. Ex. 30 | A | 0 | C | 40 µm | 40,000 sheets |

Examples 41*, 86* and 123* are not anymore part of the invention.

### (Examples 125 to 161 and Comparative Examples 31 to 40)

### <Preparation of lithographic printing plate precursor (4)>

Lithographic printing plate precursor (4) was obtained in the same manner as for lithographic printing plate precursor (1) except that photosensitive layer coating solution (1) in the preparation of lithographic printing plate precursor (1) was changed to photosensitive layer coating solution (4) having the composition below, and protective layer coating solution (1) was changed to protective layer coating solution (3).
Photosensitive layer coating solution (4)
Polymerization initiator (1) below: 0.18 parts
Sensitizing dye (1) below (wavelength of absorption maximum; 359 nm): 0.06 parts
Binder polymer described in Table 3: 0.54 parts as solids content Polymerizable compound (Aronix M-315, Toagosei Co., Ltd.): 0.45 parts Leuco crystal violet: 0.20 parts
Thermopolymerization inhibitor: 0.01 parts
(N-nitrosophenylhydroxylamine aluminum salt)
Pionin A-20 (Takemoto Oil & Fat Co., Ltd.): 0.05 parts
Fluorine-based surfactant (1) above: 0.001 parts
Methyl ethyl ketone: 3.50 parts
1-Methoxy-2-propanol: 8.00 parts

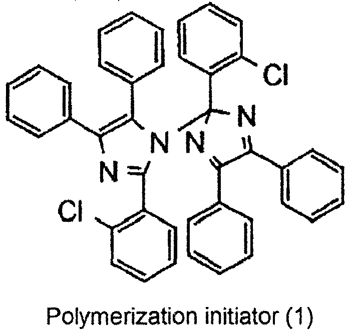

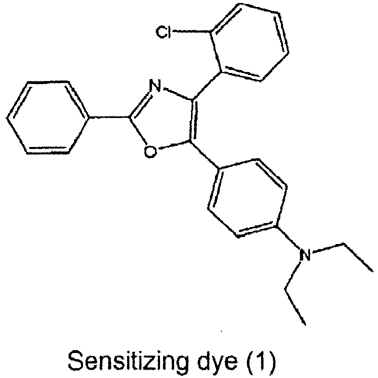

### <Exposure>

Lithographic printing plate precursor (4) was imagewise exposed using a Vx9600 Violet semiconductor laser plate setter (equipped with InGaN type semiconductor laser (light emission wavelength 405 nm ±10 nm/output 30 mW)) manufactured by Fujifilm Electronic Imaging (FFEI). Image drawing was carried out at a resolution of 2,438 dpi using an FM screen (TAFFETA 20) manufactured by Fujifilm Corporation at a plate surface exposure of 0.05 mJ/cm².

The exposure image included a solid image and a fine line image.

### <Processing and evaluation>

Examples 125 to 161, excluding Example 157, and Comparative Examples 31 to 40 were subjected to processing and to the evaluations shown in Table 9 in the same manner as for Examples 1 to 124, excluding Examples 33, 50, 87, and 124. Furthermore, Example 157 was subjected to processing and to the evaluations shown in Table 9 in the same manner as for Examples 33, 50, 87, and 124.

The results thus obtained are shown in Table 10.

From the results of Table 10, it can be seen that in all of Examples 125 to 161, which employed the process for making a lithographic printing plate of the present invention, the results were good in terms of odor of the developer, developability, and development sludge due to a component removed by development, and lithographic printing plates having excellent sensitivity and printing durability could be obtained.

**(Table 9)**

| Example | Lithographic printing plate precursor | | | Processing | | |
|---|---|---|---|---|---|---|
| | Type | Binder polymer | Urethane-acrylic hybrid polymer | Developer | Amount of Component A added (parts) | Amount of Component B added (parts) |
| Ex. 125 | (4) | Polymer 1 | None | Developer 1 | 80 | 500 |
| Ex. 126 | (4) | Polymer 1 | None | Developer 1 | 400 | 500 |
| Ex. 127 | (4) | Polymer 1 | None | Developer 1 | 1,000 | 500 |
| Ex. 128 | (4) | Polymer 1 | None | Developer 1 | 2,500 | 500 |
| Ex. 129 | (4) | Polymer 1 | None | Developer 1 | 3,500 | 500 |
| Ex. 130 | (4) | Polymer 1 | None | Developer 1 | 1,000 | 80 |
| Ex. 131 | (4) | Polymer 1 | None | Developer 1 | 1,000 | 300 |
| Ex. 132 | (4) | Polymer 1 | None | Developer 1 | 1,000 | 800 |
| Ex. 133 | (4) | Polymer 1 | None | Developer 1 | 1,000 | 1,200 |
| Ex. 134 | (4) | Polymer 1 | None | Developer 1 | 1,000 | 1,800 |
| Ex. 135 | (4) | Polymer 1 | None | Developer 2 | 400 | 500 |
| Ex. 136 | (4) | Polymer 1 | None | Developer 2 | 1,000 | 500 |
| Ex. 137 | (4) | Polymer 1 | None | Developer 2 | 2,500 | 500 |
| Ex. 138 | (4) | Polymer 1 | None | Developer 2 | 1,000 | 300 |
| Ex. 139 | (4) | Polymer 1 | None | Developer 2 | 1,000 | 800 |
| Ex. 140 | (4) | Polymer 1 | None | Developer 3 | 400 | 500 |
| Ex. 141 | (4) | Polymer 1 | None | Developer 3 | 1,000 | 500 |
| Ex. 142 | (4) | Polymer 1 | None | Developer 3 | 2,500 | 500 |
| Ex. 143 | (4) | Polymer 1 | None | Developer 3 | 1,000 | 300 |
| Ex. 144 | (4) | Polymer 1 | None | Developer 3 | 1,000 | 800 |
| Ex. 145 | (4) | Polymer 1 | None | Developer 4 | 400 | 500 |
| Ex. 146 | (4) | Polymer 1 | None | Developer 4 | 1,000 | 500 |
| Ex. 147 | (4) | Polymer 1 | None | Developer 4 | 2,500 | 500 |
| Ex. 148 | (4) | Polymer 1 | None | Developer 5 | 400 | 500 |
| Ex. 149 | (4) | Polymer 1 | None | Developer 5 | 1,000 | 500 |
| Ex. 150 | (4) | Polymer 1 | None | Developer 5 | 2,500 | 500 |
| Ex. 151 | (4) | Polymer 1 | None | Developer 8 | 1,000 | 500 |
| Ex. 152 | (4) | Polymer 1 | None | Developer 9 | 1,000 | 500 |
| Ex. 153 | (4) | Polymer 1 | None | Developer 10 | 1,000 | 500 |
| Ex. 154 | (4) | Polymer 1 | None | Developer 11 | 1,000 | 500 |
| Ex. 155 | (4) | Polymer 1 | None | Developer 12 | 1,000 | 500 |
| Ex. 156 | (4) | Polymer 1 | None | Developer 20 | 1,000 | 500 |
| Ex. 157 | (4) | Polymer 1 | None | Developer 21 | 500 | 500 |
| Ex. 158 | (4)^{.} | Polymer 2 | None | Developer 1 | 1,000 | 500 |
| Ex. 159 | (4) | Polymer 3 | None | Developer 1 | 1,000 | 500 |
| Ex. 160 | (4) | Polymer 4 | None | Developer 1 | 1,000 | 500 |
| Ex. 161 | (4) | Polymer 5 | None | Developer 1 | 1,000 | 500 |
| Comp. Ex. 31 | (4) | Polymer 1 | None | Developer 6 | - | 500 |
| Comp. Ex. 32 | (4) | Polymer 1 | None | Developer 7 | - | 500 |
| Comp. Ex. 33 | (4) | Polymer 1 | None | Developer 13 | 1,000 | - |
| Comp. Ex. 34 | (4) | Polymer 1 | None | Developer 14 | 1,000 | - |
| Comp. Ex. 35 | (4) | Polymer 1 | None | Developer 15 | 1,000 | - |
| Comp. Ex. 36 | (4) | Polymer 1 | None | Developer 16 | 1,000 | - |
| Comp. Ex. 37 | (4) | Polymer 1 | None | Developer 17 | 1,000 | - |
| Comp. Ex. 38 | (4) | Polymer 1 | None | Developer 18 | 1,000 | - |
| Comp. Ex. 39 | (4) | Polymer 1 | None | Developer 19 | - | - |
| Comp. Ex. 40 | (4) | Polymer 1 | None | SP-200 | - | - |

**(Table 10)**

| Example | Developer odor | Developability (density of non-image area C) | Development sludge | Sensitivity | Printing durability |
|---|---|---|---|---|---|
| Ex. 125 | A | 0.02 | A | 5 µm | 120,000 sheets |
| Ex. 126 | A | 0.01 | A | 5 µm | 120,000 sheets |
| Ex. 127 | A | 0 | A | 5 µm | 120,000 sheets |
| Ex. 128 | B | 0 | A | 5 µm | 120,000 sheets |
| Ex. 129 | B | 0 | A | 10 µm | 100,000 sheets |
| Ex. 130 | B | 0 | A | 5 µm | 120,000 sheets |
| Ex. 131 | A | 0 | A | 5 µm | 120,000 sheets |
| Ex. 132 | A | 0 | A | 5 µm | 120,000 sheets |
| Ex. 133 | A | 0.01 | A | 5 µm | 120,000 sheets |
| Ex. 134 | A | 0.02 | A | 5 µm | 120,000 sheets |
| Ex. 135 | A | 0.01 | A | 5 µm | 120,000 sheets |
| Ex. 136 | A | 0 | A | 5 µm | 120,000 sheets |
| Ex. 137 | B | 0 | A | 5 µm | 120,000 sheets |
| Ex. 138 | A | 0 | A | 5 µm | 120,000 sheets |
| Ex. 139 | A | 0 | A | 5 µm | 120,000 sheets |
| Ex. 140 | A | 0.01 | A | 5 µm | 120.000 sheets |
| Ex. 141 | B | 0 | A | 5 µm | 120,000 sheets |
| Ex. 142 | B | 0 | A | 5 µm | 120,000 sheets |
| Ex. 143 | B | 0 | A | 5 pm | 120,000 sheets |
| Ex. 144 | B | 0 | A | 5 µm | 120,000 sheets |
| Ex. 145 | B | 0.04 | A | 5 µm | 120,000 sheets |
| Ex. 146 | B | 0.03 | A | 5 µm | 120,000 sheets |
| Ex. 147 | B | 0.02 | A | 10 µm | 100,000 sheets |
| Ex. 148 | A | 0.04 | A | 5 µm | 120,000 sheets |
| Ex. 149 | A | 0.03 | A | 5 µm | 120,000 sheets |
| Ex. 150 | B | 0.02 | A | 10 µm | 100,000 sheets |
| Ex. 151 | A | 0 | A | 5 µm | 100,000 sheets |
| Ex. 152 | A | 0.02 | A | 5 µm | 120,000 sheets |
| Ex. 153 | A | 0 | A | 5 µm | 120,000 sheets |
| Ex. 154 | A | 0.01 | A | 5 µm | 120,000 sheets |
| Ex. 155 | B | 0.01 | A | 5 µm | 120,000 sheets |
| Ex. 156 | A | 0.01 | A | 5 µm | 120,000 sheets |
| Ex. 157 | B | 0 | A | 10 µm | 100,000 sheets |
| Ex. 158 | A | 0 | A | 5 µm | 120,000 sheets |
| Ex. 159 | A | 0 | A | 10 µm | 120,000 sheets |
| Ex. 160 | A | 0 | A | 5 µm | 100,000 sheets |
| Ex. 161 | A | 0 | A | 6 µm | 120,000 sheets |
| Comp. Ex. 31 | C | Developer streaks present | Evaluation not possible | Evaluation not possible | Evaluation not possible |
| Comp. Ex. 32 | C | Developer streaks present | Evaluation not possible | Evaluation not possible | Evaluation not possible |
| Comp. Ex. 33 | A | 0.3 | C | 50 µm | 40,000 sheets |
| Comp. Ex. 34 | C | Developer streaks present | Evaluation not possible | Evaluation not possible | Evaluation not possible |
| Comp. Ex. 35 | C | Developer streaks present | Evaluation not possible | Evaluation not possible | Evaluation not possible |
| Comp. Ex. 36 | A | 0 | C | 20 µm | 80,000 sheets |
| Comp. Ex. 37 | C | Developer streaks present | Evaluation not possible | Evaluation not possible | Evaluation not possible |
| Comp. Ex. 38 | A | 0.2 | C | 50 µm | 20,000 sheets |
| Comp. Ex. 39 | A | 0 | C | 40 µm | 40,000 sheets |
| Comp. Ex. 40 | A | 0 | C | 40 µm | 40,000 sheets |

## Claims

1. A process for making a lithographic printing plate, comprising:
a step of preparing a negative-working lithographic printing plate precursor comprising a photopolymerizable photosensitive layer above a support;
a step of imagewise exposing the negative-working lithographic printing plate precursor; and
a step of developing the exposed negative-working lithographic printing plate precursor by means of a developer comprising at least a compound represented by Formula (I) below as Component A, a compound represented by Formula (II) below as Component B and water as Component C,
wherein the photopolymerizable photosensitive layer comprises an acrylic polymer comprising a vinylcarbazole compound-derived monomer unit or a urethane-acrylic hybrid polymer, 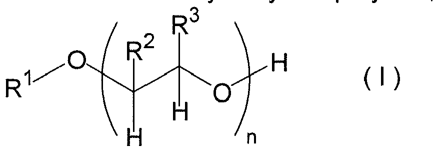 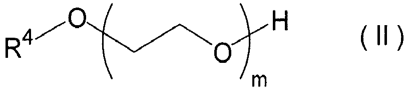 wherein in the Formulae,
R¹ denotes a straight-chain or branched alkyl group having 4 to 8 carbons, preferably a *n*-butyl group, a *n*-hexyl group, or a 2-ethylhexyl group;
R² and R³ independently denote a hydrogen atom or a methyl group and when either one of R² and R³ is a methyl group the other is a hydrogen atom, and
R² and R³ are preferably both hydrogen atoms;
n denotes 1 or 2, preferably 1;
R⁴ denotes a substituted or unsubstituted phenyl group, 1-naphthyl group, or 2-naphthyl group, preferably a substituted or unsubstituted 1-naphthyl group or 2-naphthyl group, and
m denotes an integer of 4 to 20, preferably 9 to 16.

2. The process for making a lithographic printing plate according to Claim 1, wherein Component A is a compound having an octanol/water partition coefficient of 0.8 to 2.0 and is preferably selected from the group consisting of ethylene glycol mono-*n*-butyl ether, ethylene glycol mono-*n-*hexyl ether, and propylene glycol mono-*n*-butyl ether.

3. The process for making a lithographic printing plate according to Claim 1 or 2, wherein Component A has a content in the developer that is greater than the solubility of Component A in water but no greater than 40 wt%, preferably 2 to 30 wt%, more preferably 5 to 20 wt%, relative to the total weight of the developer.

4. The process for making a lithographic printing plate according to any one of Claims 1 to 3, wherein Component B has a content in the developer that is 1 to 15 wt%, preferably 4 to 10 wt%, relative to the total weight of the developer.

5. The process for making a lithographic printing plate according to any one of Claims 1 to 4, wherein Component C has a content in the developer of at least 50 wt%, relative to the total weight of the developer.

6. The process for making a lithographic printing plate according to any one of Claims 1 to 5, wherein the developer further comprises an anionic surfactant or an amphoteric surfactant.

7. The process for making a lithographic printing plate according to any one of Claims 1 to 6, wherein the developer has a pH of 6 to 8.

8. The process for making a lithographic printing plate according to any one of Claims 1 to 7, wherein the photopolymerizable photosensitive layer comprises an acrylic polymer comprising a vinylcarbazole compound-derived monomer unit.

9. The process for making a lithographic printing plate according to Claim 8, wherein the acrylic polymer comprises an acrylonitrile-derived monomer unit.

10. The process for making a lithographic printing plate according to any one of Claims 1 to 9, wherein the photopolymerizable photosensitive layer comprises a urethane-acrylic hybrid polymer.

11. The process for making a lithographic printing plate according to Claim 10, wherein the urethane-acrylic hybrid polymer comprises a monomer unit derived from a compound selected from the group consisting of diphenylmethane diisocyanate, m-tolylene diisocyanate, isophorone diisocyanate, and dicyclohexylmethane diisocyanate.

12. A process for making a lithographic printing plate according to any preceding claim, wherein the photopolymerizable photosensitive layer is sensitive to infrared light, does not contain a borate salt, and comprises a coloring dye.

13. A process for making a lithographic printing plate according to Claim 12, wherein the photopolymerizable photosensitive layer comprises a cyanine dye and an iodonium salt.

## Patentansprüche

1. Verfahren zur Herstellung einer Lithographiedruckplatte, umfassend:
einen Schritt des Vorbereitens eines negativ-arbeitenden Lithographiedruckplattenvorläufers, der oberhalb eines Trägers eine fotopolymerisierbare fotoempfindliche Schicht umfasst;
einen Schritt zum bildweisen Belichten des negativ-arbeitenden Lithographiedruckplattenvorläufers; und
einen Schritt zum Entwickeln des belichteten negativ-arbeitenden Lithographiedruckplattenvorläufers mittels eines Entwicklers, umfassend zumindest eine durch die nachstehende Formel (I) dargestellte Verbindung als Komponente A, eine durch die nachstehende Formel (II) dargestellte Verbindung als Komponente B und Wasser als Komponente C,
worin die fotopolymerisierbare fotoempfindliche Schicht ein Acrylpolymer, das eine aus einer Vinylcarbazolverbindung abgeleitete Monomereinheit umfasst, oder ein Urethan-Acryl-Hybridpolymer umfasst 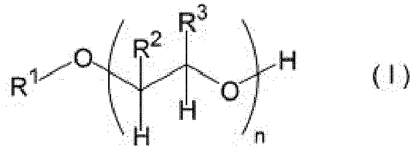 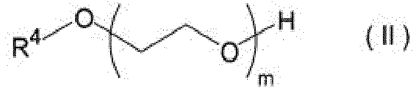 worin in den Formeln,
R¹ eine geradkettige oder verzweigte Alkylgruppe mit 4 bis 8 Kohlenstoffatomen bezeichnet, bevorzugt eine n-Butylgruppe, eine n-Hexylgruppe oder eine 2-Ethylhexylgruppe;
R² und R³ unabhängig ein Wasserstoffatom oder eine Methylgruppe bezeichnen, und wenn irgendeines von R² und R³ eine Methylgruppe ist, ist das andere ein Wasserstoffatom, und R² und R³ sind bevorzugt beide Wasserstoffatome;
n bezeichnet 1 oder 2, bevorzugt 1;
R⁴ bezeichnet eine substituierte oder unsubstituierte Phenylgruppe, 1-Naphthylgruppe oder 2-Naphthylgruppe, bevorzugt eine substituierte oder unsubstituierte 1-Naphthylgruppe oder 2-Naphthylgruppe, und
m bezeichnet eine ganze Zahl von 4 bis 20, bevorzugt 9 bis 16.

2. Verfahren zur Herstellung einer Lithographiedruckplatte gemäß Anspruch 1, worin die Komponente A eine Verbindung mit einem Octanol/Wasser-Verteilungskoeffizienten von 0,8 bis 2,0 ist, und bevorzugt ausgewählt ist aus der Gruppe, bestehend aus Ethylenglykolmono-n-butylether, Ethylenglykol-mono-n-hexylether und Propylenglykol-mono-n-butylether.

3. Verfahren zur Herstellung einer Lithographiedruckplatte gemäß Anspruch 1 oder 2, worin die Komponente A in dem Entwickler einen Mengenanteil aufweist, der größer ist als die Löslichkeit der Komponente A in Wasser, jedoch nicht größer als 40 Gew.%, bevorzugt 2 bis 30 Gew.%, stärker bevorzugt 5 bis 20 Gew.% relativ zum Gesamtgewicht des Entwicklers.

4. Verfahren zur Herstellung einer Lithographiedruckplatte gemäß irgendeinem der Ansprüche 1 bis 3, worin die Komponente B einen Mengenanteil in dem Entwickler aufweist, der 1 bis 15 Gew.%, bevorzugt 4 bis 10 Gew.% beträgt, relativ zum Gesamtgewicht des Entwicklers.

5. Verfahren zur Herstellung einer Lithographiedruckplatte gemäß irgendeinem der Ansprüche 1 bis 4, worin die Komponente C einen Mengenanteil in dem Entwickler von mindestens 50 Gew.% aufweist, relativ zum Gesamtgewicht des Entwicklers.

6. Verfahren zur Herstellung einer Lithographiedruckplatte gemäß irgendeinem der Ansprüche 1 bis 5, worin der Entwickler ferner ein anionisches Tensid oder ein amphoteres Tensid umfasst.

7. Verfahren zur Herstellung einer Lithographiedruckplatte gemäß irgendeinem der Ansprüche 1 bis 6, worin der Entwickler einen pH-Wert von 6 bis 8 aufweist.

8. Verfahren zur Herstellung einer Lithographiedruckplatte gemäß irgendeinem der Ansprüche 1 bis 7, worin die fotopolymerisierbare fotoempfindliche Schicht ein Acrylpolymer umfasst, das eine aus einer Vinylcarbazolverbindung abgeleitete Monomereinheit umfasst.

9. Verfahren zur Herstellung einer Lithographiedruckplatte gemäß Anspruch 8, worin das Acrylpolymer eine aus Acrylnitril abgeleitete Monomereinheit umfasst.

10. Verfahren zur Herstellung einer Lithographiedruckplatte gemäß irgendeinem der Ansprüche 1 bis 9, worin die fotopolymerisierbare fotoempfindliche Schicht ein Urethan-Acryl-Hybridpolymer umfasst.

11. Verfahren zur Herstellung einer Lithographiedruckplatte gemäß Anspruch 10, worin das Urethan-Acryl-Hybridpolymer eine Monomereinheit umfasst, die aus einer Verbindung abgeleitet ist, ausgewählt aus der Gruppe, bestehend aus Diphenylmethandiisocyanat, m-Tolylendiisocyanat, Isophorondiisocyanat und Dicyclohexylmethandiisocyanat.

12. Verfahren zur Herstellung einer Lithographiedruckplatte gemäß irgendeinem vorstehenden Anspruch, worin die fotopolymerisierbare fotoempfindliche Schicht gegenüber Infrarotlicht empfindlich ist, kein Boratsalz enthält und einen färbenden Farbstoff umfasst.

13. Verfahren zur Herstellung einer Lithographiedruckplatte gemäß Anspruch 12, worin die fotopolymerisierbare fotoempfindliche Schicht einen Cyanin-Farbstoff und ein Iodoniumsalz umfasst.

## Revendications

1. Procédé de fabrication d'une plaque d'impression lithographique, comprenant :
une étape de préparation d'un précurseur de plaque d'impression lithographique à effet négatif comprenant une couche photosensible photopolymérisable au-dessus d'un support ;
une étape d'exposition selon une image du précurseur de plaque d'impression lithographique à effet négatif ; et
une étape de développement du précurseur exposé de plaque d'impression lithographique à effet négatif au moyen d'un révélateur comprenant au moins un composé représenté par la formule (I) ci-dessous comme composant A, un composé représenté par la formule (II) ci-dessous comme composant B et de l'eau comme composant C,
dans lequel la couche photosensible photopolymérisable comprend un polymère acrylique comprenant une unité monomère dérivée d'un composé de vinylcarbazole ou un polymère hydride uréthane-acrylique, 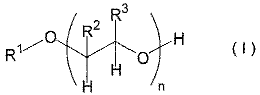 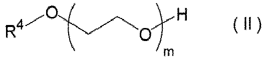 dans lequel, dans les formules,
R¹ désigne un groupe alkyle à chaîne droite ou ramifiée ayant 4 à 8 atomes de carbone, de préférence un groupe n-butyle, un groupe n-hexyle ou un groupe 2-éthylhexyle ;
R² et R³ désignent indépendamment un atome d'hydrogène ou un groupe méthyle et, lorsque l'un ou l'autre de R² et R³ est un groupe méthyle, l'autre est un atome d'hydrogène, et R² et R³ sont de préférence tous deux des atomes d'hydrogène ;
n désigne 1 ou 2, de préférence 1 ;
R⁴ désigne un groupe phényle, un groupe 1-naphtyle ou un groupe 2-naphtyle substitué ou non substitué, de préférence un groupe 1-napthyle ou un groupe 2-naphtyle substitué ou non substitué, et
m désigne un entier de 4 à 20, de préférence de 9 à 16.

2. Procédé de fabrication d'une plaque d'impression lithographique selon la revendication 1, dans lequel le composant A est un composé ayant un coefficient de séparation octanol/eau de 0,8 à 2,0 et est de préférence sélectionné dans le groupe constitué de l'éther mono-*n*-butylique d'éthylèneglycol, de l'éther mono-*n*-hexylique d'éthylèneglycol et de l'éther mono-*n*-butylique de propylèneglycol.

3. Procédé de fabrication d'une plaque d'impression lithographique selon la revendication 1 ou 2, dans lequel le composant A a une teneur dans le révélateur qui est supérieure à la solubilité du composant A dans l'eau, mais qui n'est pas supérieure à 40 % en poids, de préférence de 2 à 30 % en poids, mieux encore de 5 à 20 % en poids, par rapport au poids total du révélateur.

4. Procédé de fabrication d'une plaque d'impression lithographique selon l'une quelconque des revendications 1 à 3, dans lequel le composant B a une teneur dans le révélateur qui est de 1 à 15 % en poids, de préférence de 4 à 10 % en poids, par rapport au poids total du révélateur.

5. Procédé de fabrication d'une plaque d'impression lithographique selon l'une quelconque des revendications 1 à 4, dans lequel le composant C a une teneur dans le révélateur d'au moins 50 % en poids, par rapport au poids total du révélateur.

6. Procédé de fabrication d'une plaque d'impression lithographique selon l'une quelconque des revendications 1 à 5, dans lequel le révélateur comprend en outre un tensioactif anionique ou un tensioactif amphotère.

7. Procédé de fabrication d'une plaque d'impression lithographique selon l'une quelconque des revendications 1 à 6, dans lequel le révélateur a un pH de 6 à 8.

8. Procédé de fabrication d'une plaque d'impression lithographique selon l'une quelconque des revendications 1 à 7, dans lequel la couche photosensible photopolymérisable comprend un polymère acrylique comprenant une unité monomère dérivée d'un composé de vinylcarbazole.

9. Procédé de fabrication d'une plaque d'impression lithographique selon la revendication 8, dans lequel le polymère acrylique comprend une unité monomère dérivée d'acrylonitrile.

10. Procédé de fabrication d'une plaque d'impression lithographique selon l'une quelconque des revendications 1 à 9, dans lequel la couche photosensible photopolymérisable comprend un polymère hybride uréthane-acrylique.

11. Procédé de fabrication d'une plaque d'impression lithographique selon la revendication 10, dans lequel le polymère hydride uréthane-acrylique comprend une unité monomère dérivée d'un composé sélectionné dans le groupe constitué du diisocyanate de diphénylméthane, du diisocyanate de m-tolylène, du diisocyanate d'isophorone et du diisocyanate de dicyclohexylméthane.

12. Procédé de fabrication d'une plaque d'impression lithographique selon l'une quelconque des revendications précédentes, dans lequel la couche photosensible photopolymérisable est sensible à la lumière infrarouge, ne contient pas un sel de borate, et comprend un colorant de coloration.

13. Procédé de fabrication d'une plaque d'impression lithographique selon la revendication 12, dans lequel la couche photosensible photopolymérisable comprend un colorant de cyanine et un sel d'iodonium.
